(19) Europäisches Patentamt
European Patent Office
Office européen des brevets

(11) EP 1 850 651 A2

(12) # EUROPEAN PATENT APPLICATION

(43) Date of publication:
**31.10.2007 Bulletin 2007/44**

(51) Int Cl.:
***H05K 9/00*** *(2006.01)*

(21) Application number: **07008792.9**

(22) Date of filing: **30.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **28.04.2006 JP 2006126182**

(71) Applicant: **NITTO DENKO CORPORATION**
**Osaka (JP)**

(72) Inventors:
- **Niino, Takuya**
**Ibaraki-shi**
**Osaka (JP)**
- **Imono, Shozo**
**Ibaraki-shi**
**Osaka (JP)**
- **Sano, Masanori**
**Ibaraki-shi**
**Osaka (JP)**

(74) Representative: **Grünecker, Kinkeldey, Stockmair & Schwanhäusser**
**Anwaltssozietät**
**Maximilianstrasse 58**
**80538 München (DE)**

(54) **Article including sheet-like electromagnetic shielding structure**

(57) The present invention relates to an article to which a characteristic of shielding electromagnetic waves is imparted, which comprises at least a sheet-like electromagnetic shielding structure, the sheet-like electromagnetic shielding structure comprising a thin layer-like substrate; and a fiber convex structure section having a characteristic of conducting or absorbing electromagnetic waves, in which the said fiber convex structure section is formed at least partially on the thin layer-like substrate in such a form that at least a part of a fiber thereof is positioned outward from the surface of the thin layer-like substrate. As the article including the sheet-like electromagnetic shielding structure, an electronic device, an electronic circuit board, garment, an architectural structure, a construction material, or a transport equipped with an engine is suitable.

*FIG. 1A*

11
1b
1a1
1a

EP 1 850 651 A2

## Description

FIELD OF THE INVENTION

The present invention relates to an article including a sheet-like electromagnetic shielding structure, and more particularly, to an article including a sheet-like electromagnetic shielding structure, such as an electronic device, an electronic circuit board, garment, an architectural structure, a construction material, and a transport equipped with an engine, to which a characteristic of shielding electromagnetic waves is imparted.

BACKGROUND OF THE INVENTION

For the purpose of preventing malfunctioning of an electronic device or an electronic circuit board due to electromagnetic waves, protecting human bodies from the electromagnetic waves, preventing a leakage of information to the outside of an architectural structure, preventing irregular reflection of the electromagnetic waves within the architectural structure, or preventing malfunctioning of a transport (in particular, an aircraft), there have been proposed a various kinds of electromagnetic shielding materials (including electromagnetic absorbers). In various kinds of joining (especially, joining of electronic parts) for which a pressure-sensitive adhesive tape is used, it has been frequently required to have a characteristic of conducting or absorbing electromagnetic waves such as electrical conductivity, electromagnetic conducting properties, electromagnetic absorbing properties, or electromagnetic shielding properties. For that reason, with respect to a method for providing (bringing) a characteristic of conducting or absorbing electromagnetic waves such as electrical conductivity, electromagnetic conducting properties, electromagnetic absorbing properties, or electromagnetic shielding properties in the pressure-sensitive adhesive tape, there have hitherto been made a lot of investigations. For example, as materials having electrical conductivity, electromagnetic conducting properties, electromagnetic absorbing properties, or electromagnetic shielding properties, there are proposed an electrically conductive mutual connecting material obtained by non-random single layer coating of a particle (see Patent Document 1); an electrically conductive sealing material obtained by blending a silica powder, carbon black and a metal powder in a silicon rubber (see Patent Document 2); and so on. As materials having the electrical conductivity, electromagnetic conducting properties, electromagnetic absorbing properties, or electromagnetic shielding properties, there is also proposed a high molecular molded body having the electromagnetic shielding properties in which a flock composed of an electrically conductive fiber is flocked and fixed on a high molecular substrate and the electrical conductivity is imparted between flocks on the roots of the flocks (see Patent Document 3).

For the purpose of keeping the electrical conductivity, it is required in the above-mentioned electrically conductive mutual connecting material that a particle having the electrical conductivity be regularly aligned. If it is possible to align the particle having the electrical conductivity in a regular manner, although such is certainly useful in view of the electrical conductivity, aligning the particle in a regular manner is very complicated and is accompanied with difficulty in steps.

Furthermore, the above-mentioned electrically conductive sealing-material is provided with the electrical conductivity by kneading a particle having the electrical conductivity into a resin of every kind. For that reason, the preparation method of the case is simple, and there is a less problem in view of steps. However, in order to impart the electrical conductivity, a large amount of the electrically conductive particle must be blended, and as a result, there was involved a defect that the costs are comparatively high. Moreover, since a large amount of the electrically conductive particle is blended, there was also involved a defect that other characteristics are affected.

In addition, since the above-mentioned high molecular molded body having the electromagnetic shielding properties has a configuration in which an electrically conductive fiber is flocked on a high molecular substrate by using an adhesive layer having electrical conductivity, or the like, although the electromagnetic shielding properties is improved, it cannot be said that such an improvement is sufficient. Thus, a structure having much more excellent electromagnetic shielding properties is demanded.

Patent Document 1 : JP-T 2002-501821

Patent Document 2 : JP-A-10-120904

Patent Document 3 : JP-A-61-002394

SUMMARY OF THE INVENTION

Accordingly, an object of the invention is to provide an article including a sheet-like electromagnetic shielding structure to which a characteristic of shielding electromagnetic waves is imparted in an effective manner.

Another object of the invention is to provide an electronic device, an electronic circuit board, garment, an architectural structure, a construction material, and a transport, to which a characteristic of shielding electromagnetic waves is imparted in an effective manner.

In order to achieve the above-mentioned objects, the present inventors have made extensive and intensive investigations. As a result, it has been found that by providing a specific structure section composed of a fiber having electrical conductivity on a pressure-sensitive adhesive layer, not only it is possible to impart the electrical conductivity to a member having the pressure-sensitive adhesive layer, but also it can be prepared easily and cheaply. In particular, it has been found that by using such a member, it is possible to provide an electronic device, an electronic circuit board, a garment, an architectural structure, a construction material, and a transport, to which a characteristic of conducting or absorbing electromagnetic waves to thereby shield them is imparted. The invention has been accomplished on the basis of these findings.

BRIEF DESCRIPTION OF THE DRAWINGS

Figs. 1A and 1B each is an outline cross-sectional view partially showing an example of a sheet-like electromagnetic shielding structure in accordance with the invention.
Figs. 2A to 2C each is an outline cross-sectional view showing an example of the sheet-like electromagnetic shielding structure in accordance with the invention.
Figs. 3A to 3C each is an outline cross-sectional view showing an example of the sheet-like electromagnetic shielding structure in accordance with the invention.
Figs. 4A and 4B each is an outline cross-sectional view showing an example of the sheet-like electromagnetic shielding structure in accordance with the invention.
Fig. 5 is an outline cross-sectional view partially showing an example of the sheet-like electromagnetic shielding structure in accordance with the invention.
Figs. 6A and 6B each is an outline view partially showing an example of a fiber protection member used in the sheet-like electromagnetic shielding structure in accordance with the invention.
Fig. 7 is an outline view partially showing an example of a fiber protection member used in the sheet-like electromagnetic shielding structure in accordance with the invention.
Figs. 8A and 8B each is an outline cross-sectional view partially showing an example of the sheet-like electromagnetic shielding structure in accordance with the invention.
Fig. 9 is an outline cross-sectional view partially showing an example of the sheet-like electromagnetic shielding structure in accordance with the invention.
Figs. 10A and 10B each is an outline cross-sectional view partially showing an example of the sheet-like electromagnetic shielding structure in accordance with the invention.
Fig. 11 is an outline cross-sectional view partially showing an example of the sheet-like electromagnetic shielding structure in accordance with the invention.
Figs. 12A and 12B each is an outline cross-sectional view showing a shielding box to be used in an electromagnetic shielding evaluation system by the KEC method in which Fig. 12A shows a shielding box for electrical field and Fig. 12B shows a shielding box for magnetic field.

Description of Reference Numerals and Signs

11: Sheet-like electromagnetic shielding structure
12: Sheet-like electromagnetic shielding structure
1a: Thin layer-like substrate
1a1: Surface of thin layer-like substrate 1a
1b: Electromagnetic conducting or absorbing fiber convex structure section
2a: Sheet-like electromagnetic shielding structure
2a1: Pressure-sensitive adhesive or adhesive layer (Pressure-sensitive adhesive layer or adhesive layer)
2a2: Thin layer-like base material
2a3: Electromagnetic conducting or absorbing fiber napping section
2b: Sheet-like electromagnetic shielding structure
2b1: Pressure-sensitive adhesive layer
2b2: Release liner

2b3: Electromagnetic conducting or absorbing fiber napping section
2c: Sheet-like electromagnetic shielding structure
2c1: Polymer layer
2c2: Electromagnetic conducting or absorbing fiber napping section
3a: Sheet-like electromagnetic shielding structure
3a1: Pressure-sensitive adhesive or adhesive layer (Pressure-sensitive adhesive layer or adhesive layer)
3a2: Thin layer-like base material
3a3: Electromagnetic conducting or absorbing fiber napping section
3b: Sheet-like electromagnetic shielding structure
3b1: Pressure-sensitive adhesive layer
3b2: Release liner
3b3: Electromagnetic conducting or absorbing fiber napping section
3c: Sheet-like electromagnetic shielding structure
3c1: Polymer layer
3c2: Electromagnetic conducting or absorbing fiber napping section
4a: Sheet-like electromagnetic shielding structure
4a1: Thin layer-like substrate
4a2: Electromagnetic conducting or absorbing fiber convex structure section
4a3: Coating layer
4b: Sheet-like electromagnetic shielding structure
4b1: Thin layer-like substrate
4b2: Electromagnetic conducting or absorbing fiber convex structure section
4b3: Coating layer
4b4: Fiber protection member
5: Sheet-like electromagnetic shielding structure
5a: Thin layer-like substrate
5al: Surface of thin layer-like substrate 5a
5b: Electromagnetic conducting or absorbing fiber convex structure section
5c: Fiber protection member
61: Net-like member
62: Net-like member
61a: Penetrating hole section in net-like member 61
62a: Penetrating hole section in net-like member 62
7: Perforated sheet member
71: Sheet-like base material
72: Perforated penetrating hole section (Perforated section)
8: Sheet-like electromagnetic shielding structure
81: Structure member
81a: Thin layer-like substrate
81b: Surface of thin layer-like substrate 81a
81c: Electromagnetic conducting or absorbing fiber convex structure section
82: Structure member
82a: Thin layer-like substrate
82b: Surface of thin layer-like substrate 82a
82c: Electromagnetic conducting or absorbing fiber convex structure section
9: Sheet-like electromagnetic shielding structure
91: Structure member
91a: Thin layer-like substrate
91b: Surface of thin layer-like substrate 91a
91c: Electromagnetic conducting or absorbing fiber convex structure section
92: Structure member
92a: Thin layer-like substrate
92b: Surface of thin layer-like substrate 92a
92c: Electromagnetic conducting or absorbing fiber convex structure section
10: Sheet-like electromagnetic shielding structure
101: Structure member
101a: Thin layer-like substrate
101b: Surface of thin layer-like substrate 101a

101c: Electromagnetic conducting or absorbing fiber convex structure section
102: Structure member
102a: Thin layer-like substrate
102b: Surface of thin layer-like substrate 102a
102c: Electromagnetic conducting or absorbing fiber convex structure section
103: Structure member
103a: Thin layer-like substrate
103b: Surface of thin layer-like substrate 103a
103c: Electromagnetic conducting or absorbing fiber convex structure section
11: Sheet-like electromagnetic shielding structure
111: Structure member
111a: Thin layer-like substrate
111b: Surface of thin layer-like substrate 111a
111c: Electromagnetic conducting or absorbing fiber convex structure section
12: Sheet-like electromagnetic shielding structure
121: Structure member
121a: Thin layer-like substrate
121b: Surface of thin layer-like substrate 121a
121c: Electromagnetic conducting or absorbing fiber convex structure section
13: Sheet-like electromagnetic shielding structure
131: Structure member
131a: Thin layer-like substrate
131b: Electromagnetic conducting or absorbing fiber convex structure section
131c: Electromagnetic conducting or absorbing fiber convex structure section
132: Structure member
132a: Thin layer-like substrate
132b: Electromagnetic conducting or absorbing fiber convex structure section
133: Structure member
133a: Thin layer-like substrate
133b: Electromagnetic conducting or absorbing fiber convex structure section

DETAILED DESCRIPTION OF THE INVENTION

Namely, the present invention relates to the followings.

(1) An article to which a characteristic of shielding electromagnetic waves is imparted, which comprises at least a sheet-like electromagnetic shielding structure,
said sheet-like electromagnetic shielding structure comprising:

a thin layer-like substrate; and
a fiber convex structure section having a characteristic of conducting or absorbing electromagnetic waves,

wherein said fiber convex structure section is formed at least partially on the thin layer-like substrate in such a form that at least a part of a fiber thereof is positioned outward from the surface of the thin layer-like substrate.
(2) The article according to (1), which is an electronic device, an electronic circuit board, garment, an architectural structure, a construction material, or a transport.
(3) The article according to (2), wherein the electronic device is a mobile communication device, a handheld information terminal, or a portable personal computer.
(4) The article according to (2), wherein the article is an electronic device, and the sheet-like electromagnetic shielding structure is pressure-sensitively attached to a body of the electronic device or an electronic circuit board in the electronic device.
(5) The article according to (2), wherein the garment is an office-work apron, pregnant clothing, medical clothing, or a medical apron.
(6) The article according to (2), wherein the construction material is a wall material, a floor material, a ceiling material, a roof material, or a peripheral material of a radar system.
(7) The article according to (2), wherein the transport is an automobile, a railroad vehicle, a ship, or an aircraft.
(8) The article according to (1), wherein, in the sheet-like electromagnetic shielding structure, the thin layer-like substrate is at least one layer selected from the group consisting of a pressure-sensitive adhesive layer, an adhesive layer, and a polymer layer.

(9) The article according to (1), wherein, in the sheet-like electromagnetic shielding structure, the thin layer-like substrate has a characteristic of conducting or absorbing electromagnetic waves.

(10) The article according to (1), wherein, in the sheet-like electromagnetic shielding structure, the thin layer-like substrate is formed on at least one surface of a support.

(11) The article according to (10), wherein the support has a characteristic of conducting or absorbing electromagnetic waves.

(12) The article according to (1), wherein, in the sheet-like electromagnetic shielding structure, the fiber convex structure section having a characteristic of conducting or absorbing electromagnetic waves is coated with a coating layer.

(13) The article according to (12), wherein the coating layer has a characteristic of conducting or absorbing electromagnetic waves.

(14) The article according to (1), wherein the sheet-like electromagnetic shielding structure has such a configuration that the fiber convex structure section having a characteristic of conducting or absorbing electromagnetic waves is formed partially on the thin layer-like substrate in such a form that at least a part of a fiber thereof is positioned outward from the surface of the thin layer-like substrate; and that a fiber protection member, which is capable of suppressing or preventing the fiber convex structure section having a characteristic of conducting or absorbing electromagnetic waves from being fallen down, is provided at least partially on the surface of the thin layer-like substrate, on which the fiber convex structure section having a characteristic of conducting or absorbing electromagnetic waves is not formed.

(15) The article according to (14), wherein the fiber protection member is a member having a plurality of penetrating hole sections formed into a net shape or a sheet-like member having a plurality of penetrating hole sections formed by perforation.

(16) The article according to (1), wherein the surfaces of the sheet-like electromagnetic shielding structure on each of which the fiber convex structure sections having a characteristic of conducting or absorbing electromagnetic waves is formed are superposed with each other in an opposed state.

In the article including a sheet-like electromagnetic shielding structure in accordance with the invention, an electronic device, an electronic circuit board, garment, an architectural structure, a construction material, or a transport is suitable for the article.

As the electronic device, a mobile communication device, a handheld information terminal, or a portable personal computer is suitably usable. In such an electronic device, it is preferable that the sheet-like electromagnetic shielding structure is pressure-sensitively attached to a body of the electronic device or an electronic circuit board in the electronic device.

As the garment, an office-work apron, pregnant clothing, medical clothing, or a medical apron is suitably usable.

As the construction material, a wall material, a floor material, a ceiling material, a roof material, or a peripheral material of a radar system is suitably usable.

As the transport, an automobile, a railroad vehicle, a ship, or an aircraft is suitably usable.

As the article including such a sheet-like electromagnetic shielding structure, in the sheet-like electromagnetic shielding structure, it is preferable that the thin layer-like substrate is at least one layer selected from the group consisting of a pressure-sensitive adhesive layer, an adhesive layer, and a polymer layer. The thin layer-like substrate may have a characteristic of conducting or absorbing electromagnetic waves.

In addition, in the sheet-like electromagnetic shielding structure, the thin layer-like substrate may be formed on at least one surface of a support, and the support may have a characteristic of conducting or absorbing electromagnetic waves.

In addition, in the sheet-like electromagnetic shielding structure, the fiber convex structure section having a characteristic of conducting or absorbing electromagnetic waves may be coated with a coating layer. It is preferable that the coating layer has a characteristic of conducting or absorbing electromagnetic waves.

In addition, the sheet-like electromagnetic shielding structure may have such a configuration that the fiber convex structure section having a characteristic of conducting or absorbing electromagnetic waves is formed partially on the thin layer-like substrate in such a form that at least a part of a fiber thereof is positioned outward from the surface of the thin layer-like substrate; and that a fiber protection member, which is capable of suppressing or preventing the fiber convex structure section having a characteristic of conducting or absorbing electromagnetic waves from being fallen down, is provided at least partially on the surface of the thin layer-like substrate, on which the fiber convex structure section having a characteristic of conducting or absorbing electromagnetic waves is not formed. The fiber protection member may be a member having a plurality of penetrating hole sections formed into a net shape or a sheet-like member having a plurality of penetrating hole sections formed by perforation.

In addition, the sheet-like electromagnetic shielding structure may be configured such that the surfaces of the sheet-like electromagnetic shielding structure on each of which the fiber convex structure sections having a characteristic of conducting or absorbing electromagnetic waves is formed are superposed with each other in an opposed state.

Since the article including a sheet-like electromagnetic shielding structure in accordance with the invention has the above-mentioned configuration, a characteristic of shielding electromagnetic waves is imparted to the article in an effective manner. Accordingly, it is possible to provide an electronic device, an electronic circuit board, garment, an architectural structure, a construction material, and a transport, to which a characteristic of shielding electromagnetic waves is imparted in an effective manner.

The invention is concerned with an article including a sheet-like electromagnetic shielding structure to which a characteristic of shielding electromagnetic waves is imparted (the article being hereinafter sometimes referred to as "electromagnetic shielding structure-containing article"), in which the article includes at least the sheet-like electromagnetic shielding structure being configured such that a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

In this way, since the electromagnetic shielding structure-containing article in accordance with the invention includes at least a specific sheet-like electromagnetic shielding structure, a characteristic of conducting or absorbing electromagnetic waves to thereby shield them (the properties being hereinafter sometimes referred to as "electromagnetic shielding properties") is imparted to the article. In the invention, the electromagnetic shielding structure-containing article may exhibit the electromagnetic shielding properties by reflecting electromagnetic waves, by conducing or absorbing electromagnetic waves, or by the combination thereof (i.e., by reflecting, conducting or absorbing electromagnetic waves).

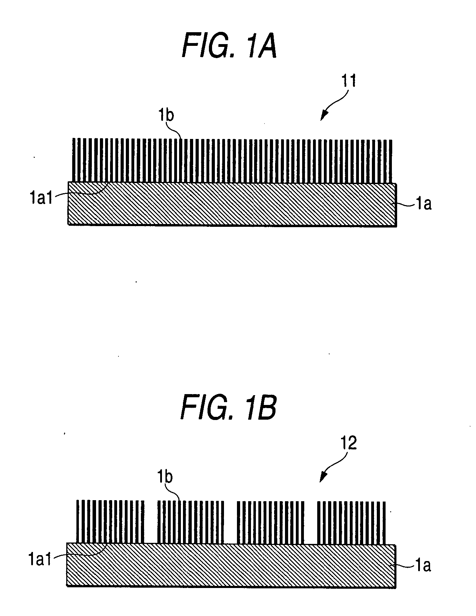

The above-mentioned sheet-like electromagnetic shielding structure is configured such that a fiber convex structure section having a characteristic of conducting or absorbing electromagnetic waves (the section being hereinafter sometimes referred to as "electromagnetic conducting or absorbing fiber convex structure section") is formed at least partially on a thin layer-like substrate in such a form that at least a part of a fiber thereof is positioned outward from the surface of the thin layer-like substrate. As shown in Figs. 1A and 1B, the sheet-like electromagnetic shielding structure includes a thin layer-like substrate, and the electromagnetic conducting or absorbing fiber convex structure section is formed at least partially (entirely or partially) on the thin layer-like substrate in such a form that at least a part of a fiber thereof is positioned outward from the surface of the thin layer-like substrate. In this way, since the sheet-like electromagnetic shielding structure has the electromagnetic conducting or absorbing fiber convex structure section, it can exhibit a characteristic of conducting or absorbing electromagnetic waves (hereinafter sometimes referred to as "electromagnetic conducting or absorbing properties") at an excellent level. Accordingly, it is possible to impart the electromagnetic shielding properties to the electromagnetic shielding structure-containing article.

Figs. 1A and 1B each is an outline cross-sectional view partially showing an example of a sheet-like electromagnetic shielding structure in accordance with the invention. In Figs. 1A and 1B, 11 and 12 each stands for a sheet-like electromagnetic shielding structure; 1a stands for a thin layer-like substrate; 1a1 stands for the surface of the thin layer-like substrate 1a; and 1b stands for an electromagnetic conducting or absorbing fiber convex structure section. The sheet-like electromagnetic shielding structure 11 as shown in Fig. 1A has a configuration in which the electromagnetic conducting or absorbing fiber convex structure section 1b is formed entirely on the surface 1a1 of the thin layer-like substrate 1a. The sheet-like electromagnetic shielding structure 12 as shown in Fig. 1B has a configuration in which the electromagnetic conducting or absorbing fiber convex structure section 1b is formed partially on the surface 1a1 of the thin layer-like substrate 1a.

Electromagnetic Conducting or Absorbing Fiber Convex Structure section

In the sheet-like electromagnetic shielding structure in accordance with the invention, the electromagnetic conducting or absorbing fiber convex structure section is formed at least partially on a thin layer-like substrate in such a form that at least a part of a fiber thereof is positioned outward (in the external side) from the surface of the thin layer-like substrate. With respect to the above-mentioned electromagnetic conducting or absorbing fiber convex structure section, the form or configuration thereof is not particularly limited so far as it is formed in such a form that at least a part of a fiber thereof is positioned outward from the surface of the thin layer-like substrate and has electromagnetic conducting or absorbing properties. Specifically, examples of the configuration of the electromagnetic conducting or absorbing fiber convex structure section include (1) a configuration in which the electromagnetic conducting or absorbing fiber convex structure section is formed at least partially (entirely or partially) on the surface of the thin layer-like substrate; and (2) a configuration in which a concave is partially formed in the thin layer-like substrate and the electromagnetic conducting or absorbing fiber convex structure section is formed on the wall surface of the concave in such a form that at least a part of a fiber thereof is protruded outward (on the external side) from the surface of the thin layer-like substrate.

With respect to the configuration of such an electro-magnetic conducting or absorbing fiber convex structure section, in the above-mentioned configuration (1), since the electromagnetic conducting or absorbing fiber convex structure section is formed on the surface of the thin layer-like substrate, it may be said that the configuration has a configuration having a portion in which all fibers are positioned outward from the surface of the thin layer-like substrate. Furthermore, in the above-mentioned configuration (2), since the electromagnetic conducting or absorbing fiber convex structure section is formed on the wall surface of a concave of the thin layer-like substrate, it can be said that the configuration has a configuration having a portion in which at least a part of the fiber (moreover, a part of one fiber) is positioned outward from the surface of the thin layer-like substrate. In this way, in the electromagnetic conducting or absorbing fiber convex structure section, it is not always required that all fibers are positioned outward (on the external side) from the surface of the thin layer-like substrate. It is only required that at least a part of the fiber (for example, in the case where the electromagnetic conducting or absorbing fiber convex structure section is formed on the wall surface of a concave of the thin layer-like substrate, a fiber formed in the upper side of the wall surface of the concave of the thin layer-like substrate) is positioned outward from the surface of the thin layer-like substrate.

Furthermore, as the fiber which is positioned outward from the surface of the thin layer-like substrate, it is not always required that the full length of one fiber is positioned outward from the surface of the thin layer-like substrate. It is only required that at least a part of one fiber is positioned outward from the surface of the thin layer-like substrate.

In addition, in the case where the electromagnetic conducting or absorbing fiber convex structure section is formed on the wall surface of a concave of the thin layer-like substrate, it is not always required that the electromagnetic conducting or absorbing fiber convex structure section is formed on the entire surface of the wall surface of the concave of the thin layer-like substrate. It is only required that the electromagnetic conducting or absorbing fiber convex structure section is formed on at least a part of the wall surface of the concave of the thin layer-like substrate.

The electromagnetic conducting or absorbing fiber convex structure section is only required to be a structure section having a shape in which at least a part of the fiber is positioned outward from the surface of the thin layer-like substrate and the shape is formed in a convex shape due to the fiber and having electromagnetic conducting or absorbing properties. Examples thereof include a fiber napping section having electromagnetic conducting or absorbing properties (the fiber napping section being hereinafter sometimes referred to as "electromagnetic conducting or absorbing fiber napping section") of a structure in which the fiber stands up from the surface on which the fiber is formed; and an electromagnetic conducting or absorbing fiber convex structure section of a structure in which a mass of the fiber is provided on the surface on which the fiber is formed. Specifically, in the case where the electromagnetic conducting or absorbing fiber convex structure section is formed on the surface of the thin layer-like substrate, examples thereof include an electromagnetic conducting or absorbing fiber napping section of a structure in which the fiber stands up from the surface of the thin layer-like substrate; and an electromagnetic conducting or absorbing fiber convex structure section of a structure in which a mass of the fiber is provided on the surface of the thin layer-like substrate. Furthermore, in the case where the electromagnetic conducting or absorbing fiber convex structure section is formed on the wall surface of a concave of the thin layer-like substrate, examples thereof include an electromagnetic conducting or absorbing fiber napping section of a structure in which at least a part of the fiber stands up from the wall surface of a concave of the thin layer-like substrate and is protruded outward from the surface of the thin layer-like substrate (in particular, the end of the fiber is protruded); and an electromagnetic conducting or absorbing fiber convex structure section of a structure in which a mass of the fiber is provided on the wall surface of a concave of the thin layer-like substrate and a part of the fiber is protruded outward from the surface of the thin layer-like substrate. The electromagnetic conducting or absorbing fiber convex structure section may be configured of a single structure or a structure of a combination of plural structures.

Incidentally, one electromagnetic conducting or absorbing fiber convex structure section is usually configured of plural fibers. The number or density of fibers which constitute one electromagnetic conducting or absorbing fiber convex structure section is not particularly limited but can be properly selected depending on the desired electromagnetic conducting or absorbing properties.

As the electromagnetic conducting or absorbing fiber convex structure section, an electromagnetic conducting and absorbing fiber napping section of a structure in which the fiber stands up from the surface on which the fiber is formed (in particular, the electromagnetic conducting and absorbing fiber napping section of a structure in which the fiber stands up from the surface of the thin layer-like substrate) is preferable.

Examples of the structure of such an electromagnetic conducting or absorbing fiber napping section include (1) a structure in which the fiber stands up in a substantially "I" shape and is protruded outward from the surface of the thin layer-like substrate in a state that one end of one fiber is adhered and fixed to a prescribed surface (for example, the surface of the thin layer-like substrate or the wall surface of the concave) of the thin layer-like substrate, while the other end of the fiber is not fixed (it is freely movable); (2) a structure in which the fiber stands up in a substantially "V" shape and is protruded outward from the surface of the thin layer-like substrate in a state that the center of one fiber is adhered to a prescribed surface (for example, the surface of the thin layer-like substrate or the wall surface of the concave) of the thin layer-like substrate, while both ends of the fiber are not fixed (they are freely movable); and (3) a structure in which the fiber stands up in a substantially inverse "U" shape and is protruded outward from the surface of the thin layer-like substrate in a state that the both ends of one fiber are adhered and fixed to a prescribed surface (for example, the surface of the thin layer-like substrate or the wall surface of the concave) of the thin layer-like substrate, while the center of the fiber is not fixed (it is freely movable). Besides, examples thereof may include a structure in which the fiber stands up in a shape such as a substantially "W" shape, a substantially "M" shape, a substantially "N" shape, and a substantially "0" shape from a prescribed surface (for example, the surface of the thin layer-like substrate or the wall surface of the concave) of the thin layer-like substrate and is protruded outward from the surface of the thin layer-like substrate; and a structure of a combination of these structures. As a structure of the electromagnetic conducting or absorbing fiber napping section, the above-mentioned structure (1) (a structure in which the fiber stands up in a substantially "I" shape from a prescribed surface of the thin layer-like substrate, such as the surface of the thin layer-like substrate or the wall surface of the concave, and is protruded outward from the surface of the thin layer-like substrate) is suitable.

As a matter of course, the electromagnetic conducting or absorbing fiber napping section may be in a state that the fiber linearly stands up in an "I" shape from a prescribed surface (for example, the surface of the thin layer-like substrate or the wall surface of the concave) of the thin layer-like substrate and is protruded outward from the surface of the thin layer-like substrate, or in a state that the fiber stands up as a whole in a state having a jagged form, a wave line form, a loop form or the like and is protruded outward from the surface of the thin layer-like substrate.

In the case where the electromagnetic conducting or absorbing fiber convex structure section is partially formed on the thin layer-like substrate, the shape as a whole is not particularly limited, but it may have a prescribed pattern shape. Incidentally, in the case where the electromagnetic conducting or absorbing fiber convex structure section is formed on the wall surface of the concave of the thin layer-like substrate, the shape as a whole in the electromagnetic conducting or absorbing fiber convex structure section is corresponding to the shape of the concave as a whole.

Although the whole area of a site on the thin layer-like substrate in which the electromagnetic conducting or absorbing fiber convex structure section is provided (area of the whole electromagnetic conducting or absorbing fiber convex structure section) is not particularly limited, for example, the whole area may be desirably selected from the range of an area corresponding to greater than 0% of the whole surface area at one surface of the thin layer-like substrate from the viewpoints of the electromagnetic conducting or absorbing properties. The area of the whole electromagnetic conducting or absorbing fiber convex structure section can be properly selected depending on the purpose of use of the sheet-like electromagnetic shielding structure or the size of the surface area at one surface of the sheet-like electromagnetic shielding structure. Specifically, in the case where the sheet-like electromagnetic shielding structure is used for an electronic device or an electronic circuit board (that is, in the case where the structure is used for the electronic device such as a mobile communication device, a handheld information terminal or a portable personal computer, or an electronic circuit board in the electronic device), the area of the whole electromagnetic conducting or absorbing fiber convex structure section is preferably 0.3% or more, more preferably 30% or more, and especially preferably 45% or more. Furthermore, in the case where the sheet-like electromagnetic shielding structure is used for garment, an architectural structure, a construction material, and a transport equipped with an engine, the area of the whole electromagnetic conducting or absorbing fiber convex structure section is preferably 0.03% or more, more preferably 0.1% or more, and especially preferably 0.3% or more.

In addition, in the case where the electromagnetic conducting or absorbing fiber convex structure sections are partially formed on the thin layer-like substrate, the area of the respective electromagnetic conducting or absorbing fiber convex structure sections in the surface of the thin layer-like substrate or the shortest interval between the respective electromagnetic conducting or absorbing fiber convex structure sections is not particularly limited.

Incidentally, as the area of the electromagnetic conducting or absorbing fiber convex structure section on the surface of the thin layer-like substrate, the area of a portion surrounded by the electromagnetic conducting or absorbing fiber convex structure section can be employed. Accordingly, in the case where the electromagnetic conducting or absorbing fiber convex structure section is formed on the wall surface of the concave of the thin layer-like substrate, the area of the electromagnetic conducting or absorbing fiber convex structure section on the surface of the thin layer-like substrate is corresponding to the area of an opening of the concave on the surface of the thin layer-like substrate.

Such an electromagnetic conducting or absorbing fiber convex structure section can be configured of a fiber having electromagnetic conducting or absorbing properties (the fiber being hereinafter sometimes referred to as "electromagnetic conducting or absorbing fiber"). Although the electromagnetic conducting or absorbing fiber is not particularly limited, it may be a fiber in which a fiber raw material itself has electromagnetic conducting or absorbing properties (the fiber being hereinafter sometimes referred to as "electromagnetic conducting or absorbing raw material fiber") or may be a fiber in which electromagnetic conducting or absorbing properties are imparted to a fiber raw material by an electromagnetic conducting or absorbing material (the fiber being hereinafter sometimes referred to as "electromagnetic conducting or absorbing properties-imparted fiber"). The electromagnetic conducting or absorbing fiber may be used singly or in combination of two or more kinds thereof.

Incidentally, as the fiber which constitutes the electromagnetic conducting or absorbing fiber convex structure section, a fiber not having the electromagnetic conducting or absorbing properties (the fiber being hereinafter sometimes referred to as "non-electromagnetic conducting or absorbing fiber") may be used together with the electromagnetic conducting or absorbing fiber. In this way, in the case where the non-electromagnetic conducting or absorbing fiber is used together with the electromagnetic conducting or absorbing fiber, the electromagnetic conducting or absorbing fiber and the non-electromagnetic conducting or absorbing fiber may be used as a separate yarn from each other or may be used as a single yarn. That is, the electromagnetic conducting or absorbing fiber convex structure section may be configured of a yarn composed of only the electromagnetic conducting or absorbing fiber and a yarn composed of only the non-electromagnetic conducting or absorbing fiber or may be configured of a twisted yarn of the electromagnetic conducting or absorbing fiber and the non-electromagnetic conducting or absorbing fiber. Examples of the non-electromagnetic conducting or absorbing fiber include a cotton fiber, a rayon fiber, a polyamide-based fiber, a polyester-based fiber, a polyacrylonitrile-based fiber, an acrylic fiber, a polyvinyl alcohol fiber, a polyethylene-based fiber, a polyimide-based fiber, a polyolefin-based fiber, a silicone-based fiber, and a fluorine-based resin fiber.

In the electromagnetic conducting or absorbing fiber, a fiber configured of a material in which the fiber raw material itself has the electromagnetic conducting or absorbing properties can be used as the electromagnetic conducting or absorbing raw material fiber. Examples of the electromagnetic conducting or absorbing raw material fiber include a metallic fiber in addition to a carbon-based fiber and a fiber made of an electrically conductive polymer. Incidentally, examples of the carbon-based fiber include a fiber made of a carbon-based raw material such as carbon black. Furthermore, the electrically conductive polymer in the fiber made of an electrically conductive polymer is not particularly limited, but examples thereof include a polyacetylene-based electrically conductive polymer, a polypyrrole-based electrically conductive polymer, a polyacene-based electrically conductive polymer, a polyphenylene-based electrically conductive polymer, a polyaniline-based electrically conductive polymer, and a polythiophene-based electrically conductive polymer. In addition, although the metallic fiber is not particularly limited, it can be properly selected among fibers made of a metal material as specifically enumerated below. Specific examples of the metallic fiber include fibers made of a metal element such as a gold fiber, a silver fiber, an aluminum fiber, an iron fiber, a copper fiber, a nickel fiber, a stainless steel-based fiber, or a copper-nickel alloy fiber and fibers made of a metallic compound of every kind including metal elements and non-metal elements such as a copper sulfide fiber.

Furthermore, in the electromagnetic conducting or absorbing fiber, the electromagnetic conducting or absorbing properties-imparted fiber is not particularly limited so far as it is a fiber in a form that electromagnetic conducting or absorbing properties are imparted by an electromagnetic conducting or absorbing material. Examples thereof include a fiber coated by an electromagnetic conducting or absorbing material (the fiber being hereinafter sometimes referred to as "electromagnetic conducting or absorbing material-coated fiber"); a fiber having an electromagnetic conducting or absorbing material impregnated therewith (the fiber being hereinafter sometimes referred to as "electromagnetic conducting or absorbing material-impregnated fiber"); and a fiber containing an electromagnetic conducting or absorbing material in a fiber raw material (the fiber being hereinafter sometimes referred to as "electromagnetic conducting or absorbing material-containing raw material fiber").

As the electromagnetic conducting or absorbing properties-imparted fiber, the electromagnetic conducting or absorbing material-coated fiber and the electromagnetic conducting or absorbing material-impregnated fiber can be suitably used. In the electromagnetic conducting or absorbing material-coated fiber and the electromagnetic conducting or absorbing material-impregnated fiber as the electromagnetic conducting or absorbing properties-imparted fiber, a fiber (fiber raw material) before the electromagnetic conducting or absorbing properties are imparted by the electromagnetic conducting or absorbing material is not particularly limited, and any of a natural fiber, a semi-synthetic fiber, and a synthetic fiber may be employed. Furthermore, the fiber raw material (fiber) may be an electromagnetic conducting or absorbing fiber or may be a non-electromagnetic conducting or absorbing fiber. More specifically, examples of the fiber raw material (fiber) include a non-electromagnetic conducting or absorbing fiber such as a cotton fiber, a rayon fiber, a polyamide-based fiber [for example, an aliphatic polyamide fiber and an aromatic polyamide fiber (so-called aramid fiber)], a polyester-based fiber (for example, a trade name "TETRON"), a polyacrylonitrile-based fiber, an acrylic fiber, a polyvinyl alcohol fiber (so-called vinylon fiber), a polyethylene-based fiber, a polyimide-based fiber, a polyolefin-based fiber, a silicone-based fiber, and a fluorine-based resin fiber; and an electromagnetic conducting or absorbing fiber such as a carbon fiber (carbon-based fiber). As the fiber raw material, a nonmagnetic conducting or absorbing fiber is preferable; and a cotton fiber, a rayon fiber, a polyamide-based fiber, and a polyester-based fiber are especially preferable. The fiber raw material may be used singly or in combination of two or more kinds thereof.

Moreover, in the electromagnetic conducting or absorbing material-coated fiber as the electromagnetic conducting or absorbing properties-imparted fiber, the electromagnetic conducting or absorbing material is not particularly limited. For example, in addition to a metal material and a plastic material having electromagnetic conducting or absorbing properties (the material being hereinafter sometimes referred to as "electromagnetic conducting or absorbing plastic material"), a magnetic material of every kind can be used. Of these, a metal material can be suitably used. The electromagnetic conducting or absorbing material can be used singly or in combination of two or more kinds thereof. In the electromagnetic conducting or absorbing material-coated fiber, the metal material may be a metal material composed of only a metal element such as a metal element single body and an alloy or may be a metallic compound of every kind containing a non-metal element together with a metal element. As the metal material, a metal material composed of only a metal element is suitable. Specifically, examples of the metal element in the metal material composed of a metal element single body include an element belong to the Group 1 of the Periodic Table (for example, lithium, sodium, potassium, rubidium, and cesium); an element belonging to the Group 2 of the Periodic Table (for example, magnesium, calcium, strontium, and barium); an element belonging to the Group 3 of the Periodic Table (for example, scandium, yttrium, lathanoids (for example, lanthanum and cerium), and actinoids (for example, actinium)); an element belonging to the Group 4 of the Periodic Table (for example, titanium, zirconium, and hafnium); an element belonging to the Group 5 of the Periodic Table (for example, vanadium, niobium, and tantalum); an element belonging to the Group 6 of the Periodic Table (for example, chromium, molybdenum, and tungsten); an element belonging to the Group 7 of the Periodic Table (for example, manganese, technetium, rhenium); an element belonging to the Group 8 of the Periodic Table (for example, iron, ruthenium, and osmium); an element belonging to the Group 9 of the Periodic Table (for example, cobalt, rhodium, and iridium); an element belonging to the Group 10 of the Periodic Table (for example, nickel, palladium, and platinum); an element belonging to the Group 11 of the Periodic Table (for example, copper, silver, and gold); an element belonging to the Group 12 of the Periodic Table (for example, zinc, cadmium, and mercury); an element belonging to the Group 13 of the Periodic Table (for example, aluminum, gallium, indium, thallium); an element belonging to the Group 14 of the Periodic Table (for example, tin and lead); and an element belonging to the Group 15 of the Periodic Table (for example, antimony and bismuth). On the other hand, examples of the alloy include stainless steel, a copper-nickel alloy, brass, a nickel-chromium alloy, an iron-nickel alloy, a zinc-nickel alloy, a gold-copper alloy, a tin-lead alloy, a silver-tin-lead alloy, a nickel-chromium-iron alloy, a copper-manganese-nickel alloy, and a nickel-manganese-iron alloy.

Furthermore, the metallic compound of every kind containing a non-metal element together with a metal element is not particularly limited so far as it is a metallic compound containing a metal element or an alloy as enumerated previously and capable of exhibiting the electromagnetic conducting or absorbing properties. Examples thereof include a metal sulfide (for example, copper sulfide); a metal oxide (for example, iron oxide, titanium oxide, tin oxide, indium oxide, and cadmium tin oxide); and a metal composite oxide.

Specifically, as the metal material, gold, silver, aluminum, iron, copper, nickel, stainless steel, and a copper-nickel alloy can be suitably used. In particular, gold, silver, aluminum, copper, nickel, and a copper-nickel alloy can be suitably used.

Incidentally, examples of the electromagnetic conducting or absorbing plastic material include an electrically conductive plastic material such as a polyacetylene-based electrically conductive polymer, a polypyrrole-based electrically conductive polymer, a polyacene-based electrically conductive polymer, a polyphenylene-based electrically conductive polymer, a polyaniline-based electrically conductive polymer, and a polythiophene-based electrically conductive polymer.

In addition, the magnetic material is not particularly limited, and examples thereof include a soft magnetic powder, ferrite of every kind, and a zinc oxide whisker. As the magnetic material, a ferromagnetic material exhibiting ferromagnetism or ferrimagnetism is suitable. Specific examples of the magnetic material include high-magnetic permeability ferrite (for example, so-called soft ferrite" (for example, so-called "Mn ferrite," so-called "Ni ferrite," so-called "Zn ferrite," so-called "Mn-Zn ferrite," and so-called "Ni-Zn ferrite")), pure iron, silicon atom-containing iron (for example, so-called "silicon steel"), a nickel-iron-based alloy (for example, so-called "permalloy" (for example, an nickel-manganese-iron alloy, a nickel-molybdenum-copper-iron alloy, and a nickel-molybdenum-manganese-iron alloy)), an iron-cobalt-based alloy, an amorphous metal high-magnetic permeability material, an iron-aluminum-silicon alloy (for example, so-called "Sendust alloy"), an iron-aluminum-silicon-nickel alloy (for example, so-called "Super Sendust alloy"), so-called "ferrite magnet" (for example, so-called "hard ferrite" (for example, so-called "Ba ferrite" and so-called "Sr ferrite")), so-called "Alnico magnet" (for example, an iron-nickel-aluminum-cobalt alloy), an iron-chromium-cobalt alloy, so-called "rare earth cobalt magnet" (for example, so-called "Sm-Co magnet" and co-called "2-17 type magnet"), so-called "Nd-Fe-B magnet," so-called "rare earth-iron-nitrogen interstitial compound magnet," and so-called "Mn-Al-C magnet".

In the electromagnetic conducting or absorbing material-coated fiber, a method for coating an electromagnetic conducting or absorbing material on a fiber raw material is not particularly limited, but a known coating method can be properly selected and applied depending on the type of the electromagnetic conducting or absorbing material. For example, in the case where the electromagnetic conducting or absorbing material is a metal material, as a method for forming the electromagnetic conducting or absorbing material-coated fiber, a coating method by vapor deposition of a metal material and a coating method by plating of a metal material are suitable.

Furthermore, in the electromagnetic conducting or absorbing material-impregnated fiber as the electromagnetic conducting or absorbing properties-imparted fiber, an electromagnetic conducting or absorbing material (for example, a metal material, an electromagnetic conducting or absorbing plastic material, and a magnetic material) the same as the electromagnetic conducting or absorbing material in the above-mentioned electromagnetic conducting or absorbing material-coated fiber can be used as the electromagnetic conducting or absorbing material, and a metal material (in particular, gold, silver, aluminum, copper, nickel, and a copper-nickel alloy) can be suitably used. In the electromagnetic conducting or absorbing material-impregnated fiber, a method for impregnating the fiber raw material with the electromagnetic conducting or absorbing material is not particularly limited, but a known impregnation method can be properly selected and applied depending on the type of the electromagnetic conducting or absorbing material. For example, in the case where the electromagnetic conducting or absorbing material is a metal material, as a method for forming the electromagnetic conducting or absorbing material-impregnated fiber, an impregnation method for dipping the fiber raw material into the metal material is suitable.

Incidentally, in the electromagnetic conducting or absorbing material-containing raw material fiber as the electromagnetic conducting or absorbing properties-imparted fiber, an electromagnetic conducting or absorbing material (for example, a metal material, an electromagnetic conducting or absorbing plastic material, and a magnetic material) the same as the electromagnetic conducting or absorbing material in the above-mentioned electromagnetic conducting or absorbing material-coated fiber can be used as the electromagnetic conducting or absorbing material, and a metal material (in particular, gold, silver, aluminum, copper, nickel, and a copper-nickel alloy) can be suitably used. The electromagnetic conducting or absorbing material such as a metal material may have a form of every kind such as a powdery form, a film-like form, a foil-like form, a thin layer-like form, and a fibrous form. Furthermore, as a material of the fiber raw material in the electromagnetic conducting or absorbing material-containing raw material fiber, a plastic material (for example, a polyamide, a polyester, polyacrylonitrile, an acrylic resin, polyvinyl alcohol, polyethylene, a polyimide, a polyolefin-based resin, a silicone-based resin, and a fluorine-based resin) is suitably used. In the electromagnetic conducting or absorbing material-containing raw material fiber, a method for containing the electromagnetic conducting or absorbing material in the fiber raw material is not particularly limited, but a known containing method can be properly selected and applied depending on the type of the electromagnetic conducting or absorbing material. For example, there is enumerated a method for containing the electromagnetic conducting or absorbing material in the fiber raw material by mixing a material of the fiber raw material with the electromagnetic conducting or absorbing material by means of kneading or the like and then fibrillating the mixture.

In the invention, as the electromagnetic conducting or absorbing fiber, at least one kind of a fiber selected from an electromagnetic conducting or absorbing material-coated fiber, an electromagnetic conducting or absorbing material-impregnated fiber, and an electromagnetic conducting or absorbing raw material fiber can be suitably used. Accordingly, the electromagnetic conducting or absorbing fiber convex structure section can be suitably configured of at least one kind of a fiber selected from an electromagnetic conducting or absorbing material-coated fiber, an electromagnetic conducting or absorbing material-impregnated fiber, and an electromagnetic conducting or absorbing raw material fiber.

As such an electromagnetic conducting or absorbing fiber (or fiber raw material), a short fiber can be suitably used. As the length of the electromagnetic conducting or absorbing fiber is increased, the electromagnetic conducting or absorbing fiber convex structure section is likely to be fallen down. It is desired that the electromagnetic conducting or absorbing fiber (or fiber raw material) has a length of from about 0.1 to 5 mm (preferably from 0.3 to 5 mm, and more preferably from 0.3 to 2 mm). Incidentally, when the length of the electromagnetic conducting or absorbing fiber is too short, the production is difficult and the costs become high, and therefore, such is not preferable from the viewpoint of cost.

Furthermore, the thickness of the electromagnetic conducting or absorbing fiber (fiber raw material) is not particularly limited, but for example, it can be selected within the range of from about 0.1 to 20 deniers (preferably from 0.5 to 15 deniers, and more preferably from 1 to 6 deniers). When the thickness of the electromagnetic conducting or absorbing fiber is too thick, for example, the bendability or flexibility of the structure is lowered. On the other hand, when the thickness of the electromagnetic conducting or absorbing fiber is too thin, the handling properties are lowered, and therefore, such is not preferable.

In addition, the thickness of the electromagnetic conducting or absorbing fiber (fiber raw material) may be defined or specified by the diameter thereof. The diameter of the electromagnetic conducting or absorbing fiber can be selected within the range of from about 5 to 100 $\mu$m (preferably from 10 to 50 $\mu$m, and more preferably from 15 to 45 $\mu$m).

Incidentally, as the electromagnetic conducting or absorbing fiber, plural kinds or two or more kinds of electromagnetic conducting or absorbing fibers or an electromagnetic conducting or absorbing fibers using plural kinds or two or more kinds of electromagnetic conducting or absorbing materials are preferably used. In particular, plural kinds or two or more kinds of electromagnetic conducting or absorbing fibers can be suitably used. In the case where plural kinds or two or more kinds of electromagnetic conducting or absorbing fibers are used as the electromagnetic conducting or absorbing fiber, the plural kinds or two or more kinds of electromagnetic conducting or absorbing fibers may be used as a separate yarn from each other or may be used as a single yarn. That is, the electromagnetic conducting or absorbing fiber convex structure section may be configured of plural kinds or two or more kinds of yarns composed of plural kinds or two or more kinds of electromagnetic conducting or absorbing fibers, or may be configured of a twisted yarn using plural kinds or two or more kinds of electromagnetic conducting or absorbing fibers. In this way, by using plural kinds or two or more kinds of electromagnetic conducting or absorbing fibers or the like as the electromagnetic conducting or absorbing fiber, it is possible to obtain a structure corresponding to a wide range of electromagnetic waves as described below.

A method for forming the electromagnetic conducting or absorbing fiber convex structure section (in particular, the electromagnetic conducting or absorbing fiber napping section) is not particularly limited, but a flocking processing method (in particular, an electrostatic flocking processing method) can be suitably applied as described below. As the above-mentioned electrostatic flocking processing method, all of an up method, a down method and a side method may be employed. Incidentally, in forming the electromagnetic conducting or absorbing fiber convex structure section partially in a prescribed site on the surface of the thin layer-like substrate by the flocking processing method, it is preferred to perform the flocking processing method after forming a member having a penetrating hole section at the position corresponding to a prescribed site on the surface of the thin layer-like substrate in which the electromagnetic conducting or absorbing fiber convex structure section is to be formed. Furthermore, in forming the electromagnetic conducting or absorbing fiber convex structure section on the wall surface of the concave of the thin layer-like substrate by the flocking processing method, it is preferred to perform the flocking processing method after forming a member having a penetrating hole section at the position corresponding to the concave of the thin layer-like substrate (the concave in which the electromagnetic conducting or absorbing fiber convex structure section is to be formed).

Thin Layer-like Substrate

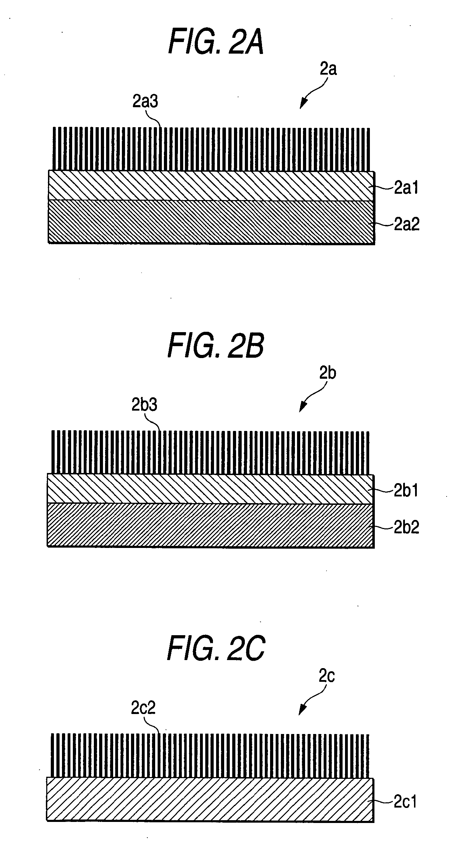

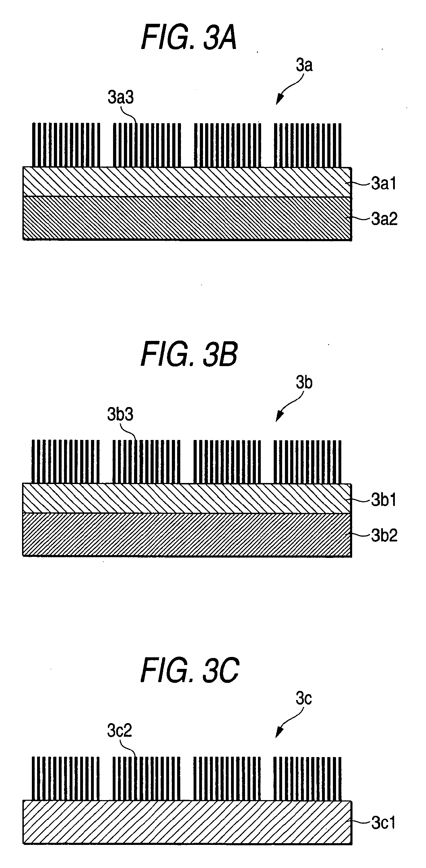

A thin layer-like substrate for forming the electromagnetic conducting or absorbing fiber convex structure section is not particularly limited so long as it can secure the flexibility or the pressure-sensitive adhesive properties or adhesive properties (pressure-sensitive adhesive or adhesive properties) in forming the electromagnetic conducting or absorbing fiber convex structure section. The thin layer-like substrate may have any form of a single-layered form or a laminated form. In the invention, as shown in Figs. 2A to 2C or Figs. 3A to 3C, as the thin layer-like substrate, a pressure-sensitive adhesive layer, an adhesive layer or a polymer layer can be suitably used. Of these layers, a pressure-sensitive adhesive layer or an adhesive layer (hereinafter sometimes referred to as "pressure-sensitive adhesive or adhesive layer") is especially suitable. Figs. 2A to 2C each is an outline cross-sectional view showing an example of the sheet-like electromagnetic shielding structure in accordance with the invention. In Figs. 2A to 2C, 2a stands for a sheet-like electromagnetic shielding structure; 2a 1 stands for a pressure-sensitive adhesive or adhesive layer (a pressure-sensitive adhesive layer or an adhesive layer); 2a2 stands for a thin layer-like base material; 2a3 stands for an electromagnetic conducting or absorbing fiber napping section; 2b stands for a sheet-like electromagnetic shielding structure; 2b 1 stands for a pressure-sensitive adhesive layer; 2b2 stands for a release liner; 2b3 stands for an electromagnetic conducting or absorbing fiber napping section; 2c stands for a sheet-like electromagnetic shielding structure; 2cl stands for a polymer layer; and 2c2 stands for an electromagnetic conducting or absorbing fiber napping section. The sheet-like electromagnetic shielding structure 2a as shown in Fig. 2Ahas a configuration in which the pressure-sensitive adhesive or adhesive layer 2a1 as the thin layer-like substrate is formed on one surface of the base material 2a2 as the support, and the electromagnetic conducting or absorbing fiber napping section 2a3 as the electromagnetic conducting or absorbing fiber convex structure section is formed entirely on the surface of the pressure-sensitive adhesive or adhesive layer 2a1. The sheet-like electromagnetic shielding structure 2b as shown in Fig. 2B has a configuration in which the pressure-sensitive adhesive layer 2b 1 as the thin layer-like substrate is formed on one surface of the release liner 2b2 as the support, and the electromagnetic conducting or absorbing fiber napping section 2b3 as the electromagnetic conducting or absorbing fiber convex structure section is formed entirely on the surface of the pressure-sensitive adhesive layer 2b1. The sheet-like electromagnetic shielding structure 2c as shown in Fig. 2C has a configuration in which the electromagnetic conducting or absorbing fiber napping section 2c2 as the electromagnetic conducting or absorbing fiber convex structure section is formed entirely on the surface of the polymer layer 2c1 as the thin layer-like substrate.

Figs. 3A to 3C each is an outline cross-sectional view showing an example of the sheet-like electromagnetic shielding structure in accordance with the invention. In Figs. 3Ato 3C, 3a stands for a sheet-like electromagnetic shielding structure; 3a1 stands for a pressure-sensitive adhesive or adhesive layer (a pressure-sensitive adhesive layer or an adhesive layer); 3a2 stands for a thin layer-like base material; 3a3 stands for an electromagnetic conducting or absorbing fiber napping section; 3b stands for a sheet-like electromagnetic shielding structure; 3b1 stands for a pressure-sensitive adhesive layer; 3b2 stands for a release liner; 3b3 stands for an electromagnetic conducting or absorbing fiber napping section; 3c stands for a sheet-like electromagnetic shielding structure; 3c1 stands for a polymer layer; and 3c2 stands for an electromagnetic conducting or absorbing fiber napping section. The sheet-like electromagnetic shielding structure 3a as shown in Fig. 3A has a configuration in which the pressure-sensitive adhesive or adhesive layer 3a1 as the thin layer-like substrate is formed on one surface of the base material 3a2 as the support, and the electromagnetic conducting or absorbing fiber napping section 3a3 as the electromagnetic conducting or absorbing fiber convex structure section is formed partially on the surface of the pressure-sensitive adhesive or adhesive layer 3al. The sheet-like electromagnetic shielding structure 3b as shown in Fig. 3B has a configuration in which the pressure-sensitive adhesive layer 3b 1 as the thin layer-like substrate is formed on one surface of the release liner 3b2 as the support, and the electromagnetic conducting or absorbing fiber napping section 3b3 as the electromagnetic conducting or absorbing fiber convex structure section is formed partially on the surface of the pressure-sensitive adhesive layer 3b1. The sheet-like electromagnetic shielding structure 3c as shown in Fig. 3C has a configuration in which the electromagnetic conducting or absorbing fiber napping section 3c2 as the electromagnetic conducting or absorbing fiber convex structure section is formed partially on the surface of the polymer layer 3c1 as the thin layer-like substrate.

In such a pressure-sensitive adhesive layer or an adhesive layer (pressure-sensitive adhesive or adhesive layer) as the thin layer-like substrate, the pressure-sensitive adhesive which constitutes the pressure-sensitive adhesive layer is not particularly limited, and useful examples thereof include a known pressure-sensitive adhesive such as a rubber-based pressure-sensitive adhesive, an acrylic pressure-sensitive adhesive, a polyester-based pressure-sensitive adhesive, a urethane-based pressure-sensitive adhesive, a polyamide-based pressure-sensitive adhesive, an epoxy-based pressure-sensitive adhesive, a vinyl alkyl ether-based pressure-sensitive adhesive, a silicone-based pressure-sensitive adhesive, and a fluorine-based pressure-sensitive adhesive. Furthermore, the pressure-sensitive adhesive may be a hot melt type pressure-sensitive adhesive. On the other hand, the adhesive which constitutes the adhesive layer is not particularly limited, and useful examples thereof include a known adhesive such as a rubber-based adhesive, an acrylic adhesive, a polyester-based adhesive, a urethane-based adhesive, a polyamide-based adhesive, an epoxy-based adhesive, a vinyl alkyl ether-based adhesive, a silicone-based adhesive, and a fluorine-based adhesive. Moreover, the adhesive may be a heat-sensitive adhesive. The pressure-sensitive adhesive or adhesive can be used singly or in combination of two or more kinds thereof. The pressure-sensitive adhesive or adhesive may be a pressure-sensitive adhesive or adhesive of any form such as an emulsion-based form, a solvent-based form, an oligomer-based form, and a solid-based form.

Incidentally, the pressure-sensitive adhesive or adhesive may contain, in addition to a polymer component (base polymer) such as a pressure-sensitive adhesive component or adhesive component, appropriate additives such as a crosslinking agent (for example, a polyisocyanate-based crosslinking agent and an alkyl etherified melamine compound-based crosslinking agent), a tackifier (for example, a rosin derivative resin, a polyterpene resin, a petroleum resin, and a phenol resin), a plasticizer, a filler, and an antiaging agent, depending on the type of the pressure-sensitive adhesive or adhesive and the like. In the case of performing crosslinking in forming the pressure-sensitive adhesive layer or adhesive layer, a known crosslinking method such as a heat crosslinking method by heating, an ultraviolet ray crosslinking method by irradiation with ultraviolet rays (UV crosslinking method), an electron beam crosslinking method by irradiation with electron beams (EB crosslinking method), and a spontaneous curing method for achieving spontaneous curing at room temperature or the like can be applied.

In the invention, a pressure-sensitive adhesive layer is suitable as the pressure-sensitive adhesive or adhesive layer. As the pressure-sensitive adhesive which constitutes the pressure-sensitive adhesive layer, a rubber-based pressure-sensitive adhesive and an acrylic pressure-sensitive adhesive can be suitably used.

As a method for forming the pressure-sensitive adhesive or adhesive layer, a known method for forming a pressure-sensitive adhesive layer or a known method for forming an adhesive layer (for example, a coating forming method and a transfer forming method) can be employed. The forming method can be properly selected depending on the type, shape and size of the sheet-like electromagnetic shielding structure or the support on which the pressure-sensitive adhesive or adhesive layer is to be formed and the like. Specifically, for example, in the case where the pressure-sensitive adhesive layer is formed on a base material as described below, examples of the method for forming a pressure-sensitive adhesive layer include a method for coating a pressure-sensitive adhesive on the base material (coating method); and a method for coating a pressure-sensitive adhesive on a release film such as a release liner to form a pressure-sensitive adhesive layer and then transferring the pressure-sensitive adhesive layer onto the base material (transfer method). Furthermore, in the case where the pressure-sensitive adhesive layer is formed on the release liner as the support as described below, examples of the method for forming a pressure-sensitive adhesive layer include a method for coating a pressure-sensitive adhesive on the release surface of the release liner (coating method). In the case where an adhesive layer is formed on a base material as the support, examples of the method for forming an adhesive layer include a method for coating an adhesive on a prescribed surface of the base material (coating method).

On the other hand, a polymer component for constituting the polymer layer as the thin layer-like substrate is not particularly limited, but one kind or two or more kinds of a known polymer component (for example, a resin component (for example, a thermoplastic resin, a thermosetting resin, and an ultraviolet ray-curable resin), a rubber component, and an elastomer component) can be properly selected and used. Specifically, in the polymer component which constitutes the polymer layer, examples of the resin component include an acrylic resin, a styrene-based resin, a polyester-based resin, a polyolefin-based resin, a polyvinyl chloride resin, a vinyl acetate-based resin, a polyamide-based resin, a polyimide-based resin, a urethane-based resin, an epoxy-based resin, a fluorine-based resin, a silicone-based resin, polyvinyl alcohol, a polycarbonate, polyacetal, a polyetherimide, polyamide-imide, polyesterimide, polyphenylene ether, polyphenylene sulfide, polyethersulfone, polyetheretherketone, polyetherketone, a polyallylate, polyaryl, and polysulfone. Furthermore, examples of the rubber component include a natural rubber and a synthetic rubber (for example, polyisobutylene, polyisoprene, a chloroprene rubber, a butyl rubber, and a nitrile butyl rubber). Moreover, examples of the elastomer component include a variety of thermoplastic elastomers such as an olefin-based thermoplastic elastomer, a styrene-based thermoplastic elastomer, a polyester-based thermoplastic elastomer, a polyamide-based thermoplastic elastomer, a polyurethane-based thermoplastic elastomer, and an acrylic thermoplastic elastomer.

The thickness of the thin layer-like substrate (for example, the pressure-sensitive adhesive or adhesive layer and the polymer layer) is not particularly limited. For example, it can be selected within the range of from about 1 to 1000 $\mu$m (preferably from 10 to 500 $\mu$m).

Incidentally, a concave may be partially formed on the thin layer-like substrate (in particular, the pressure-sensitive adhesive layer). Although such a concave may be a depressed section, it is preferably a hole section (penetrating hole section). Of the hole section, a perforated section is especially suitable. In such a concave, it is possible to adapt the shape as the whole of the concave, the shape of an opening of the respective concaves in the surface of the thin layer-like substrate, the whole area of an opening of the respective concaves in the surface of the thin layer-like substrate, the area of an opening of the respective concaves in the surface of the thin layer-like substrate, and the like with the above-mentioned electromagnetic conducting or absorbing fiber convex structure section. Incidentally, in the case where the concave is a depressed section, its depth is not particularly limited but can be properly selected within the range of a depth corresponding to 1% or more (for example, from 1 to 99%, and preferably from 30 to 90%) of the thickness of the thin layer-like substrate.

Furthermore, the pressure-sensitive adhesive layer as the thin layer-like substrate can be formed on the release liner. In this case, a depressed section as the concave can be formed on at least one surface of the pressure-sensitive adhesive layer, and preferably on one surface of the pressure-sensitive adhesive layer. Moreover, the pressure-sensitive adhesive layer as the thin layer-like substrate can be formed on each of the both surfaces of the base material as the support. In this case, the concave (for example, a depressed section and a hole section) can be formed on at least one surface of the pressure-sensitive adhesive layer, and preferably on one surface of the pressure-sensitive adhesive layer. In the case where the concave is a hole section, examples of a method for forming a hole section include a perforating processing method using a known and/or usual hole section forming machine [above all, a perforation forming machine having a convex structure of a shape of every kind (protruded structure) and a concave structure counterpart to the convex structure], a perforation processing method by heat or beams (for example, a method for performing perforation by a thermal head, a halogen vapor lamp, a xenon lamp, a flash lamp, a laser beam, or the like.), and a molding method using a mold (for example, a mold having a convex). Incidentally, in the case where the concave is a depressed section, as a method for forming a depressed section, a forming method the same as the method for forming a hole section can be employed.

In the invention, it is preferable that the thin layer-like substrate (a pressure-sensitive adhesive or adhesive layer or a polymer layer) has electromagnetic conducting or absorbing properties from the viewpoints of further enhancing the electromagnetic conducting or absorbing properties of the sheet-like electromagnetic shielding structure. The thin layer-like substrate having the electromagnetic conducting or absorbing properties can be formed by an electromagnetic conducting or absorbing material-containing composition (a pressure-sensitive adhesive composition, an adhesive composition or a polymer composition). The electromagnetic conducting or absorbing material to be used for the thin layer-like substrate is not particularly limited. For example, one kind or two or more kinds of electromagnetic conducting or absorbing materials such as a metal material, an electromagnetic conducting or absorbing plastic material (for example, an electrically conductive plastic material), and a magnetic material can be used. Incidentally, examples of the metal material, the electromagnetic conducting or absorbing plastic material, and the magnetic material include a metal material, an electromagnetic conducting or absorbing plastic material, a magnetic material as enumerated above (for example, those metal materials, electromagnetic conducting or absorbing plastic materials, magnetic materials as enumerated previously in the above-mentioned electromagnetic conducting or absorbing fiber which constitutes the electromagnetic conducting or absorbing fiber convex structure section). The electromagnetic conducting or absorbing material such as a metal material, an electromagnetic conducting or absorbing plastic material, and a magnetic material may have any form such as a powdery form, a film-like form, a foil-like form, and a thin layer-like form.

The electromagnetic conducting or absorbing material-containing thin layer-like substrate (a pressure-sensitive adhesive composition, an adhesive composition or a polymer composition) can be prepared by mixing a pressure-sensitive adhesive which constitutes the pressure-sensitive adhesive layer, an adhesive which constitutes the pressure-sensitive adhesive layer, or a polymer component which constitutes the polymer layer, with an electromagnetic conducting or absorbing material. Incidentally, the content proportion of the electromagnetic conducting or absorbing material is not particularly limited but can be properly selected depending on the pressure-sensitive properties or adhesive properties of the pressure-sensitive adhesive or the adhesive, the electromagnetic conducting or absorbing properties of the pressure-sensitive adhesive or adhesive layer or the polymer layer, and the like. For example, it is preferable that the content proportion of the electromagnetic conducting or absorbing material is from 3 to 98% by weight (in particular, from 5 to 95% by weight) of the total amount of solids in the pressure-sensitive adhesive composition, the adhesive composition or the polymer composition. When the content proportion of the electromagnetic conducting or absorbing material is too small, the electromagnetic conducting or absorbing properties ofthe thin layer-like substrate is lowered. On the other hand, when the content proportion of the electromagnetic conducting or absorbing material is too large, in the case where the thin layer-like substrate is the pressure-sensitive adhesive or adhesive layer, the pressure-sensitive adhesive properties or adhesive properties is lowered.

Support

In the sheet-like electromagnetic shielding structure in accordance with the invention, the thin layer-like substrate (in particular, the pressure-sensitive adhesive or adhesive layer as the thin layer-like substrate) may be formed on at least one surface of a support. In the case where the thin layer-like substrate is formed on each of the both surfaces of the support, the electromagnetic conducting or absorbing fiber convex structure section may be formed on only the thin layer-like substrate which is formed on one surface of the support, or may be formed on the both thin layer-like substrates which are formed on each of the both surfaces of the support.

Such a support is not particularly limited but can be properly selected and used depending on the type of the sheet-like electromagnetic shielding structure or the like. The shape of the support may be in any shape. Examples of the shape include spherical, columnar, polygonal, polygonal conical, conical, plate-like, and sheet-like shapes. Moreover, the material of the support is not particularly limited, and any material is employable. Examples of the material include a plastic material, a metal material, a fiber material, and a paper material. Such a material may be used singly or in combination of two or more kinds thereof.

In the invention, it is preferable that the support has a sheet-like form. In the case where the support has a sheet-like form, it is possible to use the sheet-like electromagnetic shielding structure as a sheet-like structure having a sheet-like form. In the case where the thin layer-like substrate is a pressure-sensitive adhesive or adhesive layer, useful examples of the support having such a sheet-like form include a base material in a sheet-like form (for example, a base material for pressure-sensitive adhesive tape or sheet) and a release liner for pressure-sensitive adhesive tape or sheet. Specifically, for example, in the case where the sheet-like electromagnetic shielding structure is formed of a pressure-sensitive adhesive tape or sheet of a base material-provided type in which one or both surfaces thereof is a pressure-sensitive adhesive layer, a base material for pressure-sensitive adhesive tape or sheet can be used as the support. Furthermore, for example, in the case where the sheet-like electromagnetic shielding structure is formed of a double-sided pressure-sensitive adhesive tape or sheet of a base material-less type, a release liner (separator) for pressure-sensitive adhesive tape or sheet can be used as the support. Incidentally, in the case where the sheet-like electromagnetic shielding structure is formed of a pressure-sensitive adhesive tape or sheet of a base material-provided type in which one or both surfaces thereof is a pressure-sensitive adhesive layer, the sheet-like electromagnetic shielding structure may have a configuration in which not only the pressure-sensitive adhesive layer is formed on one or both surfaces of the base material (the base material for pressure-sensitive adhesive tape or sheet) as the support, but also the electromagnetic conducting or absorbing fiber convex structure section is formed on the surface of the pressure-sensitive adhesive layer formed on one or both surfaces of the base material or the wall surface of the concave. On the other hand, in the case where the sheet-like electromagnetic shielding structure is formed of a double-sided pressure-sensitive adhesive tape or sheet of a base material-less type, the sheet-like electromagnetic shielding structure may have a configuration in which not only the release liner (release liner for pressure-sensitive adhesive tape or sheet) serves as a support of the pressure-sensitive adhesive layer, but also the electromagnetic conducting or absorbing fiber convex structure section is formed on the surface of the pressure-sensitive adhesive layer or the wall surface of the concave. Incidentally, the release liner as the support not only supports the pressure-sensitive adhesive layer but also protects the surface of the pressure-sensitive adhesive layer until the sheet-like electromagnetic shielding structure is used.

Base material

As described above, a base material in a sheet-like form can be suitably used as the base material which is the support as described above. As such a base material in a sheet-like form, a base material for pressure-sensitive adhesive tape or sheet (base material) is suitably used. As the base material, an appropriate thin sheet body such as a plastic base material (for example, a plastic film or sheet); a metallic base material (for example, a metal foil and a metal plate); a paper-based base material (for example, paper (for example, wood-free paper, Japanese paper, kraft paper, glassine paper, synthetic paper, and topcoat paper)); a fibrous base material (for example, a cloth, a non-woven fabric, and a net); a rubber-based base material (for example, a rubber sheet); and a foamed body (for example, a foamed sheet) can be used. The base material may have any form of a single-layered form or a laminated form. For example, the base material may be a multilayered body (two-layered or three-layered composite body) of a plastic base material and other base material (for example, a metallic base material, a paper-based base material, and a fibrous base material) by lamination, co-extrusion or the like. Incidentally, when a foamed body is used as the base material, it is possible to enhance follow-up properties against an irregular section on the surface of an adherend.

The base material is preferably a plastic base material such as a plastic film or sheet. Examples of a raw material (plastic material) of such a plastic base material include an olefin-based resin composed of an $\alpha$-olefin as a monomer component (for example, polyethylene (PE), polypropylene (PP), an ethylene-propylene copolymer, and an ethylene-vinyl acetate copolymer (EVA)); a polyester-based resin (for example, polyethylene terephthalate (PET), polyethylene naphthalate (PEN), and polybutylene terephthalate (PBT)); polyvinyl chloride (PVC); a vinyl acetate-based resin; polyphenylene sulfide (PPS); an amide-based resin (for example, a polyamide (nylon) and a wholly aromatic polyamide (aramid); a polyimide-based resin; and polyetheretherketone (PEEK). Furthermore, in the base material, the plastic material of the plastic base material may be an electromagnetic conducting or absorbing plastic material (for example, an electrically conductive plastic material). Examples of the electrically conductive plastic material include an electrically conductive polymer as enumerated previously in the electromagnetic conductive or absorbing fiber or the like. The plastic material may be used singly or in a mixed state of a combination of two or more kinds thereof. Incidentally, the plastic film or sheet may be of a non-stretched type or a stretched type having been subjected to a uniaxial or biaxial stretching treatment.

Furthermore, examples of the metal material for forming the metallic base material (for example, a metal foil and a metal plate) include a metal material as enumerated previously in the electromagnetic conducting or absorbing fiber or the like. The metal material can be used singly or in combination of two or more kinds thereof.

In the invention, for the purpose of further enhancing the electromagnetic conducting or absorbing properties of the sheet-like electromagnetic shielding structure, a base material having a characteristic of conducting or absorbing electromagnetic waves (the base material being hereinafter referred to as "electromagnetic conducting or absorbing base material") can be suitably used as the base material. The electromagnetic conducting or absorbing base material is not particularly limited so far as it can exhibit the electromagnetic conducting or absorbing properties. Examples of the electromagnetic conducting or absorbing base material include a base material formed of an electromagnetic conducting or absorbing material, a base material containing an electromagnetic conducting or absorbing material on the surface or inside thereof, an the like.

In the electromagnetic conducting or absorbing base material, the base material formed of the electromagnetic conducting or absorbing material is not particularly limited. For example, one kind or two or more kinds of electromagnetic conducting or absorbing materials such as a metal material, an electromagnetic conducting or absorbing plastic material (for example, an electrically conductive plastic material), and a magnetic material can be used. Incidentally, examples of the metal material, the electromagnetic conducting or absorbing plastic material, and the magnetic material include a metal material, an electromagnetic conducting or absorbing plastic material, and a magnetic material as enumerated in the above-mentioned electromagnetic conducting or absorbing fiber which constitutes the electromagnetic conducting or absorbing fiber convex structure section or in the above-mentioned electromagnetic conducting or absorbing material which is to be contained in the pressure-sensitive adhesive composition or the adhesive composition.

Furthermore, the base material containing an electro-magnetic conducting or absorbing material on the surface or inside thereof is not particularly limited so far as it is a base material of every kind in which an electromagnetic conducting or absorbing material is used on the surface or inside thereof. Examples of the base material containing an electromagnetic conducting or absorbing material on the surface thereof include a base material having a layer made of an electromagnetic conducting or absorbing material-containing composition which contains an electromagnetic conducting or absorbing material (the layer being hereinafter sometimes referred to as "electromagnetic conducting or absorbing material-containing layer") on the surface thereof. In the base material having an electromagnetic conducting or absorbing material-containing layer on the surface thereof, it is only required that the electromagnetic conducting or absorbing material-containing layer is formed on at least one surface of the base material. Furthermore, the thickness of the electromagnetic conducting or absorbing material-containing layer is not particularly limited. For example, it can be properly selected within the range of 0.1 μm or more (for example, from 0.1 μm to 1 mm). The electromagnetic conducting or absorbing material-containing layer may be a layer having a thin thickness (for example, a thin film layer having a thickness of from about 0.1 to 30 μm). Accordingly, the base material having an electromagnetic conducting or absorbing material-containing layer on the surface thereof may be a base material having a configuration in which an electromagnetic conducting or absorbing material-containing layer having a thin thickness is formed on a base material not having the electromagnetic conducting or absorbing properties (the base material being hereinafter sometimes referred to as "non-electromagnetic conducting or absorbing base material"), or may be a base material having a configuration in which a non-electromagnetic conducting or absorbing base material and an electromagnetic conducting or absorbing material-containing layer are laminated with each other.

In an electromagnetic conducting or absorbing material-containing composition for forming such an electromagnetic conducting or absorbing material-containing layer, the electromagnetic conducting or absorbing material may be contained as the major component or mixing component (subcomponent). The electromagnetic conducting or absorbing material is not particularly limited. Useful examples thereof include a metal material, an electromagnetic conducting or absorbing plastic material (for example, an electrically conducting plastic material), and a magnetic material. Accordingly, the electromagnetic conducting or absorbing material-containing layer may be a metal material layer (for example, a metal foil and a metal plate), an electromagnetic conducting or absorbing plastic material layer (for example, an electromagnetic conducting or absorbing plastic material-made film or sheet), or a magnetic material layer. Incidentally, examples of the metal material for forming the electromagnetic conducting or absorbing material-containing layer include a metal material as enumerated above in the electromagnetic conducting or absorbing fiber which constitutes the electromagnetic conducting or absorbing fiber convex structure section, or the like. Furthermore, examples of the electromagnetic conducting or absorbing plastic material include an electromagnetic conducting or absorbing plastic material as enumerated above in the electromagnetic conducting or absorbing fiber which constitutes the electromagnetic conducting or absorbing fiber convex structure section, or the like. Moreover, examples of the magnetic material include a magnetic material as enumerated above in the electromagnetic conducting or absorbing fiber which constitutes the electromagnetic conducting or absorbing fiber convex structure section, or the like. The electromagnetic conducting or absorbing material can be used singly or in combination of two or more kinds thereof. Incidentally, the electromagnetic conducting or absorbing material such as a metal material, an electromagnetic conducting or absorbing plastic material, and a magnetic may have any form such as a powdery form, a film-like form, a foil-like form, and a thin layer-like form.

Furthermore, the non-electromagnetic conducting or absorbing base material to be coated or laminated by the electromagnetic conducting or absorbing material is not particularly limited so far as it is a base material not having the electromagnetic conducting or absorbing properties. Useful examples thereof include a plastic base material not having the electromagnetic conducting or absorbing properties (for example, a plastic base material composed of, as a raw material, a resin not having the electromagnetic conducting or absorbing properties (for example, a polyolefin-based resin, a polyester-based resin, polyvinyl chloride, a vinyl acetate-based resin, polyphenylene sulfide, an amide-based resin, a polyimide-based resin, and polyetheretherketone)); a paper-based base material not having the electromagnetic conducting or absorbing properties (for example, wood-free paper, Japanese paper, kraft paper, glassine paper, synthetic paper, and topcoat paper); and a fibrous base material not having the electromagnetic conducting or absorbing properties (for example, a cloth or non-woven fabric not having the electromagnetic conducting or absorbing properties). Incidentally, the non-electromagnetic conducting or absorbing base material may have any form of a single-layered form or a laminated form.

Incidentally, in the base material having an electro-magnetic conducting or absorbing material-containing layer on the surface thereof, a method for forming an electromagnetic conducting or absorbing material-containing material on the surface of the base material is not particularly limited but can be properly selected and applied from a known method (for example, a metal vapor deposition method, a metal plating method, a lamination method by adhesion, an impregnation method, and a painting method), depending on the type of the electromagnetic conducting or absorbing material, the thickness of the electromagnetic conducting or absorbing material-containing layer, and the like. For example, in the case where the electromagnetic conducting or absorbing material is a metal material and the electromagnetic conducting or absorbing material-containing layer is an electromagnetic conducting or absorbing material-containing layer having a thin thickness, the electromagnetic conducting or absorbing material-containing layer can be formed on the surface of the base material by applying a coating method by vapor deposition of a metal material, a coating method by plating of a metal material or the like. Accordingly, the base material having an electromagnetic conducting or absorbing material-containing layer on the surface thereof may be a plastic film or sheet having a metal material vapor deposited on the surface thereof (a metal vapor deposited plastic film or sheet) or a plastic film or sheet having a metal material plated on the surface thereof (a metal plated plastic film or sheet).

On the other hand, examples of the base material containing an electromagnetic conducting or absorbing material in the inside thereof include a base material which is formed of an electromagnetic conducting or absorbing material-containing composition containing an electromagnetic conducting or absorbing material. Such a base material may be a base material in which an electromagnetic conducting or absorbing material is formed as a major material of the base material (the base material being hereinafter sometimes referred to as "electromagnetic conductive or absorbing material-based base material") or a base material formed of a mixed material containing a major material of the base material and an electromagnetic conducting or absorbing material (the base material being hereinafter sometimes referred to as "electromagnetic conducting or absorbing material-containing base material"). Examples of the electromagnetic conducting or absorbing material-based base material include a metallic base material (for example, a metal foil and a metal plate); an electromagnetic conducting or absorbing plastic base material (for example, a film or sheet formed of an electromagnetic conducting or absorbing plastic material); a fibrous base material having electromagnetic conducting or absorbing properties (electromagnetic conducting or absorbing fibrous base material) (for example, a woven fabric (for example, a cloth) or non-woven fabric formed of a fiber having electromagnetic conducting or absorbing properties); and a magnetic material-based base material (for example, a magnetic material plate). Examples of a metal material for forming the metallic base material include a metal material as enumerated above in the electromagnetic conducting or absorbing fiber which constitutes the electromagnetic conducting or absorbing fiber convex structure section, or the like. Furthermore, examples of an electromagnetic conducting or absorbing plastic material for forming the electromagnetic conducting or absorbing plastic base material include an electromagnetic conducting or absorbing plastic material as enumerated above in the electromagnetic conducting or absorbing fiber which constitutes the electromagnetic conducting or absorbing fiber convex structure section, or the like. Moreover, useful examples of a fiber in the electromagnetic conducting or absorbing fibrous base material include an electromagnetic conducting or absorbing fiber (for example, a carbon-based fiber, a fiber made of an electrically conductive polymer, and a metallic fiber) as enumerated above in the electromagnetic conducting or absorbing fiber which constitutes the electromagnetic conducting or absorbing fiber convex structure section, or the like. In addition, examples of a magnetic material in the magnetic material-based base material include a magnetic material as enumerated above in the electromagnetic conducting or absorbing fiber which constitutes the electromagnetic conducting or absorbing fiber convex structure section, or the like.

Furthermore, in the electromagnetic conducting or absorbing material-containing base material, examples of the major material of the base material include a material not having the electromagnetic conducting or absorbing properties (the material being hereinafter sometimes referred to as "non-electromagnetic conducting or absorbing material") such as a plastic material not having the electromagnetic conducting or absorbing properties (for example, a resin not having the electromagnetic conducting or absorbing properties (for example, a polyolefin-based resin, a polyester-based resin, polyvinyl chloride, a vinyl acetate-based resin, polyphenylene sulfide, an amide-based resin, a polyimide-based resin, and polyetheretherketone)); a paper material not having the electromagnetic conducting or absorbing properties (for example, a paper material for forming a paper-based base material not having the electromagnetic conducting or absorbing properties (for example, wood-free paper, Japanese paper, kraft paper, glassine paper, synthetic paper, and topcoat paper)); and a fiber material not having the electromagnetic conducting or absorbing properties (for example, a fiber material for forming a fibrous base material not having the electromagnetic conducting or absorbing properties (for example, a cloth or non-woven fabric not having the electromagnetic conducting or absorbing properties)). The non-electromagnetic conducting or absorbing material can be used singly or in combination of two or more kinds thereof. Examples of the electromagnetic conducting or absorbing material in the electromagnetic conducting or absorbing material-containing base material include a metal material as enumerated above in the electromagnetic conducting or absorbing fiber which constitutes the electromagnetic conducting or absorbing fiber convex structure section, or the like, an electromagnetic conducting or absorbing plastic material as enumerated above in the electromagnetic conducting or absorbing fiber which constitutes the electromagnetic conducting or absorbing fiber convex structure section, or the like, and a magnetic material as enumerated above in the electromagnetic conducting or absorbing fiber which constitutes the electromagnetic conducting or absorbing fiber convex structure section, or the like.

Incidentally, in the electromagnetic conducting or absorbing material-containing base material, in the case where the major material of the base material is a fiber material not having the electromagnetic conducting or absorbing properties, the electromagnetic conducting or absorbing material may be in a form that it is impregnated in the fiber or in a form that it is mixed in the fiber material which constitutes the fiber.

In the base material containing an electromagnetic conducting or absorbing material in the inside thereof, a method for containing the electromagnetic conducting or absorbing material in the inside of the base material is not particularly limited. For example, in the case where the base material containing an electromagnetic conducting or absorbing material in the inside thereof is an electromagnetic conducting or absorbing material-based base material, it is possible to form the electromagnetic conducting or absorbing material-based base material by applying a known method for forming a metal foil, a known method for forming a plastic film or sheet, a known method forming a fiber or the like depending on the type of the electromagnetic conducting or absorbing material-based base material or the like. Furthermore, in the case where the base material containing an electromagnetic conducting or absorbing material in the inside thereof is an electromagnetic conducting or absorbing material-containing base material, for example, after mixing the major material of the base material with the electromagnetic conducting or absorbing material, the electromagnetic conducting or absorbing material-containing base material can be formed by applying a known method for forming a metal foil, a known method for forming a plastic film or sheet or the like depending on the types of the major material of the base material and the electromagnetic conducting or absorbing material, or the like.

Incidentally, if desired, the electromagnetic conducting or absorbing base material may be blended with a variety of additives such as an inorganic filler (for example, titanium oxide and zinc oxide), an antiaging agent (for example, an amine-based antiaging agent, a quinoline-based antiaging agent, a hydroquinone-based antiaging agent, a phenol-based antiaging agent, a phosphorus-based antiaging agent, and a phosphorous acid ester-based antiaging agent), an antioxidant, an ultraviolet absorber (for example, a salicylic acid derivative, a benzophenone-based ultraviolet absorber, a benzotriazole-based ultraviolet absorber, and a hindered amine-based ultraviolet absorber), a lubricant, a plasticizer, and a coloring agent (for example, a pigment and a dye). Furthermore, as described above, the electromagnetic conducting or absorbing material may be blended into the base material.

For the purpose of improving adhesion to the pressure-sensitive adhesive or adhesive layer or the like, one or both surfaces of the electromagnetic conducting or absorbing base material may be subjected to an appropriate surface treatment such as a physical treatment (for example, a corona treatment and a plasma treatment) and a chemical treatment (for example, an undercoating treatment).

The thickness of the base material is not particularly limited. For example, the thickness can be selected within the range of from about 10 $\mu$m to 20 mm, and preferably from about 30 $\mu$m to 12 mm.

Release Liner

Examples of a release liner (for example, the release liner for pressure-sensitive adhesive tape or sheet) as the support include a base material having a release treated layer by means of a release treating agent formed on at least one surface thereof, a known base material having low-adhesive properties, and the like. As the release liner, for example, a release liner having a release treated layer formed on at least one surface of a base material for release liner is suitable. Examples of the base material for release liner include a plastic base material film (synthetic resin film) of every kind, paper, and a multilayered body (two-layered or three-layered composite body) by laminating or co-extruding these base materials. For example, the release treated layer can be formed by using a release treating agent (for example, a silicone-based release treating agent, a fluorine-based release treating agent, and a long-chain alkyl-based release treating agent) singly or in combination of two or more kinds thereof. The release treated layer can be formed by coating a release treating agent on a prescribed surface (at least one surface) of a base material for release liner and then performing a heating step for drying, a curing reaction, or the like.

Incidentally, the thickness of the release liner, the thickness of the base material for release liner, the thickness of the release treated layer, and the like are not particularly limited but can be properly selected depending on the shape of the electromagnetic conducting or absorbing fiber convex structure section, or the like.

Coating Layer

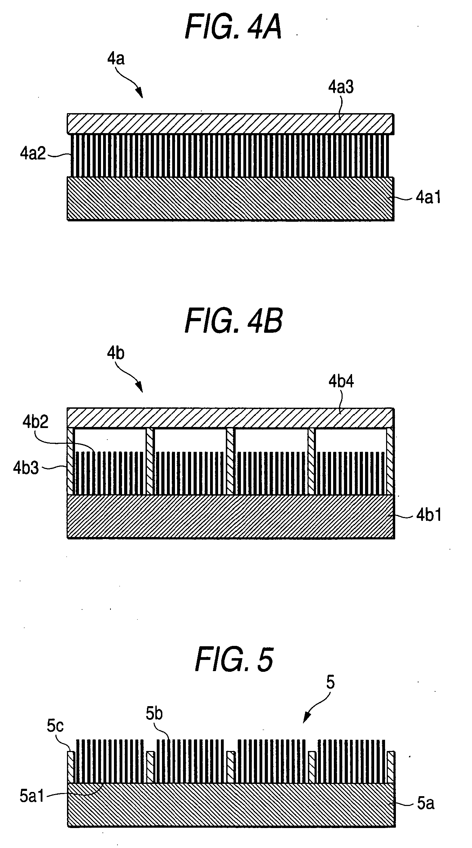

In the invention, a coating layer for coating the electromagnetic conducting or absorbing fiber convex structure section may be formed as shown in Figs. 4A and 4B. The coating layer is a layer which coats the electromagnetic conducting or absorbing fiber convex structure section. By the coating layer, it is possible to suppress or prevent the fiber which constitutes the electromagnetic conducting or absorbing fiber convex structure section from coming out from the substrate, and it is possible to effectively enhance retention of the fiber of the electro-magnetic conducting or absorbing fiber convex structure section. In addition, by the coating layer, it is possible to enhance characteristics such as impact resistance. Such a coating layer is only required to be a layer which coats at least a part or an upper side of the fiber in the electromagnetic conducting or absorbing fiber convex structure section. In particular, it is preferable that the coating layer is a layer which coats an upper side of the fiber in the electromagnetic conducting or absorbing fiber convex structure section. The coating layer may be formed in a form that it makes contact with the electromagnetic conducting or absorbing fiber convex structure section or in a form that it does not make contact with the electromagnetic conducting or absorbing fiber convex structure section. In the case where the coating layer is formed in a form that it does not make contact with the electromagnetic conducting or absorbing fiber convex structure section, for example, as shown in Fig. 4B, the coating layer may have a configuration in which it is formed on a fiber protection member having a thickness greater than that of a portion of the electromagnetic conducting or absorbing fiber convex structure section, in which the portion is positioned outward from the surface of the thin layer-like substrate.

Figs. 4A and 4B each is an outline cross-sectional view showing an example of the sheet-like electromagnetic shielding structure in accordance with the invention. In Figs. 4A and 4B, 4a stands for a sheet-like electromagnetic shielding structure; 4a1 stands for a thin layer-like substrate; 4a2 stands for an electromagnetic conducting or absorbing fiber convex structure; 4a3 stands for a coating layer; 4b stands for a sheet-like electromagnetic shielding structure; 4b 1 stands for a thin layer-like substrate; 4b2 stands for an electromagnetic conducting or absorbing fiber convex structure; 4b3 stands for a coating layer; and 4b4 stands for a fiber protection member, respectively. The sheet-like electromagnetic shielding structure 4a as shown in Fig. 4A has a configuration in which the electromagnetic conducting or absorbing fiber convex structure 4a2 is formed entirely on the surface of the thin layer-like substrate 4a1, and the coating layer 4a3 is formed on the electromagnetic conducting or absorbing fiber convex structure 4a2, whereby the upper side of the fiber in the electromagnetic conducting or absorbing fiber convex structure 4a2 is coated with the coating layer 4a3. Moreover, the sheet-like electromagnetic shielding structure 4b as shown in Fig. 4B has a configuration in which the electromagnetic conducting or absorbing fiber convex structure 4b2 and the fiber protection member 4b4 are formed in a prescribed site of the thin layer-like substrate 4b1, and the coating layer 4b3 is formed on the fiber protection member 4b4, whereby the upper side of the fiber in the electromagnetic conducting or absorbing fiber convex structure 4b2 is coated with the coating layer 4b3. As the fiber protection member, those materials as enumerated in Fiber Protection Member section as described below are usable.

The coating material which constitutes the coating layer is not particularly limited. Examples thereof include a coating material composition containing, as the major component, a known polymer component (for example, a resin component (for example, a thermoplastic resin, a thermosetting resin, and an ultraviolet ray-curable resin), a rubber component, and an elastomer component). Specifically, in the coating material composition which constitutes the coating layer, the polymer component can be properly selected and used among a polymer component the same as the polymer component as enumerated previously in the thin layer-like substrate (for example, a resin component (for example, a thermoplastic resin, a thermosetting resin, and an ultraviolet ray-curable resin), a rubber component, and an elastomer component).

The coating layer may have any form of a single-layered form or a laminated form.

In the invention, it is preferable that the coating layer has electromagnetic conducting or absorbing properties.

When the coating layer also has the electromagnetic conducting or absorbing properties, it is possible to much more enhance the electromagnetic conducting or absorbing properties of the sheet-like electromagnetic shielding structure. The coating layer having electromagnetic conducting or absorbing properties can be formed of a coating material composition containing an electromagnetic conducting or absorbing material. The electromagnetic conducting or absorbing material which is used in the coating material is not particularly limited. For example, an electromagnetic conducting or absorbing material such as a metal material, an electromagnetic conducting or absorbing plastic material (for example, an electrically conductive plastic material), and a magnetic material can be used singly or in combination of two or more kinds thereof. Incidentally, examples of the metal material, the electromagnetic conducting or absorbing plastic material, and the magnetic material include a metal material, an electromagnetic conducting or absorbing plastic material, and a magnetic material as enumerated above (for example, a metal material, an electromagnetic conducting or absorbing plastic material, and a magnetic material as enumerated above in the electromagnetic conducting or absorbing fiber which constitutes the electromagnetic conducting or absorbing fiber convex structure section, the pressure-sensitive adhesive composition or adhesive composition which constitutes the pressure-sensitive adhesive or adhesive layer, and the composition which constitutes the substrate).

The coating material composition containing an electromagnetic conducting or absorbing material can be prepared by mixing a coating material and an electromagnetic conducting or absorbing material. Incidentally, in the coating material composition, the content proportion of the electromagnetic conducting or absorbing material is not particularly limited but can be properly selected depending on the type of a polymer component of the coating material, the electromagnetic conducting or absorbing properties of the coating layer, and the like. For example, it is preferable that the content proportion of the electromagnetic conducting or absorbing material is from 3 to 98% by weight (in particular, from 5 to 95 % by weight) of the total amount of solids in the coating material composition. When the content proportion of the electromagnetic conducting or absorbing material is too small, the electromagnetic conducting or absorbing properties of the coating layer is lowered, while when it is too large, the formation of the coating layer becomes difficult.

Incidentally, since the coating layer is a layer for coating the electromagnetic conducting or absorbing fiber convex structure section, it is important that in forming the coating layer, the electromagnetic conducting or absorbing fiber convex structure section be preformed on the thin layer-like substrate. Accordingly, after forming the electromagnetic conducting or absorbing fiber convex structure section on the thin layer-like substrate, the coating layer can be formed.

As a method for forming the coating layer, a known forming method (for example, a coating forming method, a dip forming method, and a spray forming method) can be employed. The forming method can be properly selected depending on the form of the coating layer, the type and form of the electromagnetic conducting or absorbing fiber convex structure section. Specifically, by coating the coating material composition on the electromagnetic conducting or absorbing fiber convex structure section formed in the thin layer-like substrate (or on the electromagnetic conducting or absorbing fiber convex structure section and the fiber protection member) in a form that at least a part of the fiber is positioned outward from the surface of the thin layer-like substrate, the coating layer can be formed.

The thickness of the coating layer is not particularly limited but can be properly set up depending on the type and form of the coating layer and the length of the fiber which is exposed in the electromagnetic conducting or absorbing fiber convex structure section. For example, the thickness of the coating layer can be selected within the range of from 10 to 5000 $\mu$m (preferably from 30 to 3000 $\mu$m, and more preferably from 30 to 2000 $\mu$m).

In the invention, the coating layer may be a layer formed of a pressure-sensitive adhesive tape or sheet. Specifically, the coating layer may be formed by pressure-sensitively attaching a pressure-sensitive adhesive tape or sheet onto the electromagnetic conducting or absorbing fiber convex structure section. As a pressure-sensitive adhesive tape or sheet for forming the coating layer may be a pressure-sensitive adhesive tape or sheet composed of only a pressure-sensitive adhesive layer (a pressure-sensitive adhesive tape or sheet of a base material-less type), or may be a pressure-sensitive adhesive tape or sheet in which one or both surfaces thereof is a pressure-sensitive adhesive layer (a pressure-sensitive adhesive tape or sheet of a base material-provided type). In this way, the coating layer may be a layer composed of only a pressure-sensitive adhesive layer or a layer composed of a laminated body including a pressure-sensitive layer and a base material. The coating layer formed of a pressure-sensitive tape or sheet may be formed not only by coating a coating material composition, but also by pressure-sensitively attaching a pressure-sensitive adhesive tape or sheet onto an electromagnetic conducting or absorbing fiber convex structure section.

In the case where the coating layer is formed of a pressure-sensitive adhesive tape or sheet of a base material-less type or a pressure-sensitive adhesive tape or sheet of a base material-provided type, a pressure-sensitive adhesive layer in the pressure-sensitive adhesive tape or sheet of each type may be only one of a pressure-sensitive adhesive layer not having the electromagnetic conducting or absorbing properties (non-electromagnetic conducting or absorbing pressure-sensitive adhesive layer) and a pressure-sensitive adhesive layer having the electromagnetic conducting or absorbing properties (electromagnetic conducting or absorbing pressure-sensitive adhesive layer). In such a coating layer, examples of a pressure-sensitive adhesive composition for constituting the non-electromagnetic conducting or absorbing pressure-sensitive adhesive layer in the pressure-sensitive adhesive tape or sheet of each type include those pressure-sensitive adhesive compositions as enumerated above in the above-mentioned pressure-sensitive adhesive or adhesive layer as the thin layer-like substrate. On the other hand, examples of a pressure-sensitive adhesive composition for constituting the electromagnetic conducting or absorbing pressure-sensitive adhesive layer in the pressure-sensitive adhesive tape or sheet of each type include those pressure-sensitive adhesive compositions containing an electromagnetic conducting or absorbing material as enumerated above, as a pressure-sensitive adhesive composition for constituting a pressure-sensitive adhesive or adhesive layer having the electromagnetic conducting or absorbing properties, in the above-mentioned pressure-sensitive adhesive or adhesive layer as the thin layer-like substrate.

In the case where the coating layer is formed of a pressure-sensitive adhesive tape or sheet of a base material-provided type, a base material in the pressure-sensitive adhesive tape or sheet may be a base material not having the electromagnetic conducting or absorbing properties (non-electromagnetic conducting or absorbing base material) or a base material having the electromagnetic conducting or absorbing properties (electromagnetic conducting or absorbing base material). In such a coating layer, examples of the non-electromagnetic conducting or absorbing base material in the pressure-sensitive adhesive tape or sheet of a base material-provided type include a plastic base material having the non-electromagnetic conducting or absorbing properties, a paper-based base material having the non-electromagnetic conducting or absorbing properties, a fibrous base material having the non-electromagnetic conducting or absorbing properties, and the like. Specific examples thereof includes those plastic base materials, paper- based base materials, and fibrous base materials as enumerated above in the above-mentioned base material as the support in the structure, and the like. On the other hand, examples of the electromagnetic conducting or absorbing base material in the pressure-sensitive adhesive tape or sheet of a base material-provided type include those base materials as enumerated above in the above-mentioned base material as the support in the structure (for example, a base material composed of an electromagnetic conducting or absorbing material, a base material containing an electromagnetic conducting or absorbing material on the surface or inside thereof.

Specifically, useful examples of the pressure-sensitive adhesive tape or sheet for forming the coating layer include a pressure-sensitive adhesive tape or sheet not having a base material, a pressure-sensitive adhesive tape or sheet having a base material composed of a plastic film or sheet (for example, a polyester film or sheet or the like), a pressure-sensitive adhesive tape or sheet having a base material composed of a non-woven fabric, a pressure-sensitive adhesive tape or sheet having a base material composed of a metal foil (for example, an aluminum foil or the like). Among these pressure-sensitive adhesive tapes or sheets, as the pressure-sensitive adhesive for constituting the pressure-sensitive adhesive layer, an acrylic pressure-sensitive adhesive and a rubber-based pressure-sensitive adhesive are suitable, and they may contain an electromagnetic conducting or absorbing material.

A method for forming the pressure-sensitive adhesive tape or sheet for forming the coating layer can be properly selected from a known method for forming a pressure-sensitive adhesive tape or sheet. Since the thickness of the pressure-sensitive adhesive tape or sheet corresponds to the thickness of the coating layer, it is important to adjust the thickness of the pressure-sensitive adhesive layer or the base material in the pressure-sensitive adhesive tape or sheet so as to be the thickness of the coating layer as enumerated previously. Incidentally, in the pressure-sensitive adhesive tape or sheet for forming the coating layer, the pressure-sensitive adhesive layer or the base material may have any form of a single-layered form or a laminated form. In the case where the coating layer is formed of a pressure-sensitive adhesive tape or sheet having a configuration in which a pressure-sensitive adhesive layer is formed on the both surfaces of a base material, the pressure-sensitive adhesive layers formed on the both surfaces of the base material may be the same pressure-sensitive adhesive layer, or may be different from each other.

Fiber Protection Member

In the case where a sheet-like electromagnetic shielding structure in accordance with the invention has a configuration in which an electromagnetic conducting or absorbing fiber convex structure section is formed partially on a thin layer-like substrate, as shown in Fig. 5, a fiber protection member, which is capable of suppressing or preventing the electromagnetic conducting or absorbing fiber convex structure section from being fallen down, may be formed at least partially on a portion of the surface of the thin layer-like substrate, on which the electromagnetic conducting or absorbing fiber convex structure section is not formed. Specifically, the sheet-like electromagnetic shielding structure may have a configuration in which an electromagnetic conducting or absorbing fiber convex structure section is formed partially on the thin layer-like substrate in such a form that at least a part of a fiber thereof is positioned outward from the surface of the thin layer-like substrate, and a fiber protection member capable of suppressing or preventing the electromagnetic conducting or absorbing fiber convex structure section from being fallen down may be formed at least partially on a portion of the surface of the thin layer-like substrate, on which the electromagnetic conducting or absorbing fiber convex structure section is not formed. In this way, the sheet-like electromagnetic shielding structure in accordance with the invention has a configuration in which the electromagnetic conducting or absorbing fiber convex structure section is formed partially on the thin layer-like substrate in such a form that at least a part of a fiber thereof is positioned outward (in the external side) from the surface of the thin layer-like substrate, and a fiber protection member capable of suppressing or preventing the electromagnetic conducting or absorbing fiber convex structure section from being fallen down is provided at least partially (entirely or partially) on the surface of the thin layer-like substrate, on which the electromagnetic conducting or absorbing fiber convex structure section is not formed. Accordingly, even when various types of external pressure such as rolling pressure at the time of producing the sheet-like electromagnetic shielding structure, pressing or winding pressure at the time of using sheet-like electromagnetic shielding structure are applied thereto, the electromagnetic conducting or absorbing fiber convex structure section is suppressed or prevented from being fallen down, thereby enabling to maintain the electromagnetic conducting or absorbing properties at an excellent level in an effective manner.

Fig. 5 is an outline cross-sectional view partially showing an example of the sheet-like electromagnetic shielding structure in accordance with the invention. In Fig. 5, 5 stands for a sheet-like electromagnetic shielding structure; 5a stands for a thin layer-like substrate; 5a1 stands for the surface of the thin layer-like substrate 5a; 5b stands for an electromagnetic conducting or absorbing fiber convex structure section; and 5c stands for a fiber protection member. The sheet-like electromagnetic shielding structure 5 as shown in Fig. 5 has a configuration in which the electromagnetic conducting or absorbing fiber convex structure section 5b is formed partially on the surface 5a 1 of the thin layer-like substrate 5a, and the fiber protection member 5c is provided on a portion of the surface 5a1 of the thin layer-like substrate 5a, on which the electromagnetic conducting or absorbing fiber convex structure section 5b is not formed.

With regard to such a fiber protection member, it is preferable that the fiber protection member is provided entirely on the surface of the thin layer-like substrate, on which the electromagnetic conducting or absorbing fiber convex structure section is not formed. A form in which the fiber protection member is provided on the surface of the thin layer-like substrate is not particularly limited so far as it is possible to attach the fiber protection member onto the surface of the thin layer-like substrate in a state that the fiber protection member is not easily peeled away, but it is preferable that the fiber protection member is provided in a form that the fiber protection member is pressure-sensitively attached onto the surface of the thin layer-like substrate. For example, in the case where the thin layer-like substrate is a pressure-sensitive adhesive layer or an adhesive layer (a pressure-sensitive adhesive or adhesive layer) as described above, it is possible to form the fiber protection member that is pressure-sensitively attached onto the surface of the thin layer-like substrate by pressure-sensitively attaching the fiber protection member onto the surface of the pressure-sensitive adhesive or adhesive layer as the thin layer-like substrate. On the other hand, in the case where the thin layer-like substrate is not the pressure-sensitive adhesive or adhesive layer, it is possible to form the fiber protection member that is pressure-sensitively attached onto the surface of the thin layer-like substrate by using a known fixing means (for example, a method for pressure-sensitively attaching the fiber protection member onto the thin layer-like substrate using a pressure-sensitive adhesive or an adhesive, a method in which a pressure-sensitive adhesive layer or an adhesive layer is formed on one surface of the fiber protection member, thereby pressure-sensitively attaching the fiber protection member onto the thin layer-like substrate using the pressure-sensitive adhesive layer or the adhesive layer formed on the one surface of the fiber protection member, or the like).

As a member for the fiber protection member, it is not particularly limited so far as the member is able to suppress or prevent the electromagnetic conducting or absorbing fiber convex structure section from being fallen down. For example, in the case where the electromagnetic conducting or absorbing fiber convex structure section has a configuration in which each electromagnetic conducting or absorbing fiber convex structure section is formed on the thin layer-like substrate in an independent form (i.e., a configuration in which each electromagnetic conducting or absorbing fiber convex structure section is formed in an island shape as in a so-called "see-island structure"), the fiber protection member is only required to be configured by using a singular or plural member capable of covering a site on the surface of the thin layer-like substrate, on which the electromagnetic conducting or absorbing fiber convex structure section is not formed. It is preferable that fiber protection member is configured by a member having at least a penetrating hole section in a site on the thin layer-like substrate corresponding to the electromagnetic conducting or absorbing fiber convex structure section formed on the thin layer-like substrate. In this way, by using a member having a penetrating hole section as the fiber protection member, it is possible to provide the fiber protection member in a site on the surface of the thin layer-like substrate on which the electromagnetic conducting or absorbing fiber convex structure section is not formed. Accordingly, the sheet-like electromagnetic shielding structure in accordance with the invention has electromagnetic conducting or absorbing properties by the fact that the electromagnetic conducting or absorbing fiber convex structure section is formed partially in the thin layer-like substrate in a form that at least a part of a fiber thereof is positioned outward from the surface of the thin layer-like substrate, and may have a configuration in which a fiber protection member configured by a member having a penetrating hole section is provided on the surface of the thin layer-like substrate, and the electromagnetic conducting or absorbing fiber convex structure section is formed in a site on the thin layer-like substrate corresponding to the penetrating hole section of the fiber protection member in a form that at least a part of a fiber thereof is positioned outward from the surface of the thin layer-like substrate.

A fiber protection member configured by a member having a penetrating hole section may be configured by a single member having plural penetrating hole sections or by plural members each having a singular or plural penetrating hole section, depending on the shape of the electromagnetic conducting or absorbing fiber convex structure section formed on the thin layer-like substrate.

In the member having a penetrating hole section, the shape of the penetrating hole section is not particularly limited so far as it is possible to position the electromagnetic conducting or absorbing fiber convex, structure section within the penetrating hole section, but a shape corresponding to the shape of the electromagnetic conducting or absorbing fiber convex structure section is preferable. Specifically, as the shape of the penetrating hole section, the penetrating hole section may have any shape depending on the shape of the electromagnetic conducting or absorbing fiber convex structure section, and examples of the shape include a fixed shape such as a substantially circular shape or a substantially polygonal shape, or various non-fixed shapes. Incidentally, in the case of the member having plural penetrating hole sections, an alignment state of the plural penetrating hole sections is not particularly limited, and the plural penetrating hole sections may be aligned in any one of a regularly aligned state and an irregularly aligned state.

Accordingly, in the member having a penetrating hole section as the fiber protection member, the diameter (an average diameter, a minimum diameter or a maximum diameter) or shape of the penetrating hole section, or the width (an average width, a minimum width or a maximum width) between penetrating hole sections is not particularly limited and can be properly selected depending on the shape of the electromagnetic conducting or absorbing fiber convex structure section formed on the substrate. Accordingly, the penetrating hole section may be formed in a regular or irregular manner.

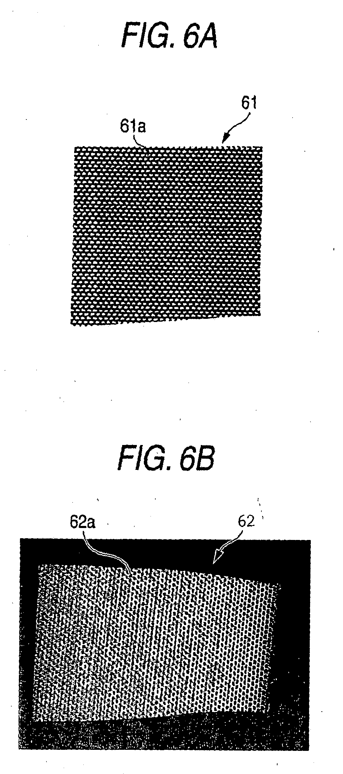

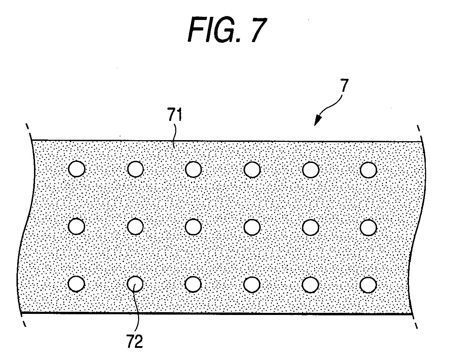

In the invention, the member having a penetrating hole section is not particularly limited so far as the member has a penetrating hole section. For example, a member formed in a net shape and having plural penetrating hole sections as shown in Figs. 6A and 6B (the member being hereinafter sometimes referred to as "net-like member") or a sheet-like member having plural penetrating hole sections formed by perforation as shown in Fig. 7 (the sheet-like member being hereinafter sometimes referred to as "perforated sheet member") can be suitably used. That is, it is preferable that the fiber protection member is configured by the net-like member or the perforated sheet member.

Figs. 6A and 6B each is an outline view partially showing an example of a fiber protection member used in the sheet-like electromagnetic shielding structure in accordance with the invention. In Figs. 6A and 6B, 61 and 62 each stands for a net-like member; 61a stands for a penetrating hole section in the net-like member 61; and 62a stands for a penetrating hole section in the net-like member 62. The net-like members 61 and 62 each includes plural penetrating hole sections 61a and 62a formed in a net shape, In this way, the net-like member may have plural penetrating hole sections formed regularly or irregularly in a fixed or non-fixed shape.

Fig. 7 is an outline view partially showing an example of a fiber protection member used in the sheet-like electromagnetic shielding structure in accordance with the invention. In Fig. 7, 7 stands for a perforated sheet member; 71 stands for a sheet-like base material; and 72 stands for a penetrating hole section formed by perforation (perforated section). The perforated sheet member 7 includes, as the penetrating hole section formed by perforation, plural perforated sections 72 at a prescribed site of the sheet-like base material 71. In this way, similar to the case of the net-like member, the perforated sheet member may have plural penetrating hole sections formed regularly or irregularly in a fixed or non-fixed shape.

In particular, since the perforated sheet member is formed by perforation using a perforator, it is possible to easily control the shape, size or formation site of the penetrating hole section (perforated section) in the perforated sheet member. That is, in the perforated sheet member, the degree of freedom in designing the penetrating hole section to be formed is high. Incidentally, in pressure-sensitively or adhesively attaching the perforated sheet member onto the thin layer-like substrate such as a pressure-sensitive adhesive or adhesive layer, it is possible to secure an attachment area in an easier manner than that for the case of the net-like member, and it is thus advantageous. In this way, in the case of the perforated sheet member, by adjusting the size of formation site of the penetrating hole section at the time of perforation, it is possible to easily prepare the perforated sheet member formed in a form that the penetrating hole section is aligned in a prescribed pattern shape.

Since such a perforated sheet member is formed by perforation, a thick portion that is elevated toward only one surface thereof is formed on the peripheral portion of the perforated section, and the perforated sheet member is used in a form that the thick portion at the elevated side is positioned at an outer side. For this reason, in the invention, in the case where the member having the penetrating hole section is the perforated sheet member, the thickness (a maximum thickness) at the thick portion of the peripheral portion of the perforated section is adopted as the thickness of the perforated sheet member. On the other hand, in the case where the member having the penetrating hole section is the net-like member or the perforated sheet member not having the thick portion at the peripheral portion of the perforated section, the thickness of the peripheral portion of the penetrating hole section is adopted as the thickness of the member having the penetrating hole section. In this case, the adopted thickness is corresponding to the average thickness of the member having the penetrating hole section.

In the member having the penetrating hole section such as the net-like member or the perforated sheet member, a void ratio thereof is not particularly limited, but can be properly selected depending on the size of the electromagnetic conducting or absorbing fiber convex structure sections formed in the thin layer-like substrate. For example, the void ratio can be properly selected from a range greater than 0%. The void ratio in the member having the penetrating hole section can be properly selected depending on the purpose of use of the sheet-like electromagnetic shielding structure or the size of the surface area at one surface of the sheet-like electromagnetic shielding structure.

The void ratio in the member having the penetrating hole section is a value measured by "void ratio measuring method" to be described later.

Void Ratio Measuring Method

After coloring the member having the penetrating hole section with appropriate colors if desired, the colored member having the penetrating hole section is placed on a sheet colored with a color different from that of the colored member (for example, in the case where the member having the penetrating hole section has a white color system such as a white color or a milky white color, the member with the penetrating hole section is placed on a black sheet, or in the case where the member having the penetrating hole section has any color, the member with the penetrating hole section is colored with a black color and then placed on a white sheet) and then is scanned with a scanner, and image data of the member having the penetrating hole section is read (input) into a computer. Then, on the computer, using, as an image processing related software, a trade name "PHOTOSHOP ELEMENTS 2.0" (marketed from Adobe Systems Incorporated.; Digital Image Editing Software), an image processing or editing for removing unnecessary portions is performed (specifically, for example, in the case where the member having the penetrating hole section has a black color or is colored with a black color, an image processing or editing for removing unnecessary color portions is performed so that the portion of the member having the penetrating hole section becomes a black color portion and the portion of the penetrating hole section becomes a white color portion). In this way, after performing the image processing or editing so that there remain only two colors, i.e., a color corresponding the portion of the member having the penetrating hole section and a color corresponding to the portion of the penetrating hole section, using, as an image processing related software, a trade name "MATROX INSPECTOR 2.1" (marketed from MATROX Corporation and sold by Canon System Solutions Inc.; Image Processing Algorithm Verification Tool), a binarization operation is performed to calculate a ratio of each color per unit area (10 mm × 10 mm) (in this case, an average ratio of ratios of each color measured at different three locations is calculated), thereby obtaining a ratio of the penetrating hole section in the member having the penetrating hole section. Specifically, in the case where the member having the penetrating hole section having or colored with a black color is placed on a white sheet, a ratio between a white color and a black color is obtained. In this case, the ratio of a black color (i.e., black ratio) corresponds to the ratio of the member having the penetrating hole section, and the ratio of a white color (i.e., white ratio) corresponds to the ratio (i.e., a void ratio of the member having the penetrating hole section) of the penetrating hole section in the member having the penetrating hole section.

In the image data of the member having the penetrating hole section scanned by the scanner and input to the computer, in the case where even when the member having the penetrating hole section is not colored, the portion of the member having the penetrating hole section and the portion of the penetrating hole section are clearly differentiable on a screen on which the portions are displayed on the basis of an output from the computer, it may be possible to perform an image processing or editing so as to make colors of the portion of the member having the penetrating hole section and the portion of the penetrating hole section to be different from each other, by using a trade name "PHOTOSHOP ELEMENTS 2.0" (marketed from Adobe Systems Incorporated.; Digital Image Editing Software), so that there remain only two colors, i.e., a color corresponding the portion of the member having the penetrating hole section and a color corresponding to the portion of the penetrating hole section. Thereafter, in a similar manner to those described above, using a trade name "MATROX INSPECTOR 2.1" (marketed from MATROX Corporation and sold by Canon System Solutions Inc.; Image Processing Algorithm Verification Tool), a binarization operation is performed to calculate a ratio of each color per unit area (10 mm × 10 mm) (in this case, an average ratio of ratios of each color measured at different three locations is calculated), thereby obtaining a ratio of the penetrating hole section in the member having the penetrating hole section.

Incidentally, a raw material for the fiber protection member is not particularly limited, and examples thereof include a plastic material, a fiber material, a paper material, and a metal material. Incidentally, for example, useful examples of the plastic material include an olefin-based resin such as polyethylene (low-density polyethylene, linear low-density polyethylene, medium-density polyethylene, high-density polyethylene, or the like), polypropylene, poly-1-butane, poly-4-methy-1-pentane, ethylene-propylene copolymer, ethylene-1-butane copolymer, ethylene-vinyl acetate copolymer, ethylene-acrylate ester-based copolymer (ethylene-ethyl acrylate copolymer, ethylene-methyl methacrylate copolymer, or the like), or ethylene-vinyl alcohol copolymer; a polyester-based resin such as polyethylene terephthalate, polybutylene terephthalate, polyethylene naphthalate, or polybutylene naphthalate; polyacrylate; a styrene-based resin such as polystyrene, styrene-isoprene copolymer, styrene-butadiene copolymer, styrene-isoprene-styrene copolymer, styrene-butadiene-styrene copolymer, or acrylonitrile-butadien-styrene copolymer; a polyamide-based resin such as polyamide-6, or polyamide-6,6; polyvinyl chloride; polyvinlylidene chloride; and polycarbonate.

Incidentally, examples of the fiber material include a cotton fiber, a rayon fiber, a polyamide-based fiber, a polyester-based fiber, a polyacrylonitrile-based fiber, an acrylic fiber, a polyvinyl alcohol fiber, a polyethylene-based fiber, a polypropylene-based fiber, a polyimide-based fiber, a silicone-based fiber, and a fluorine-based resin fiber.

Incidentally, examples of the paper material include Japanese paper, foreign paper, wood-free paper, glassine paper, kraft paper, clupak paper, creped paper, clay-coated paper, topcoat paper, synthetic paper, plastic laminated paper, and plastic-coated paper. Incidentally, examples of the metal material include an aluminum material and a copper material.

In the invention, a plastic material, a fiber material or a paper material is preferable as a raw material for the fiber protection member, and a plastic material is especially suitable. The raw material for the fiber protection member may be used singly or in combination of two or more kinds thereof.

As the fiber protection member, one that is light in weight and excellent in bendability can be suitably used. From the viewpoint of lightness and bendability, a thin sheet-like member (in particular, sheet-like member) can be suitably used as the fiber protection member. Incidentally, a plastic material is preferable as the raw material for the fiber protection member. Among the plastic material, an olefin resin (in particular, an ethylene-based and/or propylene-based resin including at least an ethylene monomer (for example, polyethylene, polypropylene, and an ethylene-propylene copolymer) and/or a propylene monomer) and a polyester-based resin (in particular, polyethylene terephthalate) are especially suitable.

Although the thickness (height) of the fiber protection member is not particularly limited, it is important to have a thickness in which it is possible to suppress or prevent the electromagnetic conducting or absorbing fiber convex structure section from being fallen down. The thickness is properly selected depending on the thickness (height) of the electromagnetic conducting or absorbing fiber convex structure section. Specifically, for example, the thickness (or height) of the fiber protection member may be a thickness (or height) corresponding to a proportion of from 10 to 250% of the thickness (or height) of the portion in the electromagnetic conducting or absorbing fiber convex structure section that is positioned outward from the surface of the thin layer-like substrate (in this case, the proportion is preferably from 20 to 200%; more preferably from 80 to 150%; and especially preferably from 90 to 120%). When the thickness proportion of the fiber protection member is less than 10% with respect to the thickness of the portion in the electromagnetic conducting or absorbing fiber convex structure section that is positioned outward from the surface of the thin layer-like substrate, the effect of suppressing or preventing the electromagnetic conducting or absorbing fiber convex structure section from being fallen down is lowered. On the other hand, when the thickness proportion of the fiber protection member is greater than 250%, the thickness of the fiber protection member becomes too thick, and it is thus economically disadvantageous. Moreover, the bendability, flexibility or lightness of the sheet-like electromagnetic shielding structure may be lowered.

A production method of the fiber protection member is not particularly limited. For example, in the case where the fiber protection member is a member having a penetrating hole section (in particular, a net-like member or a perforated sheet member), useful example of the production method thereof include a method of producing a member having a penetrating hole section by forming the penetrating hole section onto a member not having the penetrating hole section by perforation processing or the like, and a method of producing a member having a penetrating hole section by using a material having a penetrating hole section formed thereon as a material for the member. Specifically, for example, in the case where the fiber protection member is a member having a penetrating hole section (in particular, a net-like member or a perforated sheet member) and formed of a plastic material, a member formed of a plastic material and having a penetrating hole section (in particular, a net-like member or a perforated sheet member formed of a plastic material) can be produced by using, for example, a method of forming the penetrating hole section on a prescribed site of a member not having the penetrating hole section by perforation processing or the like, or a method of performing a gravure printing in a form that a penetrating hole section is formed on the plastic material by thermofusion (for example, a method of using a roll having convex and concave portions).

From the viewpoint of exterior appearance of the sheet-like electromagnetic shielding structure, the fiber protection member may be colored with the same color as that of the fiber of the electromagnetic conducting or absorbing fiber convex structure section. Incidentally, the fiber protection member may have electromagnetic conducting or absorbing properties from the viewpoint of enhancing the electromagnetic conducting or absorbing properties of the sheet-like electromagnetic shielding structure. Furthermore, the surface of the fiber protection member (in particular, an outer surface thereof in the case where the fiber protection member is provided on the surface of the thin layer-like substrate) may be formed of a release surface (for example, the surface of a release treated layer) with respect to a pressure-sensitive adhesive layer or an adhesive layer.

Superposed Structure

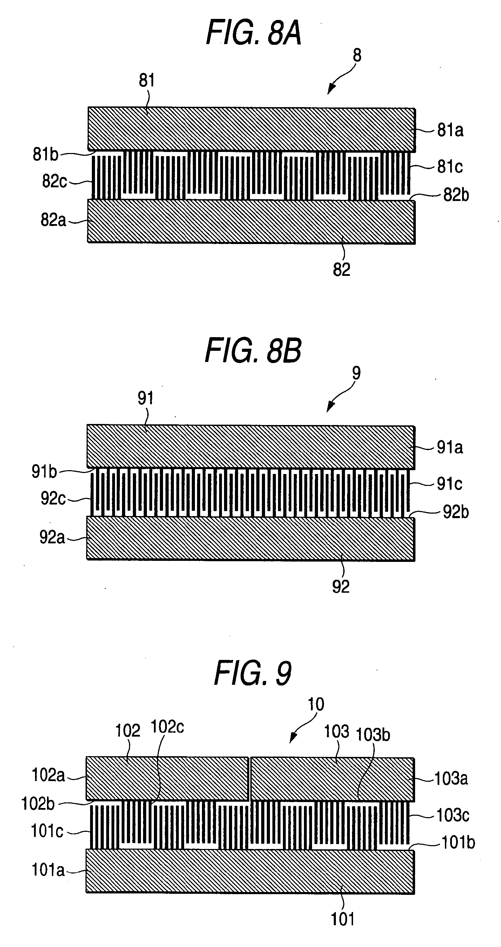

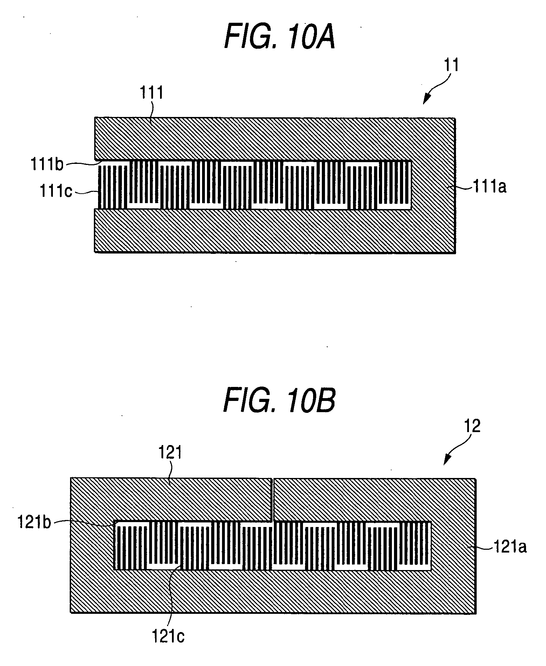

As shown in Figs. 8A to 10B, a sheet-like electromagnetic shielding structure in accordance with the invention may have a configuration in which the surfaces thereof on each of which the fiber convex structure sections having a characteristic of conducting or absorbing electromagnetic waves is formed are superposed with each other in an opposed state. In this way, even when the electromagnetic conducting or absorbing fiber convex structure section is provided in the sheet-like electromagnetic shielding structure, so far as the surfaces thereof each having formed thereon the electromagnetic conducting or absorbing fiber convex structure section are superposed with each other in such a form that the surfaces face each other, the fibers in the electromagnetic conducting or absorbing fiber convex structure section are effectively maintained on the thin layer-like substrate, whereby it is possible to effectively suppress or prevent the fibers from coming out from the thin layer-like substrate. Incidentally, in the sheet-like electromagnetic shielding structure, when those surfaces each having formed thereon the electromagnetic conducting or absorbing fiber convex structure section are superposed with each other in such a form that the surfaces face each other, by superposing the fibers in the electromagnetic conducting or absorbing fiber convex structure section in a form that they are intricately interwinded to each other, it is possible to suppress or prevent the fibers in the electromagnetic conducting or absorbing fiber convex structure section from being fallen down.

Figs. 8A and 10B each is an outline cross-sectional view partially showing an example of the sheet-like electromagnetic shielding structure in accordance with the invention. In Fig. 8A, 8 stands for a sheet-like electromagnetic shielding structure; 81 stands for a structure member; 81a stands for a thin layer-like substrate; 81b stands for the surface of the thin layer-like substrate 81a; 81c stands for an electromagnetic conducting,or absorbing fiber convex structure section; 82 stands for a structure member; 82a stands for a thin layer-like substrate; 82b stands for the surface of the thin layer-like substrate 82a; and 82c stands for an electromagnetic conducting or absorbing fiber convex structure section. The sheet-like electromagnetic shielding structure 8 as shown in Fig. 8A has a configuration in which the structure member 81, which is configured such that the electromagnetic conducting or absorbing fiber convex structure section 81c is formed partially on the surface 81b of the thin layer-like substrate 81a, is superposed onto a structure member 82, which is configured such that the electromagnetic conducting or absorbing fiber convex structure section 82c is formed partially on the surface 82b of the thin layer-like substrate 82a, whereby the structure member 81 and the structure member 82 are superposed with each other in such a form that the surfaces 81b and 82b each having formed thereon the electromagnetic conducting or absorbing fiber convex structure section faces with each other. As is clear from Fig. 8A, the electromagnetic conducting or absorbing fiber convex structure section 81c is formed in a form that at least a part of a fiber thereof is positioned outward from the surface 81b of the thin layer-like substrate 81a, and the electromagnetic conducting or absorbing fiber convex structure section 82c is formed in a form that at least a part of a fiber thereof is positioned outward from the surface 82b of the thin layer-like substrate 82a

In Fig. 8B, 9 stands for a sheet-like electromagnetic shielding structure; 91 stands for a structure member; 91a stands for a thin layer-like substrate; 91b stands for the surface of the thin layer-like substrate 91a; 91c stands for an electromagnetic conducting or absorbing fiber convex structure section; 92 stands for a structure member; 92a stands for a thin layer-like substrate; 92b stands for the surface of the thin layer-like substrate 92a; and 92c stands for an electromagnetic conducting or absorbing fiber convex structure section. The sheet-like electromagnetic shielding structure 9 as shown in Fig. 8B has a configuration in which the structure member 91, which is configured such that the electromagnetic conducting or absorbing fiber convex structure section 91c is formed entirely on the surface 91b of the thin layer-like substrate 91a, is laminated onto a structure member 92, which is configured such that the electromagnetic conducting or absorbing fiber convex structure section 92c is formed entirely on the surface 92b of the thin layer-like substrate 92a, whereby the structure member 91 and the structure member 92 are superposed with each other in such a form that the surfaces 91b and 92b each having formed thereon the electromagnetic conducting or absorbing fiber convex structure section faces with each other. As is clear from Fig. 8B, the electromagnetic conducting or absorbing fiber convex structure section 91c is formed in a form that at least a part of a fiber thereof is positioned outward from the surface 91b of the thin layer-like substrate 91a, and the electromagnetic conducting or absorbing fiber convex structure section 92c is formed in a form that at least a part of a fiber thereof is positioned outward from the surface 92b of the thin layer-like substrate 92a.

In Fig. 9, 10 stands for a sheet-like electromagnetic shielding structure; 101 stands for a structure member; 101a stands for a thin layer-like substrate; 101b stands for the surface ofthe thin layer-like substrate 101a; 101c stands for an electromagnetic conducting or absorbing fiber convex structure section; 102 stands for a structure member; 102a stands for a thin layer-like substrate; 102b stands for the surface of the thin layer-like substrate 102a; 102c stands for an electromagnetic conducting or absorbing fiber convex structure section; 103 stands for a structure member; 103a stands for a thin layer-like substrate; 103b stands for the surface of the thin layer-like substrate 103a; and 103c stands for an electromagnetic conducting or absorbing fiber convex structure section. The sheet-like electromagnetic shielding structure 10 as shown in Fig. 9 has a configuration in which the structure member 102, which is configured such that the electromagnetic conducting or absorbing fiber convex structure section 102c is formed partially on the surface 102b of the thin layer-like substrate 102a, is laminated onto one end portion on the structure member 101, which is configured such that the electromagnetic conducting or absorbing fiber convex structure section 101c is formed partially on the surface 101b of the thin layer-like substrate 101a, whereby the structure member 101 and the structure member 102 are superposed with each other in such a form that the surfaces 101b and 102b each having formed thereon the electromagnetic conducting or absorbing fiber convex structure section faces with each other; and the structure member 103, which is configured such that the electromagnetic conducting or absorbing fiber convex structure section 103c is formed partially on the surface 103b of the thin layer-like substrate 103a, is laminated onto the other end portion on the structure member 101, whereby the structure member 101 and the structure member 103 are superposed with each other in a form that the surfaces 101b and 103b each having formed thereon the electromagnetic conducting or absorbing fiber convex structure section faces with each other. As is clear from Fig. 9, the electromagnetic conducting or absorbing fiber convex structure section 101c is formed in a form that at least a part of a fiber thereof is positioned outward from the surface 101b of the thin layer-like substrate 101a; the electromagnetic conducting or absorbing fiber convex structure section 102c is formed in a form that at least a part of a fiber thereof is positioned outward from the surface 102b of the thin layer-like substrate 102a; and the electromagnetic conducting or absorbing fiber convex structure section 103c is formed in a form that at least a part of a fiber thereof is positioned outward from the surface 103b of the thin layer-like substrate 103a.

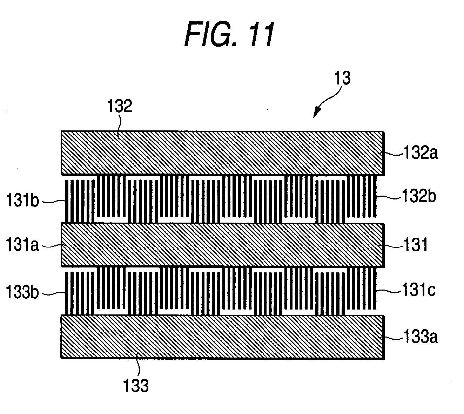

In Fig. 10A, 11 stands for a sheet-like electromagnetic shielding structure; 111 stands for a structure member; 111a stands for a thin layer-like substrate; 111b stands for the surface of the thin layer-like substrate 111a; and 111c stands for an electromagnetic conducting or absorbing fiber convex structure section. The sheet-like electromagnetic shielding structure 11 as shown in Fig. 10A has a configuration in which the structure member 111, which is configured such that the electromagnetic conducting or absorbing fiber convex structure section 111c is formed partially on the surface 111b of the thin layer-like substrate 111a, is bent parallel in the longitudinal direction so that one end thereof is positioned on the other end thereof at the central portion in the lateral direction, whereby the structure member 111 is superposed thereon in such a form that the surfaces 111b each having formed thereon the electromagnetic conducting or absorbing fiber convex structure section faces with each other. As is clear from Fig. 10A, the electromagnetic conducting or absorbing fiber convex structure section 111c is formed in a form that at least a part of a fiber thereof is positioned outward from the surface 111b of the thin layer-like substrate 111a.

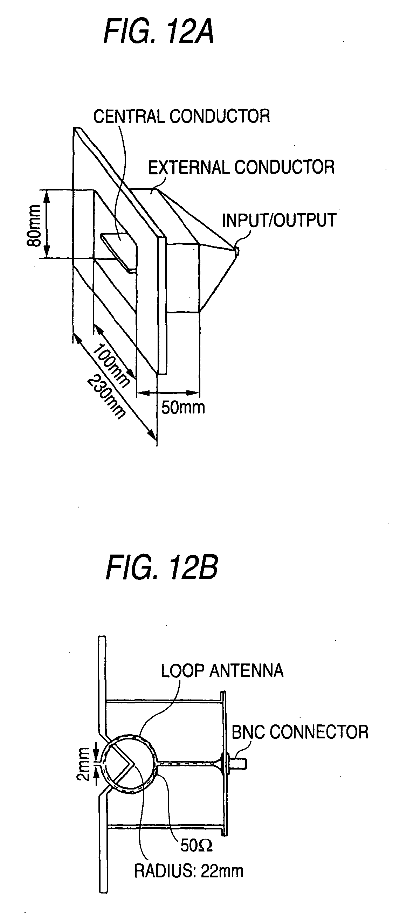

In Fig. 10B, 12 stands for a sheet-like electromagnetic shielding structure; 121 stands for a structure member; 121a stands for a thin layer-like substrate; 121b stands for the surface of the thin layer-like substrate 121a; and 121c stands for an electromagnetic conducting or absorbing fiber convex structure section. The sheet-like electromagnetic shielding structure 12 as shown in Fig. 10B has a configuration in which the structure member 121, which is configured such that the electromagnetic conducting or absorbing fiber convex structure section 121c is formed partially on the surface 121b of the thin layer-like substrate 121a, is bent parallel in the longitudinal direction so that both ends thereof are positioned on respective central portions between both ends thereof and the central portion thereof in the lateral direction, whereby the structure member 121 is superposed thereon in such a form that the surfaces 121b each having formed thereon the electromagnetic conducting or absorbing fiber convex structure section faces with each other. As is clear from Fig. 10B, the electromagnetic conducting or absorbing fiber convex structure section 121c is formed in a form that at least a part of a fiber thereof is positioned outward from the surface 121b of the thin layer-like substrate 121a.

The structure members for forming the sheet-like electromagnetic shielding structures as shown in Figs. 8A to 10B are formed into a sheet shape. In particular, in the sheet-like electromagnetic shielding structures as shown in Figs. 10A and 10B, since the structure members thereof are bent, it is important that the structure member thereof has bendability.

Incidentally, the sheet-like electromagnetic shielding structures shown in Figs. 8A to 9 are configured by laminating a plurality of structure members with each other and the sheet-like electromagnetic shielding structures shown in Figs. 10A and 10B are configured by bending a single structure member itself. As a matter of course, the sheet-like electromagnetic shielding structure in accordance with the invention may be configured by a combination of bending of at least any one structure member and lamination of a plurality of structure members.

Incidentally, in the case where a structure member in which electromagnetic conducting or absorbing fiber convex structure sections are formed on both surfaces of a thin layer-like substrate is used as a structure member, as shown in Fig. 11, for example, a sheet-like electromagnetic shielding structure may be formed by laminating a plurality of structure members in such a form that those surfaces each having formed thereon the electromagnetic conducting or absorbing fiber convex structure section faces with each other by using, as a structure member becoming the outermost layer thereof, a structure member in which the electromagnetic conducting or absorbing fiber convex structure section is formed on one surface of the thin layer-like substrate.

Fig. 11 is an outline cross-sectional view partially showing an example of the sheet-like electromagnetic shielding structure in accordance with the invention. In Fig. 11, 13 stands for a sheet-like electromagnetic shielding structure; 131 stands for a structure member; 131a stands for a thin layer-like substrate; 131b stands for an electromagnetic conducting or absorbing fiber convex structure section; 131c stands for an electromagnetic conducting or absorbing fiber convex structure section; 132 stands for a structure member; 132a stands for a thin layer-like substrate; 132b stands for an electromagnetic conducting or absorbing fiber convex structure section; 133 stands for a structure member; 133a stands for a thin layer-like substrate; and 133b stands for an electromagnetic conducting or absorbing fiber convex structure section. In Fig. 11, the structure member 131 has a configuration in which the electromagnetic conducting or absorbing fiber convex structure sections 131b and 131c are formed partially on each surface of the thin layer-like substrate 131a; the structure member 132 has a configuration in which the electromagnetic conducting or absorbing fiber convex structure section 132b is formed partially on one surface of the thin layer-like substrate 132a; and the structure member 133 has a configuration in which the electromagnetic conducting or absorbing fiber convex structure section 133b is formed partially on one surface of the thin layer-like substrate 133a. The sheet-like electromagnetic shielding structure 13 as shown in Fig. 11 has a configuration in which the structure member 131 and the structure member 132 are superposed with each other in such a form that the surface of the structure member 131 having formed thereon the electromagnetic conducting or absorbing fiber convex structure section 131b faces the surface of the structure member 132 having formed thereon the electromagnetic conducting or absorbing fiber convex structure section 132b; and the structure member 131 and the structure member 133 are superposed with each other in such a form that the surface of the structure member 131 having formed thereon the electromagnetic conducting or absorbing fiber convex structure section 131c faces the surface of the structure member 133 having formed thereon the electromagnetic conducting or absorbing fiber convex structure section 133b. As is clear from Fig. 11, in the structure members 131 to 133, the electromagnetic conducting or absorbing fiber convex structure sections 131b, 131c, 132b and 133b each is formed in a form that at least a part of a fiber thereof is positioned outward from the surface of the thin layer-like substrate.

Although Fig. 11 shows the case of using a single structure member in which electromagnetic conducting or absorbing fiber convex structure sections are formed on both surfaces of the thin layer-like substrate, the invention may be applied to a case where a structure member in which electromagnetic conducting or absorbing fiber convex structure sections are formed on both surfaces of a thin layer-like substrate is used as a structure member. In this case, similar to the case of Fig. 11, the sheet-like electromagnetic shielding structure in accordance with the invention may be produced by laminating a plurality of structure members in such a form that those surfaces each having formed thereon the electromagnetic conducting or absorbing fiber convex structure section faces with each other by using, as a structure member becoming the outermost layer thereof, a structure member in which the electromagnetic conducting or absorbing fiber convex structure section is formed on one surface of the thin layer-like substrate.

In the sheet-like electromagnetic shielding structure in accordance with the invention, in the case where those surfaces each having formed thereon the electromagnetic conducting or absorbing fiber convex structure section are superposed with each other in such a form that the surfaces face each other, it is preferable to form the electromagnetic conducting or absorbing fiber convex structure section on each surface thereof by superposing fibers in the electromagnetic conducting or absorbing fiber convex structure section formed on the both surfaces with each other while preventing from being fallen down so that electromagnetic conducting or absorbing properties are exhibited in an effective manner. Specifically, in the case of using a structure member having a configuration in which an electromagnetic conducting or absorbing fiber convex structure section is formed partially on a thin layer-like substrate, it is preferable that the electromagnetic conducting or absorbing fiber convex structure section is formed partially on those surfaces of singular or plural structure members which face with each other when they are superposed with each other in such a form that it is possible to superpose a portion of one surface thereof having formed thereon the electromagnetic conducting or absorbing fiber convex structure section onto a portion of the other surface thereof having not formed thereon the electromagnetic conducting or absorbing fiber convex structure section so that each portion faces with each other.

In the case of using a structure member having a configuration in which an electromagnetic conducting or absorbing fiber convex structure section is formed partially on a thin layer-like substrate, for example, by superposing a member having a hole section onto the surface of the thin layer-like substrate thus forming the electromagnetic conducting or absorbing fiber convex structure section on a portion of the surface of the thin layer-like substrate corresponding to the hole section of the member having the hole section, it is possible to form the electromagnetic conducting or absorbing fiber convex structure section partially on a prescribed portion of the thin layer-like substrate in such a form that it is possible to superpose a portion of one surface thereof having formed thereon the electromagnetic conducting or absorbing fiber convex structure section with a portion of the other surface thereof having not formed thereon the electromagnetic conducting or absorbing fiber convex structure section so that each portion faces with each other.

Incidentally, for example, in the case of using a structure member having a configuration in which an electromagnetic conducting or absorbing fiber convex structure section is formed entirely on a thin layer-like substrate, it is preferable that the electromagnetic conducting or absorbing fiber convex structure section is formed entirely on those surfaces of singular or plural structure members which face with each other when they are superposed with each other in such a form that it is possible to superpose fibers of the electromagnetic conducting or absorbing fiber convex structure section on one surface thereof onto fibers of the electromagnetic conducting or absorbing fiber convex structure section on the other surface thereof so that the fibers on one surface thereof is positioned between the fibers on the other surface thereof.

In the case of using a structure member having a configuration in which an electromagnetic conducting or absorbing fiber convex structure section is formed entirely on a thin layer-like substrate, for example, by controlling (adjusting) the density of the electromagnetic conducting or absorbing fiber convex structure sections on the surface of the thin layer-like substrate or the density of fibers in the electromagnetic conducting or absorbing fiber convex structure section, it is possible to form the electromagnetic conducting or absorbing fiber convex structure section entirely on the thin layer-like substrate in such a form that it is possible to superpose fibers of the electromagnetic conducting or absorbing fiber convex structure section on one surface thereof onto fibers of the electromagnetic conducting or absorbing fiber convex structure section on the other surface thereof so that the fibers on one surface thereof is positioned between the fibers on the other surface thereof.

In this way, in the invention, it is possible to produce a sheet-like electromagnetic shielding structure having a configuration in which those surfaces each having formed thereon the electromagnetic conducting or absorbing fiber convex structure section are superposed with each other in such a form that the surfaces face each other, by bending or laminating singular or plural structure members formed at least partially (entirely or partially) on the thin layer-like substrate in such a form that at least a part of fiber thereof is positioned outward (in the external side) from the surface of the thin layer-like substrate.

In such a sheet-like electromagnetic shielding structure having a configuration in which those surfaces each having formed thereon the electromagnetic conducting or absorbing fiber convex structure section are superposed with each other in such a form that the surfaces face each other, the structure member has a configuration in which a fiber convex structure section having a characteristic of conducting or absorbing electromagnetic waves is formed at least partially on the thin layer-like substrate in such a form that at least a part of fiber thereof is positioned outward from the surface of the thin layer-like substrate, in the same manner to the case of a sheet-like electromagnetic shielding structure not having a configuration in which those surfaces each having formed thereon the electromagnetic conducting or absorbing fiber convex structure section are superposed with each other in such a form that the surfaces face each other. That is, the sheet-like electromagnetic shielding structure having a configuration in which those surfaces each having formed thereon the electromagnetic conducting or absorbing fiber convex structure section are superposed with each other in such a form that the surfaces face each other is produced by superposing those surfaces each having formed thereon singular or plural sheet-like electromagnetic shielding structures with each other in such a form that the surfaces face each other by bending or laminating the sheet-like electromagnetic shielding structures not having a configuration in which those surfaces each having formed thereon the electromagnetic conducting or absorbing fiber convex structure section are superposed with each other in such a form that the surfaces face each other.

Sheet-like Electromagnetic Shielding Structure

As described above, in a sheet-like electromagnetic shielding structure in accordance with the invention, it is important that the sheet-like electromagnetic shielding structure has a configuration in which an electromagnetic conducting or absorbing fiber convex structure section is formed at least partially on a thin layer-like substrate in such a form that at least a part of fiber thereof is positioned outward from the surface of the thin layer-like substrate. So long as the sheet-like electromagnetic shielding structure has such a configuration, an appropriate layer may be formed on an appropriate portion thereof so far as it does not greatly harm the effect or operation of the invention. Specifically, the sheet-like electromagnetic shielding structure in accordance with the invention may have any one of the following configurations (A) to (F).

Configuration (A): A configuration in which a pressure-sensitive adhesive layer or an adhesive layer (pressure-sensitive adhesive or adhesive layer) as a thin layer-like substrate is formed on at least one surface (one surface or both surfaces) of a base material as a support for supporting the thin layer-like substrate, and an electromagnetic conducting or absorbing fiber convex structure section is formed at least partially on the pressure-sensitive adhesive or adhesive layer on at least one surface (one surface or both surfaces) of the base material in such a form that at least a part of fiber thereof is positioned outward from the surface of the pressure-sensitive adhesive or adhesive layer.

Configuration (B): A configuration in which a pressure-sensitive adhesive layer as a thin layer-like substrate is formed on one release surface of a release liner for supporting the thin layer-like substrate, and an electromagnetic conducting or absorbing fiber convex structure section is formed at least partially on the pressure-sensitive adhesive layer on at least one surface of the release liner in such a form that at least a part of fiber thereof is positioned outward from the surface of the pressure-sensitive adhesive or adhesive layer.

Configuration (C): A configuration in which a thin layer-like substrate is not supported by a support, and an electromagnetic conducting or absorbing fiber convex structure section is formed at least partially on at least one surface (one surface or both surfaces) of a polymer layer as the thin layer-like substrate in such a form that at least a part of fiber thereof is positioned outward from the surface of the polymer layer.

Configuration (D): In the above-mentioned configurations (A) to (C), a configuration in which the electromagnetic conducting or absorbing fiber convex structure section is coated with a coating layer [i.e., a configuration in which a thin layer-like substrate is supported by a support (such as a base material or a release liner) according to the necessity, an electromagnetic conducting or absorbing fiber convex structure section is formed at least partially on at least one surface (one surface or both surfaces) of a pressure-sensitive adhesive or adhesive layer or a polymer layer as the thin layer-like substrate in such a form that at least a part of fiber thereof is positioned outward from the surface of the pressure-sensitive adhesive or adhesive layer or the polymer layer, and the electromagnetic conducting or absorbing fiber convex structure section is coated with a coating layer].

Configuration (E): In the above-mentioned configurations (A) to (D), a configuration in which a fiber protection member is provided at least partially on a portion of the thin layer-like substrate not having formed thereon the electro-

magnetic conducting or absorbing fiber convex structure section [i.e., a configuration in which a thin layer-like substrate is supported by a support (such as a base material or a release liner) according to the necessity, an electromagnetic conducting or absorbing fiber convex structure section is formed at least partially on at least one surface (one surface or both surfaces) of a pressure-sensitive adhesive or adhesive layer or a polymer layer as the thin layer-like substrate in such a form that at least a part of fiber thereof is positioned outward from the surface of the pressure-sensitive adhesive or adhesive layer or the polymer layer, and a fiber protection member is provided at least partially on a portion of the surface of the pressure-sensitive adhesive or adhesive layer or the polymer layer not having formed thereon the electromagnetic conducting or absorbing fiber, convex structure section; and, in the case of the configuration (D), the electromagnetic conducting or absorbing fiber convex structure section is coated with a coating layer].

Configuration (F): A configuration in which the sheet-like electromagnetic shielding structure having the above-mentioned configurations (A) to (C) and (E) is superposed with each other in such a form that those surfaces each having formed thereon the electromagnetic conducting or absorbing fiber convex structure section face with each other.

Incidentally, as a sheet-like electromagnetic shielding structure, a sheet-like electromagnetic shielding structure configured in at least two- or more-tiered configuration selected from the sheet-like electromagnetic shielding structures having the above-mentioned configurations (A) to (F) can be used.

In the sheet-like electromagnetic shielding structure, the electromagnetic conducting or absorbing fiber convex structure section formed on both surfaces of the thin layer-like substrate may be the same or different electromagnetic conducting or absorbing fiber convex structure section. Incidentally, the coating layer coated on the electromagnetic conducting or absorbing fiber convex structure sections may be the same or different coating layer. Incidentally, the pressure-sensitive adhesive or adhesive layer formed on both surfaces of the base material may be the same or different pressure-sensitive adhesive or adhesive layer.

Incidentally, in the case where the sheet-like electromagnetic shielding structure has the electromagnetic conducting or absorbing fiber convex structure section on one surface thereof, the other surface of the sheet-like electromagnetic shielding structure may be formed entirely or partially (for example, at least on any one end thereof) of a pressure-sensitive adhesive surface or an adhesive surface. In this way, in the case where one surface of the sheet-like electromagnetic shielding structure is formed of a pressure-sensitive adhesive surface or an adhesive surface, the pressure-sensitive adhesive surface or the adhesive surface may be formed of a pressure-sensitive adhesive surface or an adhesive surface composed of a pressure-sensitive adhesive layer or an adhesive layer having electromagnetic conducting or absorbing properties, or a pressure-sensitive adhesive surface or an adhesive surface composed of a pressure-sensitive adhesive layer or an adhesive layer not having electromagnetic conducting or absorbing properties. In this case, it is preferable that the pressure-sensitive adhesive surface or the adhesive surface is a pressure-sensitive adhesive surface or an adhesive surface composed of a pressure-sensitive adhesive layer or an adhesive layer having electromagnetic conducting or absorbing properties. Incidentally, in the case where the sheet-like electromagnetic shielding structure has a configuration in which an electromagnetic conducting or absorbing fiber convex structure section is coated with a coating layer, the surface of the coating layer may be formed entirely or partially (for example, at least on any one end thereof) of a pressure-sensitive adhesive surface or an adhesive surface. In this way, in the case where a coating layer is formed on the sheet-like electromagnetic shielding structure, and the surface of the coating layer is formed of a pressure-sensitive adhesive surface or an adhesive surface, the pressure-sensitive adhesive surface or the adhesive surface may be a pressure-sensitive adhesive surface or an adhesive surface composed of a pressure-sensitive adhesive layer or an adhesive layer having electromagnetic conducting or absorbing properties, or a pressure-sensitive adhesive surface or an adhesive surface composed of a pressure-sensitive adhesive layer or an adhesive layer not having electromagnetic conducting or absorbing properties. Such a pressure-sensitive adhesive surface or an adhesive surface may be formed by using a known method of using a pressure-sensitive adhesive or an adhesive or a known method of using a double-sided pressure-sensitive adhesive tape. Accordingly, in the case where the surface of the sheet-like electromagnetic shielding structure is formed of a pressure-sensitive adhesive surface or an adhesive surface, it is possible to produce the sheet-like electromagnetic shielding structure whose surface is formed of a pressure-sensitive adhesive surface or an adhesive surface by using various methods, such as a method of using a support (base material) whose surface exposed to the outside is preformed of a pressure-sensitive adhesive surface or an adhesive surface, a method of coating a pressure-sensitive adhesive or an adhesive on the surface of a support (base material) whose surface exposed to the outside is not formed of a pressure-sensitive adhesive surface or an adhesive surface, a method of sticking a double-sided pressure-sensitive adhesive tape or sheet (a double-sided pressure-sensitive adhesive tape or sheet of a base material-less type, or a double-sided pressure-sensitive adhesive tape or sheet of a base material-provided type) on the surface ofa support (base material) whose surface exposed to the outside is not formed of a pressure-sensitive adhesive surface or an adhesive surface, a method of using a pressure-sensitive tape or sheet whose surface exposed to the outside is preformed of a pressure-sensitive adhesive surface or an adhesive surface, a method of coating a pressure-sensitive adhesive or an adhesive on the surface of a coating layer whose surface exposed to the outside is not formed of a pressure-sensitive adhesive surface or an adhesive surface, or a method of sticking a double-sided pressure-sensitive adhesive tape or sheet (a double-sided pressure-sensitive adhesive tape or sheet of a base material-less type, or a double-sided pressure-sensitive adhesive tape or sheet of a base material-provided type) on the surface of a coating layer whose surface exposed to the outside is not formed of a pressure-sensitive adhesive surface or an adhesive surface.

In the invention, even when the electromagnetic conducting or absorbing fiber convex structure section is coated by a coating layer, and the coating layer includes or is formed of an insulating layer (for example, an electrically non-conductive member such as an electrically non-conductive pressure-sensitive adhesive layer or an electrically non-conductive adhesive layer that forms a pressure-sensitive surface or an adhesive surface), the lowering of the electromagnetic conducting or absorbing properties is suppressed or prevented, whereby the electromagnetic conducting or absorbing properties (in particular, electromagnetic shielding properties of performing shielding by conducting or absorbing electromagnetic waves) are effectively maintained and exhibited. In the invention, in the case where a coating layer is formed in the sheet-like electromagnetic shielding structure, it is preferable that the surface of the coating layer is formed of an insulating layer. Such an insulating layer may be formed for example by a method of using a pressure-sensitive adhesive tape or sheet of a base material-provided type in which a non-electromagnetic conducting or absorbing base material (in particular, a plastic base material not having electromagnetic conducting or absorbing properties), or a method of sticking a pressure-sensitive adhesive tape or sheet of a base material-provided type in which a non-electromagnetic conducting or absorbing base material (in particular, a plastic base material not having electromagnetic conducting or absorbing properties) on the surface of the coating layer.

Incidentally, in the case where the sheet-like electromagnetic shielding structure has an electromagnetic conducting or absorbing fiber convex structure section partially on both surfaces of a thin layer-like substrate, and a fiber protection member is provided at least partially on a portion of the surface of the thin layer-like substrate, on which the electromagnetic conducting or absorbing fiber convex structure section is not formed, the fiber protection member is only required to be provided on a portion of at least one surface of the thin layer-like substrate, on which the electromagnetic conducting or absorbing fiber convex structure section is not formed. In this case, it is preferable that the fiber protection member is provided on a portion of both surfaces of the thin layer-like substrate, on which the electromagnetic conducting or absorbing fiber convex structure section is not formed.

In such a sheet-like electromagnetic shielding structure, in the case where the electromagnetic conducting or absorbing fiber convex structure section is formed on both surfaces of the thin layer-like substrate, it is possible to much more enhance the electromagnetic conducting or absorbing properties. Accordingly, not only the base material for supporting the thin layer-like substrate can be made thin or be omitted thus achieve lightening of the sheet-like electromagnetic shielding structure, but also flexibility or follow-up properties (follow-up properties to an adherend) of the sheet-like electromagnetic shielding structure can be improved.

As described above, the sheet-like electromagnetic shielding structure in accordance with the invention has the pressure-sensitive adhesive properties (in particular, pressure-sensitive properties) as well as the electromagnetic conducting or absorbing properties. For example, in the case where a sheet-like electromagnetic shielding structure has the pressure-sensitive properties, the sheet-like electromagnetic shielding structure may be formed in a pressure-sensitive adhesive tape or sheet form in which the surface of a pressure-sensitive adhesive layer not having formed thereon an electromagnetic conducting or absorbing fiber convex structure section is formed of a pressure-sensitive adhesive surface.

The sheet-like electromagnetic shielding structure can be produced in a roll-like wound form or in a single-layered or sheet-laminated form. In this way, in the case where the sheet-like electromagnetic shielding structure is formed in a roll-like wound form or in a single-layered or sheet-laminated form, it is preferable that the electromagnetic conducting or absorbing fiber convex structure section is formed partially on one or both surfaces ofthe thin layer-like substrate. Incidentally, it is preferable that the fiber protection member is formed at least partially on the surface of the thin layer-like substrate, on which the electromagnetic conducting or absorbing fiber convex structure section is not formed. In this way, when the fiber protection member is provided, even in the case where the sheet-like electromagnetic shielding structure is formed in a roll-like wound form or in a single-layered or sheet-laminated form, the electromagnetic conducting or absorbing fiber convex structure section is excellent in preventing the falling down of the fiber thereof. Therefore, even when the sheet-like electromagnetic shielding structure is rewinded into the wound body or isolated from the laminated body, it is possible to obtain a sheet-like electromagnetic shielding structure in which the fiber in the electromagnetic conducting or absorbing fiber convex structure section is prevented from being fallen down. Accordingly, in the invention, the sheet-like electromagnetic shielding structure can be commercialized as a sheet-like electromagnetic shielding structure in a roll-like wound form (wound body or rolled body) or as a sheet-like electromagnetic shielding structure in a single-layered or sheet-laminated form.

In the light of the above, since the sheet-like electromagnetic shielding structure has a configuration in which the electromagnetic conducting or absorbing fiber convex structure section is formed at least partially on the thin layer-like substrate in such a form that at least a part of a fiber thereof is positioned outward from the surface of the thin layer-like substrate, and it is possible to effectively exhibit the electromagnetic conducting or absorbing properties by the electromagnetic conducting or absorbing fiber convex structure section, it can be used in a variety of utilities applying the electromagnetic conducting or absorbing properties by the electromagnetic conducting or absorbing fiber convex structure section. In particular, the sheet-like electromagnetic shielding structure can be suitably used in utilities applying the electromagnetic shielding properties of performing shielding by conducting or absorbing electromagnetic waves. Specifically, the sheet-like electromagnetic shielding structure can be suitably used as an electromagnetic shielding material capable of performing shielding electromagnetic waves in an article of every kind including an electronic device, an electronic circuit board, garment, an architectural structure, a construction material, and a transport.

In particular, with respect to the sheet-like electromagnetic shielding structure, by using, as an electromagnetic conducting or absorbing fiber for forming the electromagnetic conducting or absorbing fiber convex structure section, plural kinds or two or more kinds of electromagnetic conducting or absorbing fibers (for example, plural kinds or two or more kinds of electromagnetic conducting or absorbing raw material fibers and an electromagnetic conducting or absorbing properties-imparted fiber using different metal materials as an electromagnetic conducting or absorbing material, such as plural kinds or two or more kinds of electromagnetic conducting or absorbing material-coated fibers or electromagnetic conducting or absorbing material-impregnated fibers) or by using an electromagnetic conducting or absorbing fiber which is a single kind of an electromagnetic conducting or absorbing fiber but in which plural kinds or two or more kinds of electromagnetic conducting or absorbing materials are used (for example, an electromagnetic conducting or absorbing properties-imparted fiber using plural kinds or two or more kinds of electromagnetic conducting or absorbing materials such as an electromagnetic conducting or absorbing material-coated fibers and an electromagnetic conducting or absorbing material-impregnated fiber), it becomes possible to effectively exhibit a shielding function against not only electromagnetic waves having a single peak wavelength but also electromagnetic waves having plural peak wavelengths. That is, as the electromagnetic conducting or absorbing fiber which constitutes the electromagnetic conducting or absorbing fiber convex structure section, by combining plural kinds of electromagnetic conducting or absorbing fibers and properly adjusting a proportion thereof, it is possible to effectively shield electromagnetic waves by a single structure (electromagnetic shielding material) against a radiation source such as a material and a substance, from which plural electromagnetic waves having various peak wavelengths are emitted in a prescribed proportion. In this way, in the invention, the type of the radiation source from which electromagnetic waves are emitted is not limited, and it is possible to obtain an article of every kind (for example, an electronic device, an electronic circuit board, garment, an architectural structure, a construction material, and a transport) to which the electromagnetic shielding material capable of exhibiting a shielding function against a radiation source of a wide range is provided.

Specifically, in the case where an electromagnetic conducting or absorbing properties-imparted fiber is used as the electromagnetic conducting or absorbing fiber, in metal materials used in the electromagnetic conducting or absorbing material which constitutes the electromagnetic conducting or absorbing properties-imparted fiber, for example, nickel and gold, the type or wavelength of electromagnetic waves capable of performing shielding by conducting or absorbing electromagnetic waves is different therebetween. Accordingly, for example, in an electromagnetic shielding structure-containing article (for example, an electronic device, an electronic circuit board, garment, an architectural structure, a construction material, and a transport) having a configuration in which the electromagnetic conducting or absorbing fiber convex structure section is formed by using, as the electromagnetic conducting or absorbing fiber, a nickel plated fiber and a gold plated fiber, the resulting electromagnetic shielding material can efficiently exhibit an electromagnetic shielding effect by nickel and an electromagnetic shielding effect by gold, respectively, thereby enabling to much more effectively shield electromagnetic waves.

In addition, in the sheet-like electromagnetic shielding structure in accordance with the invention, by properly adjusting the length of the electromagnetic conducting or absorbing fiber, the density of the electromagnetic conducting or absorbing fiber in the electromagnetic conducting or absorbing fiber convex structure section, or the like as well as the type of the electromagnetic conducting or absorbing fiber for forming the electromagnetic conducting or absorbing fiber convex structure section, it is possible to provide a sheet-like electromagnetic shielding structure capable of exhibiting the desired or adequate electromagnetic shielding properties.

Incidentally, for the purpose of much more effectively conducting or absorbing electromagnetic waves, the sheet-like electromagnetic shielding structure in accordance with the invention may be grounded.

Such a sheet-like electromagnetic shielding structure can be produced by forming an electromagnetic conducting or absorbing fiber convex structure section in a prescribed site on a prescribed surface in a thin layer-like substrate. A method of forming the electromagnetic conducting or absorbing fiber convex structure section is not particularly limited, for example, a flocking processing method is especially preferable. Accordingly, it is preferable that a production method of the sheet-like electromagnetic shielding structures in accordance with the invention includes a step for forming an electromagnetic conducting or absorbing fiber convex structure section in a prescribed site on a prescribed surface in a thin layer-like substrate by applying, for example, a flocking processing method. In this way, according to the invention, it is possible to produce a structure having electromagnetic conducting or absorbing properties easily and cheaply by a simple method, for example, flocking of an electromagnetic conducting or absorbing fiber.

Specifically, by subjecting a prescribed site in the thin layer-like substrate to flocking processing by applying the flocking processing method, a sheet-like electromagnetic shielding structure having the electromagnetic conducting or absorbing fiber convex structure section in the thin layer-like substrate can be produced by forming the electromagnetic conducting or absorbing fiber convex structure section in a prescribed site of the above-mentioned thin layer-like substrate in a form that at least a part of the fiber is positioned outward from the surface of the thin layer-like substrate. As such a flocking processing method, an electrostatic flocking processing method is especially suitable. Incidentally, as the electrostatic flocking processing method, for example, there is enumerated a processing method in which a material to be flocked having a pressure-sensitive adhesive or adhesive layer or a thin layer-like substrate is set as a counter electrode to one electrode; a direct current high voltage is applied thereto; flocks (fibers) are supplied between these electrodes; and the flocks are flied along the line of electric force due to a Coulomb force and made to stick into the surface of the material to be flocked (for example, the surface of the thin layer-like substrate and the wall surface of the concave of the thin layer-like substrate), thereby achieving flocking. Such an electrostatic flocking processing method is not particularly limited so far as it is a known electrostatic flocking method. For example, any of an up method, a down method and a side method as described in "Principle and Truth of Electrostatic Flocking" in SENI (Fiber), Vol. 34, No. 6 (1982-6) may be employed.

Incidentally, for the purpose of effectively producing the structure by forming the electromagnetic conducting or absorbing fiber convex structure section in a prescribed partial site of the thin layer-like substrate (for example, a prescribed partial site on the surface of the thin layer-like substrate and a wall surface of the concave formed partially in the thin layer-like substrate) by the flocking processing method (in particular, the electrostatic flocking processing method), it is preferred to use a member having a penetrating hole section, as described above. As the member having such a penetrating hole section, a release base material having a hole section or the fiber protection member as described above is suitably usable. The release member having the hole section can be released at an appropriate time.

In the invention, by providing a fiber protection member on the surface of the thin layer-like substrate in advance, it is possible to effectively produce a sheet-like electromagnetic shielding structure having an electromagnetic conducting or absorbing fiber convex structure section formed in a form that falling down thereof is suppressed or prevented by the fiber protection member. In this way, as the fiber protection member which is to be provided in advance on the surface of the thin layer-like substrate, a fiber protection member configured by a member having a penetrating hole section (a fiber protection member having a penetrating hole section) can be used. Accordingly, as a production method of a sheet-like electromagnetic shielding structure having an electromagnetic conducting or absorbing fiber convex structure section formed in a form that falling down thereof is suppressed or prevented by the fiber protection member, a flocking processing method is suitable in which after providing a fiber protection member having a penetrating hole section on the surface of a thin layer-like substrate, an electromagnetic conducting or absorbing fiber convex structure section is formed on a portion of the thin layer-like substrate corresponding to the penetrating hole section of the fiber protection member in a form that at least a part of the fiber is positioned outward from the surface of the thin layer-like substrate by applying a flocking processing.

Incidentally, a method of providing a fiber protection member on the surface of a thin layer-like substrate is not particularly limited, but a fixing means which is properly selected from a known fixing means depending on the type of the thin layer-like substrate or the type of the fiber protection member can be used. Specifically, in the case where the thin layer-like substrate is a pressure-sensitive adhesive or adhesive layer, it is possible to provide the fiber protection member on a prescribed portion of the surface of the pressure-sensitive adhesive or adhesive layer by pressure-sensitively attaching the fiber protection member to the prescribed portion of the surface of the pressure-sensitive adhesive or adhesive layer as the thin layer-like substrate. On the other hand, in the case where the thin layer-like substrate is a polymer layer, by using a fixing means such as an pressure-sensitive adhesive or an adhesive or a fixing means in which a pressure-sensitive adhesive or adhesive layer is formed on the surface of a fiber protection member, it is possible to provide the fiber protection member on a prescribed portion of the surface of the polymer layer by pressure-sensitively attaching the fiber protection member to the prescribed site on the surface of the polymer layer as the thin layer-like substrate.

In this way, in a production method of a sheet-like electromagnetic shielding structure in which after providing a member having a penetrating hole section such as a fiber protection member on the surface of a thin layer-like substrate in advance, an electromagnetic conducting or absorbing fiber convex structure section is formed on a prescribed portion of the thin layer-like substrate, it is possible to control the forming position of the electromagnetic conducting or absorbing fiber convex structure section on the surface of the thin layer-like substrate, the size and number of the electromagnetic conducting or absorbing fiber convex structure sections, the concave for forming the electromagnetic conducting or absorbing fiber convex structure section, and so on, depending on the forming position of the penetrating hole section in the member having the penetrating hole section, the size and number of the penetrating hole sections in the member having the penetrating hole section, and the like.

Incidentally, in the invention, the electromagnetic conducting or absorbing properties (in particular, the electrical conductivity) of the sheet-like electromagnetic shielding structure can be evaluated by measuring a volume specific resistance according to JIS K6705. The electromagnetic conducting or absorbing properties of the sheet-like electromagnetic shielding structure can be controlled depending on the size of the respective electromagnetic conducting or absorbing fiber convex structure sections which are formed on the thin layer-like substrate (the occupied area of one electromagnetic conducting or absorbing fiber convex structure section) and the shape thereof, the proportion of the whole electromagnetic conducting or absorbing fiber convex structure section formed on the thin layer-like substrate with respect to the entire surface of the thin layer-like substrate (the proportion of the occupied area of the whole electromagnetic conducting or absorbing fiber convex structure section), the shape (length, thickness, or the like) and raw material ofthe fiber in the electromagnetic conducting or absorbing fiber convex structure section, and the like.

Electromagnetic Shielding Structure-Containing Article

An electromagnetic shielding structure-containing article in accordance with the invention is an article to which electromagnetic shielding properties are imparted by including at least the above-mentioned sheet-like electromagnetic shielding structure. With respect to the electromagnetic shielding structure-containing article, an article capable of including the sheet-like electromagnetic shielding structure is not particularly limited, and examples thereof include an electronic device, an electronic circuit board, garment, an architectural structure, a construction material, and a transport. That is, examples of electromagnetic shielding structure-containing article includes an electronic device including at least a sheet-like electromagnetic shielding structure, an electronic circuit board including at least a sheet-like electromagnetic shielding structure, a garment including at least a sheet-like electromagnetic shielding structure, an architectural structure including at least a sheet-like electromagnetic shielding structure, a construction material including at least a sheet-like electromagnetic shielding structure, and a transport including at least a sheet-like electromagnetic shielding structure. Specifically, examples of the electromagnetic shielding structure-containing article include the following electromagnetic shielding structure-containing articles (a) to (f).

Electromagnetic Shielding Structure-Containing Article (a): An electronic device to which electromagnetic shielding properties are imparted by at least including a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

Electromagnetic Shielding Structure-Containing Article (b): An electronic circuit board to which electromagnetic shielding properties are imparted by at least including a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

Electromagnetic Shielding Structure-Containing Article (c): A garment to which electromagnetic shielding properties are imparted by at least including a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

Electromagnetic Shielding Structure-Containing Article (d): An architectural structure to which electromagnetic shielding properties are imparted by at least including a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

Electromagnetic Shielding Structure-Containing Article (e): A construction material to which electromagnetic shielding properties are imparted by at least including a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

Electromagnetic Shielding Structure-Containing Article (f): A transport to which electromagnetic shielding properties are imparted by at least including a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate.

Electronic device

An electronic device in accordance with the invention is imparted with electromagnetic shielding properties and includes at least the above-mentioned sheet-like electromagnetic shielding structure in a thin layer-like substrate (i.e., a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate). Although the electronic device may include the sheet-like electromagnetic shielding structure in any form, it is preferable that the electronic device includes the sheet-like electromagnetic shielding structure in a form that the sheet-like electromagnetic shielding structure is pressure-sensitively attached onto any one member constituting the electronic device. Specifically, in the electronic device, examples of a member capable of pressure-sensitively attaching thereon the sheet-like electromagnetic shielding structure include a body (including a server rack) of the electronic device, an electronic circuit board in the electronic device, wirelines (including flexible printed circuit and flat cable; such as power-related wirelines or information-related wirelines) in the electronic device, a display panel in the electronic device, CPU (central processing unit), IC (integrated circuit), a graphic board, and transmitter. Among these, a body of the electronic device and an electronic circuit board in the electronic device are suitable. As a site on the body of the electronic device to be used for pressure-sensitively attaching the sheet-like electromagnetic shielding structure, a surface at the inner side of a body of the electronic device is usually used. Incidentally, as a site on the electronic circuit board to be used for pressure-sensitively attaching the sheet-like electromagnetic shielding structure, the top surface or rear surface of the electronic circuit board is suitable; or the structure may be installed between the electronic circuit boards. Incidentally, as a site on the wirelines of the electronic device to be used for pressure-sensitively attaching the sheet-like electromagnetic shielding structure, the surface of the wirelines (cables) of every kind can be used. For example, plural wirelines are wound and pressure-sensitively attached onto the structure in a bound (wound) state, or the structure is pressure-sensitively attached onto the surface of the printed circuit or flat cable as the wirelines. Incidentally, as a site on the display panel of the electronic device to be used for pressure-sensitively attaching the sheet-like electromagnetic shielding structure, a rear surface of the display panel is usually used. In this way, in the electronic device in accordance with the invention, it is preferable that the sheet-like electromagnetic shielding structure is pressure-sensitively attached onto the electronic circuit board in the electronic device.

Examples of such an electronic device include a mobile communication device (a handheld communication device; for example, a so-called "handheld phone" and a so-called "PHS"), a handheld information terminal (a so-called "PDA": Personal Digital Assistants), a personal computer (a computer; for example, a desktop computer and a portable personal computer), an amateur wireless communication device (for example, a transceiver), a display (for example, a so-called "liquid-crystal display," a so-called "plasma display" and a so-called "cathode-ray tube display"), a television (for example, a so-called "liquid-crystal television," a so-called "plasma television" and a so-called "cathode-ray tube television"), a so-called "DVD recorder," a so-called "hard-disc recorder," a so-called "digital camera," a so-called "digital video camera," various audio devices, a so-called "car navigation," various game machines, a color printer, a facsimile machine, a projector, a measuring machine, an optical transmission module, a microwave oven, an ITS-related unit, a PC card, a CD-ROM machine, a DVD-ROM machine, a hard-disc machine, an antenna (for example, a so-called "BS antenna"), a so-called "BS converter," and various electronic devices for photoelectric conversion. Examples of the portable personal computer (a handheld personal computer; a notebook computer in a broad sense of the meaning) include a so-called "notebook computer" of an A4-size or more (a notebook computer in a narrow sense of the meaning), a so-called "sub-notebook computer" of about B4-size, a so-called "mini-notebook computer" of less than B4-size, and a so-called "tablet PC."

In the invention, a mobile communication device, a handheld information terminal, and a portable personal computer are preferably used as the electronic device, and above all, a handheld phone and a PDA are suitable.

The electronic device in accordance with the invention includes a sheet-like electromagnetic shielding structure and is imparted with electromagnetic shielding properties. For that reason, the electronic device can realize shielding not only by blocking itself from external electromagnetic waves and thus suppressing or preventing noise from intruding into the electronic device, but also by blocking internal electromagnetic waves from being output from the electronic device and thus suppressing or preventing noise from being output from the electronic device. Accordingly, the electronic device in accordance with the invention has various advantages such as suppressing or reducing an electromagnetic noise radiation from components of the electronic device; reducing an electromagnetic interference (resonance or crosstalk) within the electronic device; suppressing a surface current; reducing an SAR (Specific Absorption Rate) amount of the handheld phone (the SAR is the unit of measurement for the amount of electromagnetic wave energy absorbed by the human body); improving an immunity; or serving as an excellent countermeasure to ESD.

The term "noise" means harmful or unnecessary electromagnetic or electrical signals and therefore a signal (electromagnetic or electrical signal) useful to one device (or a specific device) may become a noise signal that is unnecessary to the other device (or other devices).

Electronic Circuit Board

An electronic circuit board in accordance with the invention is imparted with electromagnetic shielding properties and includes at least the above-mentioned sheet-like electromagnetic shielding structure on a thin layer-like substrate (i.e., a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate). Although the electronic circuit board may include the sheet-like electromagnetic shielding structure in any form, it is preferable that the electronic circuit board includes the sheet-like electromagnetic shielding structure in a form that the sheet-like electromagnetic shielding structure is pressure-sensitively attached onto the electronic circuit board. As a site on the electronic circuit board to be used for pressure-sensitively attaching the sheet-like electromagnetic shielding structure, the top surface or rear (bottom) surface of the electronic circuit board can be used; or the structure may be installed between the electronic circuit boards. In this way, in the electronic circuit board in accordance with the invention, it is preferable that the sheet-like electromagnetic shielding structure is pressure-sensitively attached onto the top or rear surface of the electronic circuit.

The electronic circuit board in accordance with the invention includes a sheet-like electromagnetic shielding structure and is imparted with electromagnetic shielding properties. For that reason, the electronic circuit board can realize shielding not only by blocking itself from external electromagnetic waves and thus suppressing or preventing noise from intruding into the electronic circuit board, but also by blocking internal electromagnetic waves from being output from the electronic circuit board and thus suppressing or preventing noise from being output from the electronic circuit board. Accordingly, the electronic circuit board in accordance with the invention has various advantages such as suppressing or reducing an electromagnetic noise radiation from components of the electronic circuit board; or reducing an electromagnetic interference (resonance or crosstalk) between the electronic circuit boards.

Such an electronic circuit board may be used in various articles such as the above-mentioned electronic device or a transport equipped with an engine to be described later.

Garment

A garment in accordance with the invention is imparted with electromagnetic shielding properties and includes at least the above-mentioned sheet-like electromagnetic shielding structure on a thin layer-like substrate (i.e., a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate). Although the garment may include the sheet-like electromagnetic shielding structure in any form, it is preferable that the garment includes the sheet-like electromagnetic shielding structure in a form that the sheet-like electromagnetic shielding structure is fixed onto at a prescribed site of the garment by various fixing method (for example, a pressure-sensitive attaching method, a sewing method, a fixing method using a button, a fixing method using a magic tape, and a fixing method using a fastener).

Examples of such a garment include an office-work apron (for example, a so-called "OA apron" (such as an electromagnetic preventive apron or an electromagnetic blocking apron), pregnant clothing (for example, an apron for so-called "IH cooking device"), and medical clothing (for example, clothing's for so-called "CT scanner" measurement, clothing's for so-called "MRI" measurement, and a so-called "white coat").

In the invention, the garment means a garment in a broad sense of the meaning. Therefore, examples of the garment may include not only clothing's (for example, a shirt, a blouse, an outer wear, trousers, a skirt, a coat, a so-called "white coat" (a white outer garment) and an underwear, but also an apron, a hat, a hood, and socks.

The garment in accordance with the invention includes a sheet-like electromagnetic shielding structure and is imparted with electromagnetic shielding properties. For that reason, the garment can realize shielding by blocking itself from electromagnetic waves radiated from a computer, from electromagnetic waves radiated from a home electronic cooking device (for example, an IH (induction heating) cooking device), from electromagnetic waves radiated from various medical devices (for example, a so-called "MRI" device, a so-called "CT scanner" device, and a so-called "radiographic visualization" device) and thus suppressing or preventing electromagnetic wave effect onto a human body.

Architectural Structure

An architectural structure in accordance with the invention is imparted with electromagnetic shielding properties and includes at least the above-mentioned sheet-like electromagnetic shielding structure on a thin layer-like substrate (i.e., a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate). Although the architectural structure may include the sheet-like electromagnetic shielding structure in any form, it is preferable that the architectural structure includes the sheet-like electromagnetic shielding structure in a form that the sheet-like electromagnetic shielding structure is pressure-sensitively attached onto any one member (in particular, an outer surface of the member) constituting the architectural structure or in a form that the sheet-like electromagnetic shielding structure is contained in the inside (within the laminated body) of a laminated structure of any one member constituting the architectural structure. Specifically, in the architectural structure, examples of a member capable of pressure-sensitively attaching thereon or containing the sheet-like electromagnetic shielding structure in the inside of the laminated structure include an outer surface (for example, a wall surface, a roof surface and a top surface) of the architectural structure, an inner surface of respective rooms in the architectural structure (for example, a wall surface, a ceiling surface, and a floor surface), a construction material in the architectural structure [for example, a wall material (for example, a wall plywood, a wall sheet, a wallpaper, and a wall tile); a floor material (for example, a flooring material, a floor plywood, a floor sheet, a floor linoleum, a floor stone, a floor carpet, a flooring material for a so-called "floor heating system," a Tatami (Japanese floor mat), and a tatami board; a ceiling material (for example, a ceiling plywood, a ceiling sheet, and a ceiling wallpaper); a roof material (for example, a roof plywood, a tile and various roof materials); a pillar material (for example, a wooden pillar installed in a vertical or non-vertical direction, a metallic pillar, and a concrete-made pillar); and various base material (for example, a wall base material and a floor base material)], the surface in the external or internal side of a bonding site between construction materials, a piping in the architectural structure, a shutter material, an outer door material, a window frame material, a door (including a sliding door) material (for example, a door material in the architectural structure, a front door material, and a material for doors exposed to the outside), a door frame material, a partition material, an installed furniture (a built-in type furniture) or a material thereof, and a wall tile for kitchen. Among these, the surface in the external or internal side of a construction material in the architectural structure or a bonding site between construction materials is suitable. Incidentally, the sheet-like electromagnetic shielding structure may be pressure-sensitively attached onto wirelines (for example, power-related wirelines and information-related wirelines) installed in the architectural structure.

Examples of such an architectural structure include an individual house, a mansion, an office building, a hall (a cinema, a concert hall, a theater, an art gallery, a museum, a wedding hall, and a hall for conference or lecture), a darkroom, a structure related to base-station antenna [for example, a structure related to base-station antenna in a base station for mobile communication device, a structure related to base-station antenna in VICS (Vehicle Information and Communication System), a structure related to base-station antenna in a base station for multiplex communication system, and a structure related to base-station antenna in a television or radio set], and a structure related to a so-called "ITS" (Intelligent Transport System) [for example, a so-called "ETC" (Electronic Toll Collection System)]. Examples of a structure related to the ETC include a ceiling structure installed on the periphery of a radar receiver system in the ETC (for example, a ceiling structure installed on the ceiling portion of an ETC lane), a partitioning structure (for example, a structure installed between ETC lanes to prevent cross-interference between the ETC lanes), and a pole of the partitioning structure (for example, a pole installed in the ETC lane or between the ETC lanes).

The architectural structure in accordance with the invention includes a sheet-like electromagnetic shielding structure and is imparted with electromagnetic shielding properties. For that reason, the architectural structure can realize shielding not only by blocking internal electromagnetic waves from being output to the outside and thus suppressing or preventing leakage of information, but also by blocking itself from external electromagnetic waves and thus disabling the use of a so-called "handheld phone" or preventing a bad effect of FM waves (radio waves) (for example, preventing malfunctioning of a wireless microphone) in the architectural structure (for example, a hall having various usages such as a cinema, a concert hall, a theater, an art gallery, a museum, a wedding hall, a hall for conference or lecture) or a specific room (for example, a conference room) in the architectural structure. Incidentally, it is possible to suppress or prevent scattering or irregular reflection of electromagnetic waves radiated from an electronic device installed in a room and thus preventing malfunctioning of various electronic devices installed in the room, thereby enabling to operate the electronic devices in an effective manner. For example, by applying to a construction material such as a partition or wall material, it is possible to suppress or prevent lowering of communication speed resulting from reflection onto a construction material such as a partition or wall material at the time of using a so-called "wireless LAN." Incidentally, in the case where the architectural structure is a structure related to the ITS such as ETC, it is possible to suppress or prevent a multi-path signal traveling in a radar system, a cross-interference in an ETC gate, and an overlapping reception in the radar system, thereby preventing malfunctioning or double levying. Incidentally, by applying onto an outer surface of a high-rise building, it is possible to suppress or prevent a ghost of television radio waves.

Construction Material

A construction material in accordance with the invention is imparted with electromagnetic shielding properties and includes at least the above-mentioned sheet-like electromagnetic shielding structure on a thin layer-like substrate (i.e., a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate). Although the construction material may include the sheet-like electromagnetic shielding structure in any form, it is preferable that the architectural structure includes the sheet-like electromagnetic shielding structure in a form that the sheet-like electromagnetic shielding structure is pressure-sensitively attached onto the construction material or in a form that the sheet-like electromagnetic shielding structure is contained in the inside (within the laminated body) of a laminated structure of the construction material. As a site on the construction material to be used for pressure-sensitively attaching the sheet-like electromagnetic shielding structure, a surface (any one surface or the other surface thereof) of the construction material is usually used. In this way, as the construction material in accordance with the invention, a construction material having the sheet-like electromagnetic shielding structure pressure-sensitively attached onto the surface thereof, or a construction material having the sheet-like electromagnetic shielding structure contained in the inside (within the laminated body) of a laminated structure thereof is preferable.

Examples of such a construction material include various materials used in the architectural structure as enumerated previously. For example, not only a wall material, a floor material, a ceiling material, a roof material, a pillar material, and a base material, but also a peripheral material of a radar system (for example, a ceiling material, a partitioning material, and a pole used in the periphery of a radar receiver system), and a peripheral material of an antenna support may be used. Such a construction material may be made of a material of every kind. Examples thereof include a wood-made construction material (for example, plywood such as a particle board, a so-called "MDF," or a so-called "conpane (concrete panel)"), a metal-made construction material (for example, an aluminum-made material and a stainless material), a stone-made construction material (for example, a plaster board and a marble), a brick-made construction material, a ceramic-made construction material, and a glass-made construction material.

The construction material in accordance with the invention includes a sheet-like electromagnetic shielding structure and is imparted with electromagnetic shielding properties. For that reason, the construction material can realize shielding by blocking electromagnetic waves from one surface to the other surface, thereby suppressing or preventing leakage of information, disabling the use of a so-called "handheld phone," preventing a bad effect of FM waves (radio waves) and malfunctioning of an electronic device. Incidentally, in the case where the construction material is a material (for example, a peripheral material of a radar system) for a structure related to the ITS such as ETC, it is possible to suppress or prevent a multi-path signal traveling in a radar system, a cross-interference in an ETC gate, and an overlapping reception in the radar system, thereby preventing malfunctioning or double levying. Incidentally, in the case where the construction material is a partition or a wall material, it is possible to suppress or prevent lowering of communication speed resulting from reflection onto a construction material such as a partition or wall material at the time of using a wireless LAN.

Transport

A transport in accordance with the invention is imparted with electromagnetic shielding properties and includes at least the above-mentioned sheet-like electromagnetic shielding structure on a thin layer-like substrate (i.e., a sheet-like electromagnetic shielding structure having a configuration in which a fiber convex structure section having a characteristic of conducting or absorbing electromagnetic waves is formed at least partially on a thin layer-like substrate in such a form that at least a part of a fiber thereof is positioned outward from the surface of the thin layer-like substrate). In the invention, the transport means basically a transport having an engine or motor (an engine or motor-equipped transport). As the engine or motor, it is only required to be a machine or mechanism converting various types of energy into a mechanical force or a movement. For example, an engine of every kind using various fuels [for example, a petroleum-based liquid fuel (a so-called "gasoline," a so-called "light oil," a so-called "heavy oil," and a kerosene (burning oil)); an alcohol-based liquid fuel (for example, methanol and ethanol); a gaseous fuel (for example, a natural gas, a hydrogen gas, and a methane gas); and a solid fuel (for example, a coal and a charcoal), and an engine using an electrical energy (a so-called "motor") may be used in every form.

Such a transport is usually equipped with an electronic device. Accordingly, the transport includes various electronic systems and components thereof such as various control systems and components thereof or radar monitoring systems and components thereof.

Although the transport may include the sheet-like electromagnetic shielding structure in any form, it is preferable that the transport includes the sheet-like electromagnetic shielding structure in a form that the sheet-like electromagnetic shielding structure is pressure-sensitively attached onto any one member constituting the transport. Specifically, in the transport, examples of a member capable of pressure-sensitively attaching thereon the sheet-like electromagnetic shielding structure include a body (an air-frame) of the transport, an electronic circuit board in the transport, and wirelines in the transport (for example, power-related wirelines and information-related wirelines). Among these, the body (an air-frame) of the transport, the electronic circuit board in the transport, and the wirelines in the transport are suitable. As a site on the body of the transport to be used for pressure-sensitively attaching the sheet-like electromagnetic shielding structure, any one or both of the surfaces at the outer and inner sides of the body may be used. Incidentally, as a site on the electronic circuit board to be used for pressure-sensitively attaching the sheet-like electromagnetic shielding structure, the top surface or rear surface of the electronic circuit board is suitable; or the structure may be installed between the electronic circuit boards. In this way, in the transport in accordance with the invention, it is preferable that the sheet-like electromagnetic shielding structure is pressure-sensitively attached onto the body of the transport, the electronic circuit board in the transport, and the wirelines in the transport.

Examples of such a transport include an automobile (for example, a truck and a bus as well as an ordinary automobile), a railroad vehicle, a ship, an aircraft (for example, an airship, a glider, a balloon as well as an airplane and a helicopter), a submarine, a two-wheeled vehicle (for example, a so-called "motorcycle" and a so-called "scooter"), a rocket, a spaceship, and an artificial satellite.

In the invention, an automobile, a railroad vehicle, a ship, and an aircraft are especially suitable as the transport.

The transport in accordance with the invention includes a sheet-like electromagnetic shielding structure and is imparted with electromagnetic shielding properties. For that reason, in the case where the transport is a ship, by pressure-sensitively attaching the sheet-like electromagnetic shielding structure onto the peripheral portion of a mast, it is possible to come up with a countermeasure to a false image in a radar system. Incidentally, by pressure sensitively attaching the sheet-like electromagnetic shielding structure onto the inner surface of a body of the transport or onto components such as the electronic device, electronic circuit board or wirelines in the transport, it is possible to suppress or reduce an electromagnetic noise radiation from the electronic device, the electronic circuit board or the wirelines and to reduce an electromagnetic interference (resonance or crosstalk) between the electronic circuit boards; suppressing a surface current, thereby suppressing or preventing malfunctioning of the transport and reducing an SAR (Specific Absorption Rate) amount (the SAR is the unit of measurement for the amount of electromagnetic wave energy absorbed by the human body) in an effective manner. Incidentally, by pressure sensitively attaching the sheet-like electromagnetic shielding structure onto the outer surface of a body of the transport such as an aircraft, it is possible to suppress or prevent generation of unnecessary internal noise in the body of the transport and thus to suppress or prevent the effect of unnecessary external noise.

Examples of a site on the electronic device, electronic circuit board or wirelines in the transport include those sites as enumerated in the above-mentioned electronic device or the above-mentioned electronic circuit board.

Examples

The invention will be described below in detail with reference to the following Examples, but it should not be construed that the invention is limited to these Examples. Incidentally, in Sheet-like Electromagnetic Shielding Structure Production Examples 1 to 9 to be described later, electrostatic flocking processing was carried out by using a box provided with a line capable of spraying a fiber in the positively charged state and of flowing a longitudinal strip-form sheet in the negatively charged state from one side to the other side (size: 2.5 m (length in the line flow direction) × 1.3 m (width) × 1.4 m (height)). Specifically, the electrostatic flocking processing was carried out by spraying the fiber from an upper portion (one portion) within the above-mentioned box and introducing and moving the longitudinal strip-form sheet within the box at a line speed of 5 m/min in the state of spraying at an applied voltage of 30 kV such that the surface on which the fiber was to be formed was positioned in the upper side.

Sheet-like Electromagnetic Shielding Structure Production Example 1

On both surfaces of an aluminum-made base material (thickness: 50 μm) as an electromagnetic conducting or absorbing base material, an acrylic pressure-sensitive adhesive (base polymer: butyl acrylate/acrylic acid copolymer) having 35% by weight (proportion based on the total amount of solids) of a nickel powder blended therein was coated in a thickness after drying of 35 μm to form an electromagnetic conducting or absorbing pressure-sensitive adhesive layer. Subsequently, a trade name "Nisseki Conwed ON6200" (from NISSEKI PLASTO CO., LTD; mesh opening: 4 mm × 4 mm, basis weight: 34 g/m$^2$, void ratio: 76%, thickness: 0.5 mm) (net-like member) was pressure-sensitively attached as a fiber protection member to one surface of the electromagnetic conducting or absorbing pressure-sensitive adhesive layer. Thereafter, the surface of the electromagnetic conducting or absorbing pressure-sensitive adhesive layer was subjected to electrostatic flocking processing by using, as an electromagnetic conducting or absorbing fiber, an acrylic fiber whose surface had been subjected to a nickel plating treatment (a plating treatment with nickel) (fiber diameter: 20 μm, fiber length: 0.5 mm), and the above-mentioned acrylic fiber whose surface had been subjected to a nickel plating treatment was flocked in a site on the surface of the above-mentioned electromagnetic conducting or absorbing pressure-sensitive adhesive layer corresponding to the penetrating hole section of the net-like member (fiber protection member), thereby forming a fiber napping section (electromagnetic conducting or absorbing fiber napping section) composed of an electromagnetic conducting or absorbing fiber (acrylic fiber whose surface had been subjected to a nickel plating treatment). Incidentally, an acrylic pressure-sensitive adhesive tape (a trade name "No. 31B" manufactured by NITTO DENKO CORPORATION) using a polyester film as a base material was pressure-sensitively attached onto the above-mentioned electromagnetic conducting or absorbing fiber napping section. There was thus prepared a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an acrylic pressure-sensitive adhesive tape (the sheet-like electromagnetic shielding structure will be hereinafter sometimes referred to as "sheet-like electromagnetic shielding structure A1").

Incidentally, the sheet-like electromagnetic shielding structure A1 has a layer configuration in which the electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the acrylic pressure-sensitive adhesive tape are formed in this order.

Sheet-like Electromagnetic Shielding Structure Production Example 2

The same procedures as in Sheet-like Electromagnetic Shielding Structure Production Example 1 were followed, except for using, as the fiber protection member, a trade name "Nisseki Conwed ON3330" (from NISSEKI PLASTO CO., LTD; mesh opening: 4 mm $\times$ 1 mm, basis weight: 32 g/m$^2$, void ratio: 68%, thickness: 0.32 mm) (net-like member), thereby preparing a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an acrylic pressure-sensitive adhesive tape (the sheet-like electromagnetic shielding structure will be hereinafter sometimes referred to as "sheet-like electromagnetic shielding structure A2").

Incidentally, the sheet-like electromagnetic shielding structure A2 has a layer configuration in which the electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the acrylic pressure-sensitive adhesive tape are formed in this order.

Sheet-like Electromagnetic Shielding Structure Production Example 3

On one surface of an aluminum-made base material (thickness: 50 $\mu$m) as an electromagnetic conducting or absorbing base material, an acrylic pressure-sensitive adhesive (base polymer: butyl acrylate/acrylic acid copolymer) was coated in a thickness after drying of 35 $\mu$m to form a non-electromagnetic conducting or absorbing pressure-sensitive adhesive layer. Incidentally, on the other surface of the aluminum-made base material, an acrylic pressure-sensitive adhesive (base polymer: butyl acrylate/acrylic acid copolymer) having 35% by weight (proportion based on the total amount of solids) of a nickel powder blended therein was coated in a thickness after drying of 35 $\mu$m to form an electromagnetic conducting or absorbing pressure-sensitive adhesive layer. Subsequently, a trade name "Nisseki Conwed XN9567" (from NISSEKI PLASTO CO., LTD; mesh opening: 1 mm $\times$ 1 mm, basis weight: 151 g/m$^2$, void ratio: 46%, thickness: 0.34 mm) (net-like member) was pressure-sensitively attached as a fiber protection member to the surface of the electromagnetic conducting or absorbing pressure-sensitive adhesive layer. Thereafter, the surface of the electromagnetic conducting or absorbing pressure-sensitive adhesive layer was subjected to electrostatic flocking processing by using, as an electromagnetic conducting or absorbing fiber, an acrylic fiber whose surface had been subjected to a nickel plating treatment (a plating treatment with nickel) (fiber diameter: 20 $\mu$m, fiber length: 0.5 mm), and the above-mentioned acrylic fiber whose surface had been subjected to a nickel plating treatment was flocked in a site on the surface of the above-mentioned electromagnetic conducting or absorbing pressure-sensitive adhesive layer corresponding to the penetrating hole section of the net-like member (fiber protection member), thereby forming a fiber napping section (electromagnetic conducting or absorbing fiber napping section) composed of an electromagnetic conducting or absorbing fiber (acrylic fiber whose surface had been subjected to a nickel plating treatment). Incidentally, an acrylic pressure-sensitive adhesive tape (a trade name "No. 31B" manufactured by NITTO DENKO CORPORATION) using a polyester film as a base material was pressure-sensitively attached onto the above-mentioned electromagnetic conducting or absorbing fiber napping section. There was thus prepared a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface ofthe electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an acrylic pressure-sensitive adhesive tape (the sheet-like electromagnetic shielding structure will be hereinafter sometimes referred to as "sheet-like electromagnetic shielding structure A3").

Incidentally, the sheet-like electromagnetic shielding structure A3 has a layer configuration in which the electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the acrylic pressure-sensitive adhesive tape are formed in this order.

Sheet-like Electromagnetic Shielding Structure Production Example 4

The same procedures as in Sheet-like Electromagnetic Shielding Structure Production Example 1 were followed, except for using, as the fiber protection member, a trade name "Nisseki Conwed XN6065" (from NISSEKI PLASTO CO., LTD; mesh opening: 1 mm $\times$ 1 mm, basis weight: 100 g/m$^2$, void ratio: 38%, thickness: 0.48 mm) (net-like member), thereby preparing a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an acrylic pressure-sensitive adhesive tape (the sheet-like electromagnetic shielding structure will be hereinafter sometimes referred to as "sheet-like electromagnetic shielding structure A4").

Incidentally, the sheet-like electromagnetic shielding structure A4 has a layer configuration in which the electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the acrylic pressure-sensitive adhesive tape are formed in this order.

Sheet-like Electromagnetic Shielding Structure Production Example 5

The same procedures as in Sheet-like Electromagnetic Shielding Structure Production Example 3 were followed, except for using, as the fiber protection member, a sheet-like member (perforated sheet member) in a form that a perforated hole section (diameter: 0.8 mm) having a circular shape was formed in a polyethylene-based resin-made base material (thickness: 0.10 mm) with a substantially regular spacing to obtain a void ratio of 2% (the sheet-like member having a thickness of 0.18 mm at a thick portion of the peripheral portion of the perforated section), thereby preparing a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an acrylic pressure-sensitive adhesive tape (the sheet-like electromagnetic shielding structure will be hereinafter sometimes referred to as "sheet-like electromagnetic shielding structure A5").

Incidentally, the sheet-like electromagnetic shielding structure A5 has a layer configuration in which the non-electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the acrylic pressure-sensitive adhesive tape are formed in this order.

Sheet-like Electromagnetic Shielding Structure Production Example 6

On both surfaces of an aluminum-made base material (thickness: 50 $\mu$m) as an electromagnetic conducting or absorbing base material, an acrylic pressure-sensitive adhesive (base polymer: butyl acrylate/acrylic acid copolymer) having 35% by weight (proportion based on the total amount of solids) of a nickel powder blended therein was coated in a thickness after drying of 35 $\mu$m to form an electromagnetic conducting or absorbing pressure-sensitive adhesive layer. Thereafter, one surface of the electromagnetic conducting or absorbing pressure-sensitive adhesive layer was subjected to electrostatic flocking processing by using, as an electromagnetic conducting or absorbing fiber, an acrylic fiber whose surface had been subjected to a nickel plating treatment (a plating treatment with nickel) (fiber diameter: 20 μm, fiber length: 0.5 mm), and the above-mentioned acrylic fiber whose surface had been subjected to a nickel plating treatment was flocked entirely on the surfaces of the above-mentioned electromagnetic conducting or absorbing pressure-sensitive adhesive layer. There was thus prepared a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed entirely on the surface of the electromagnetic conducting or absorbing pressure-sensitive adhesive layer formed on the electromagnetic conducting or absorbing base material (the sheet-like electromagnetic shielding structure will be hereinafter sometimes referred to as "sheet-like electromagnetic shielding structure A6").

Incidentally, the sheet-like electromagnetic shielding structure A6 has a layer configuration in which the electromagnetic conducting or absorbing pressure-sensitive adhesive layer; the electromagnetic conducting or absorbing base material; and the electromagnetic conducting or absorbing pressure-sensitive adhesive layer having formed thereon the electromagnetic conducting or absorbing fiber napping section (entirely) are formed in this order.

Sheet-like Electromagnetic Shielding Structure Production Example 7

On both surfaces of an aluminum-made base material (thickness: 50 μm) as an electromagnetic conducting or absorbing base material, an acrylic pressure-sensitive adhesive (base polymer: butyl acrylate/acrylic acid copolymer) having 35% by weight (proportion based on the total amount of solids) of a nickel powder blended therein was coated in a thickness after drying of 35 μm to form an electromagnetic conducting or absorbing pressure-sensitive adhesive layer. Subsequently, a trade name "Nisseki Conwed XN6065" (from NISSEKI PLASTO CO., LTD; mesh opening: 1 mm × 1 mm, basis weight: 100 g/m$^2$, void ratio: 38%, thickness: 0.48 mm) (net-like member) was pressure-sensitively attached as a fiber protection member to one surface of the electromagnetic conducting or absorbing pressure-sensitive adhesive layer. Thereafter, the surface of the electromagnetic conducting or absorbing pressure-sensitive adhesive layer was subjected to electrostatic flocking processing by using, as an electromagnetic conducting or absorbing fiber, an acrylic fiber whose surface had been subjected to a nickel plating treatment (a plating treatment with nickel) (fiber diameter: 20 μm, fiber length: 0.5 mm), and the above-mentioned acrylic fiber whose surface had been subjected to a nickel plating treatment was flocked in a site on the surface of the above-mentioned electromagnetic conducting or absorbing pressure-sensitive adhesive layer corresponding to the penetrating hole section of the net-like member (fiber protection member). There was thus prepared a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, and the electromagnetic conducting or absorbing fiber napping section is prevented from being fallen down by the net-like member (the sheet-like electromagnetic shielding structure will be hereinafter sometimes referred to as "sheet-like electromagnetic shielding structure A7").

Incidentally, the sheet-like electromagnetic shielding structure A7 has a layer configuration in which the electromagnetic conducting or absorbing pressure-sensitive adhesive layer; the electromagnetic conducting or absorbing base material; and the electromagnetic conducting or absorbing pressure-sensitive adhesive layer having formed thereon the electromagnetic conducting or absorbing fiber napping section (partially) and the fiber protection member are formed in this order.

Sheet-like Electromagnetic Shielding Structure Production Example 8

On both surfaces of an aluminum-made base material (thickness: 50 μm) as an electromagnetic conducting or absorbing base material, an acrylic pressure-sensitive adhesive (base polymer: butyl acrylate/acrylic acid copolymer) having 35% by weight (proportion based on the total amount of solids) of a nickel powder blended therein was coated in a thickness after drying of 35 μm to form an electromagnetic conducting or absorbing pressure-sensitive adhesive layer. Subsequently, a trade name "Nisseki Conwed XN6065" (from NISSEKI PLASTO CO., LTD; mesh opening: 1 mm × 1 mm, basis weight: 100 g/m$^2$, void ratio: 38%, thickness: 0.48 mm) (net-like member) was pressure-sensitively attached as a fiber protection member to one surface of the electromagnetic conducting or absorbing pressure-sensitive adhesive layer. Thereafter, the surface of the electromagnetic conducting or absorbing pressure-sensitive adhesive layer was subjected to electrostatic flocking processing by using, as an electromagnetic conducting or absorbing fiber, an acrylic fiber whose surface had been subjected to a nickel plating treatment (a plating treatment with nickel) (fiber diameter: 20 μm, fiber length: 0.5 mm), and the above-mentioned acrylic fiber whose surface had been subjected to a nickel plating treatment was flocked in a site on the surface of the above-mentioned electromagnetic conducting or absorbing pressure-sensitive adhesive layer corresponding to the penetrating hole section of the net-like member (fiber protection member), thereby forming a fiber napping section (electromagnetic conducting or absorbing fiber napping section) composed of an electromagnetic conducting or absorbing fiber (acrylic fiber whose surface had been subjected to a nickel plating treatment). Incidentally, an electrically conductive pressure-sensitive adhesive tape (a trade name "NITO FOIL AT-5 105E" manufactured by NITTO DENKO CORPORATION) using an aluminum-made base material as a base material was pressure-sensitively attached onto the above-mentioned electromagnetic conducting or absorbing fiber napping section. There was thus prepared a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an electrically conductive pressure-sensitive adhesive tape (the sheet-like electromagnetic shielding structure will be hereinafter sometimes referred to as "sheet-like electromagnetic shielding structure A8").

Incidentally, the sheet-like electromagnetic shielding structure A8 has a layer configuration in which the electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the electrically conductive pressure-sensitive adhesive tape are formed in this order.

Sheet-like Electromagnetic Shielding Structure Production Example 9

The same procedures as in Sheet-like Electromagnetic Shielding Structure Production Example 8 were followed, except for using, as the fiber protection member, a trade name "Nisseki Conwed XN9567" (from NISSEKI PLASTO CO., LTD; mesh opening: 1 mm × 1 mm, basis weight: 151 g/m$^2$, void ratio: 46%, thickness: 0.34 mm) (net-like member), thereby preparing a sheet-like electromagnetic shielding structure in a form that a fiber napping section (electromagnetic conducting or absorbing fiber napping section) composed of the electromagnetic conducting or absorbing fiber (acrylic fiber whose surface had been subjected to a nickel plating treatment) was formed partially on the surface of the electromagnetic conducting or absorbing pressure-sensitive adhesive layer formed on the electromagnetic conducting or absorbing base material, the electromagnetic conducting or absorbing fiber napping section is prevented from being fallen down by the net-like member, and the electromagnetic conducting or absorbing fiber napping section is coated by a coating layer composed of an electrically conductive pressure-sensitive adhesive tape (the sheet-like electromagnetic shielding structure will be hereinafter sometimes referred to as "sheet-like electromagnetic shielding structure A9").

Incidentally, the sheet-like electromagnetic shielding structure A9 has a layer configuration in which the electromagnetic conducting or absorbing pressure-sensitive adhesive layer; the electromagnetic conducting or absorbing base material; the electromagnetic conducting or absorbing pressure-sensitive adhesive layer on which the electromagnetic conducting or absorbing fiber napping section (partially) and the fiber protection member are formed; and the coating layer composed of the electrically conductive pressure-sensitive adhesive tape are formed in this order.

Evaluation Of Magnetic Shielding Effect In Sheet-like Electromagnetic Shielding Structure

With respect to the sheet-like electromagnetic shielding structures A1 to A9 as prepared in Sheet-like Electromagnetic Shielding Structure Production Examples 1 to 9, a magnetic shielding effect were respectively evaluated by using an electromagnetic shielding evaluation system by the KEC method. The evaluation results are shown in Table 1.

Incidentally, the KEC method in the electromagnetic shielding evaluation system by the KEC method is a method as developed by Kansai Electronic Industry Development Center. According to the method, the shielding effect in the near electromagnetic field is evaluated by using an amplifier and a spectrum analyzer and respective shielding boxes (a shielding box for electrical field and a shielding box for magnetic field) marketed from Anritsu Corporation. Specifically, by using a shielding box for electrical field as shown in Fig. 12A or a shielding box for magnetic field as shown in Fig. 12B, the sheet-like electromagnetic shielding structure is placed in a prescribed position; an electromagnetic wave having a prescribed frequency (MHz) (incident wave: incident electrical field or incident magnetic field) is made incident with prescribed energy (hereinafter sometimes referred to as "E1") from the side of the electromagnetic conducting or absorbing fiber convex structure section of the sheet-like electromagnetic shielding structure; energy (hereinafter sometimes referred to as "E2") of a transmitted wave (transmitted electrical field or transmitted magnetic field) which has transmitted into the other surface of the sheet-like electromagnetic shielding structure is measured; and the shielding effect (dB) is determined according to the following expression (1).

$$\text{Shielding effect (dB)} = 20 \times \log (E2/E1) \quad (1)$$

Figs. 12A and 12B each is an outline cross-sectional view showing a shielding box to be used in the electromagnetic shielding evaluation system by the KEC method, in which Fig. 12A shows a shielding box for electrical field and Fig. 12B shows a shielding box for magnetic field. The shielding box for electrical field (unit for electrical field shielding evaluation) has a structure in which dimensional distribution of a TEM cell is employed and the inside of the plane vertical to the transmission axis direction is divided bilaterally symmetrically. However, a short circuit is prevented from the formation by inserting a measurement sample. Furthermore, the shielding box for magnetic field (unit for magnetic field shielding evaluation) has a structure in which a shield type circular loop antenna is used for the purpose of generating a large electromagnetic field of the magnetic field component and combined with a metal plate of 90° square such that a 1/4 portion of the loop antenna is exposed outward.

Incidentally, with respect to the shielding effect, the details are described in Denjiha Shahei Gijutsu (Electromagnetic Shielding Technologies) (pages 253 to 269) in Tokkyo Mappu Shirizu: Denki 23 (Patent Map Series: Electricity 23) published by Japan Institute of Invention and Innovation or the like. In the document, it is described that an index to what extent the electromagnetic energy of the incident electrical field or incident magnetic field can be decayed is the shielding effect, and as represented by the above-mentioned expression (1), the shielding effect is expressed as a value resulting from multiplication of a common logarithm of a ratio of the electromagnetic energy of the transmitted electrical field or transmitted magnetic field to the electromagnetic energy of the incident electrical field or incident magnetic field by twenty (unit: dB), respectively. In addition, with respect to the shielding effect, it is described (on pages 253 to 254) that as the standard of the shielding effect, the shielding effect is not substantially revealed at from 0 to 10 dB; the shielding effect is the minimum at from 10 to 30 dB; the shielding effect is an average level at from 30 to 60 dB; the shielding effect is considerably revealed at from 60 to 90 dB; and the shielding effect is the maximum at 90 dB or more.

In the above-mentioned KEC method, a measurement limit is different between the low frequency region and the high frequency region. This is because a transmission characteristic of a shielding (aluminum shielding plate) is constant regardless of the frequency (-105 dBm over from 1 MHz to 1 GHz in the electrical field shielding box), while a transmission characteristic of the through has a frequency characteristic (the transmission characteristic is decayed to about -50 dBm in the low frequency side, whereas substantially the same as 0 dBm as in the transmitting side is received in the high frequency side). Incidentally, it is thought that the transmission characteristic of shielding (2 mm-thick aluminum shielding plate) is actually a much smaller value and that "-105 dBm" is a noise level (ability) of the spectrum analyzer. In addition, it is thought that if the noise level (ability) of the spectrum analyzer becomes higher, the transmission characteristic of shielding (aluminum shielding plate) becomes a smaller value, and a difference from the through becomes large, whereby the measurement limit is expanded. However, since when expressed in terms of electrical power, "-105 dBm" is a very small value as not more than 0.1 pW, it is considered that more enhancement is difficult.

Table 1

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement Limit (DB) | 57 | 63 | 66 | 71 | 74 | 77 | 83 | 86 | 90 | 92 | 95 | 98 | 100 | 97 | 93 | 75 |
| Sheet-like electromagnetic shielding structure | | | | | | | | | | | | | | | | |
| Structure A1 | 32 | 37 | 41 | 46 | 49 | 53 | 66 | 77 | 76 | 76 | 77 | 77 | 80 | 97 | 93 | 75 |
| Structure A2 | 31 | 37 | 41 | 46 | 49 | 53 | 65 | 73 | 90 | 92 | 90 | 93 | 95 | 97 | 93 | 75 |
| Structure A3 | 32 | 37 | 41 | 46 | 49 | 53 | 65 | 73 | 90 | 89 | 89 | 93 | 97 | 97 | 93 | 75 |
| Structure A4 | 31 | 37 | 42 | 46 | 49 | 54 | 64 | 73 | 90 | 90 | 89 | 93 | 100 | 97 | 93 | 75 |
| Structure A5 | 31 | 37 | 41 | 46 | 49 | 53 | 57 | 79 | 74 | 73 | 75 | 78 | 78 | 97 | 93 | 75 |
| Structure A6 | 29 | 36 | 39 | 44 | 48 | 52 | 63 | 69 | 80 | 88 | 95 | 98 | 100 | 97 | 93 | 75 |
| Structure A7 | 31 | 37 | 41 | 46 | 50 | 54 | 64 | 71 | 83 | 89 | 95 | 98 | 100 | 97 | 93 | 75 |
| Structure A8 | 50 | 60 | 65 | 71 | 74 | 77 | 83 | 86 | 90 | 92 | 95 | 98 | 100 | 97 | 93 | 75 |
| Structure A9 | 49 | 61 | 66 | 71 | 74 | 77 | 83 | 86 | 90 | 92 | 95 | 98 | 100 | 97 | 93 | 75 |
| * Unit of shielding effect : dB | | | | | | | | | | | | | | | | |

From Table 1, it was confirmed that the sheet-like electromagnetic shielding structures A1 to A9 as prepared in Sheet-like Electromagnetic Shielding Structure Production Examples 1 to 9 were markedly excellent with respect to the magnetic field shielding effect.

As is clear from Table 1, the sheet-like electromagnetic shielding structures A1 to A9 as prepared in Sheet-like Electromagnetic Shielding Structure Production Examples 1 to 9 were markedly excellent with respect to the electrical field shielding effect.

Incidentally, since in the sheet-like electromagnetic shielding structures A1 to A5 and A7 to A9, the electromagnetic conducting or absorbing fiber convex structure section composed of the electromagnetic conducting or absorbing fiber is protected by the fiber protection member, the electromagnetic conducting or absorbing fiber convex structure section is excellent in preventing the falling down of the fiber thereof. Accordingly, the fiber is suppressed or prevented from being fallen down, and a thickness effect of the electromagnetic conducting or absorbing fiber convex structure section can be efficiently exhibited. Moreover, since in the sheet-like electromagnetic shielding structures A 1 to A5 and A8 to A9, the electromagnetic conducting or absorbing fiber convex structure section composed of the electromagnetic conducting or absorbing fiber is coated by the coating layer, coming out of the fiber can be suppressed or prevented.

Example 1

A handheld phone including a sheet-like electromagnetic shielding structure was prepared by pressure-sensitively attaching the sheet-like electromagnetic shielding structure A1 as prepared in Sheet-like Electromagnetic Shielding Structure Production Example 1 onto the surface at the inner side of a case of the handheld phone by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 2

A handheld phone including a sheet-like electromagnetic shielding structure was prepared by pressure-sensitively attaching the sheet-like electromagnetic shielding structure A2 as prepared in Sheet-like Electromagnetic Shielding Structure Production Example 2 onto the rear surface of a liquid-crystal display module in the handheld phone by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 3

A handheld phone including a sheet-like electromagnetic shielding structure was prepared by pressure-sensitively attaching the sheet-like electromagnetic shielding structure A3 as prepared in Sheet-like Electromagnetic Shielding Structure Production Example 3 onto the rear surface of an electronic circuit board in the handheld phone by using a non-electromagnetic conducting or absorbing pressure-sensitive adhesive layer.

Example 4

A handheld phone including a sheet-like electromagnetic shielding structure was prepared by pressure-sensitively attaching the sheet-like electromagnetic shielding structure A4 as prepared in Sheet-like Electromagnetic Shielding Structure Production Example 4 onto the surface of an FPC board (Flexible Printed Circuit board) in the handheld phone by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 5

A notebook computer including a sheet-like electromagnetic shielding structure was prepared by not only pressure-sensitively attaching the sheet-like electromagnetic shielding structure A5 as prepared in Sheet-like Electromagnetic Shielding Structure Production Example 5 onto the rear surface of a mother board in the notebook computer (for example, an A4-size notebook computer) by using a non-electromagnetic conducting or absorbing pressure-sensitive adhesive layer, but also pressure-sensitively attaching the sheet-like electromagnetic shielding structure A1 as prepared in Sheet-like Electromagnetic Shielding Structure Production Example 1 onto the surface of an FPC board in the notebook computer by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 6

A liquid-crystal television including a sheet-like electromagnetic shielding structure was prepared by not only pressure-sensitively attaching the sheet-like electromagnetic shielding structure A1 as prepared in Sheet-like Electromagnetic Shielding Structure Production Example 1 onto the surface at the inner side of a case of the liquid-crystal television (for example, a 28-inch liquid-crystal television) by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed), but also pressure-sensitively attaching the sheet-like electromagnetic shielding structure A5 as prepared in Sheet-like Electromagnetic Shielding Structure Production Example 5 onto the rear surface of an electronic circuit board for liquid-crystal display control by using a non-electromagnetic conducting or absorbing pressure-sensitive adhesive layer.

Example 7

A digital camera including a sheet-like electromagnetic shielding structure was prepared by not only pressure-sensitively attaching the sheet-like electromagnetic shielding structure A1 as prepared in Sheet-like Electromagnetic Shielding Structure Production Example 1 onto the surface at the inner side of a case of the digital camera by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed), but also pressure-sensitively attaching the sheet-like electromagnetic shielding structure A5 as prepared in Sheet-like Electromagnetic Shielding Structure Production Example 5 onto the surface of an FPC board and the rear surface of an electronic circuit board for liquid-crystal display control by using a non-electromagnetic conducting or absorbing pressure-sensitive adhesive layer.

Example 8

An apron including a sheet-like electromagnetic shielding structure was prepared by pressure-sensitively attaching the sheet-like electromagnetic shielding structure A6 as prepared in Sheet-like Electromagnetic Shielding Structure Production Example 6 onto a site on the inner surface of the apron corresponding to the range from a chest part to a belly part by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 9

A wall plywood including a sheet-like electromagnetic shielding structure was prepared by pressure-sensitively attaching the sheet-like electromagnetic shielding structure A7 as prepared in Sheet-like Electromagnetic Shielding Structure Production Example 7 onto the rear surface of a plywood used as a wall material for house construction by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 10

A member for a ceiling structure of an ETC lane including a sheet-like electromagnetic shielding structure was prepared by pressure-sensitively attaching the sheet-like electromagnetic shielding structure A8 as prepared in Sheet-like Electromagnetic Shielding Structure Production Example 8 entirely onto the surface of a plastic-made plate by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

Example 11

An automobile including a sheet-like electromagnetic shielding structure was prepared by pressure-sensitively attaching (i.e., bonding) the sheet-like electromagnetic shielding structure A9 as prepared in Sheet-like Electromagnetic Shielding Structure Production Example 9 onto wire harnesses used in the automobile by using an electromagnetic conducting or absorbing pressure-sensitive adhesive layer whose surface is entirely exposed (that is, an electromagnetic conducting or absorbing pressure-sensitive adhesive layer on which the electromagnetic conducting or absorbing fiber napping section is not formed).

While the invention has been described in detail and with reference to specific embodiments thereof, it will be apparent to one skilled in the art that various changes and modifications can be made therein without departing from the scope thereof.

This application is based on Japanese patent application No. 2006-126182 filed April 28, 2006, the entire contents thereof being hereby incorporated by reference.

Further, all references cited herein are incorporated in their entireties.

## Claims

**1.** An article to which a characteristic of shielding electromagnetic waves is imparted, which comprises at least a sheet-like electromagnetic shielding structure,
said sheet-like electromagnetic shielding structure comprising:

a thin layer-like substrate; and
a fiber convex structure section having a characteristic of conducting or absorbing electromagnetic waves,

wherein said fiber convex structure section is formed at least partially on the thin layer-like substrate in such a form that at least a part of a fiber thereof is positioned outward from the surface of the thin layer-like substrate.

**2.** The article according to claim 1, which is an electronic device, an electronic circuit board, garment, an architectural structure, a construction material, or a transport.

**3.** The article according to claim 2, wherein the electronic device is a mobile communication device, a handheld information terminal, or a portable personal computer.

**4.** The article according to claim 2, wherein the article is an electronic device, and the sheet-like electromagnetic shielding structure is pressure-sensitively attached to a body of the electronic device or an electronic circuit board in the electronic device.

**5.** The article according to claim 2, wherein the garment is an office-work apron, pregnant clothing, medical clothing, or a medical apron.

**6.** The article according to claim 2, wherein the construction material is a wall material, a floor material, a ceiling material, a roof material, or a peripheral material of a radar system.

**7.** The article according to claim 2, wherein the transport is an automobile, a railroad vehicle, a ship, or an aircraft.

**8.** The article according to claim 1, wherein, in the sheet-like electromagnetic shielding structure, the thin layer-like substrate is at least one layer selected from the group consisting of a pressure-sensitive adhesive layer, an adhesive layer, and a polymer layer.

**9.** The article according to claim 1, wherein, in the sheet-like electromagnetic shielding structure, the thin layer-like substrate has a characteristic of conducting or absorbing electromagnetic waves.

**10.** The article according to claim 1, wherein, in the sheet-like electromagnetic shielding structure, the thin layer-like substrate is formed on at least one surface of a support.

**11.** The article according to claim 10, wherein the support has a characteristic of conducting or absorbing electromagnetic waves.

**12.** The article according to claim 1, wherein, in the sheet-like electromagnetic shielding structure, the fiber convex structure section having a characteristic of conducting or absorbing electromagnetic waves is coated with a coating layer.

**13.** The article according to claim 12, wherein the coating layer has a characteristic of conducting or absorbing electromagnetic waves.

**14.** The article according to claim 1, wherein the sheet-like electromagnetic shielding structure has such a configuration that the fiber convex structure section having a characteristic of conducting or absorbing electromagnetic waves is formed partially on the thin layer-like substrate in such a form that at least a part of a fiber thereof is positioned outward from the surface of the thin layer-like substrate; and that a fiber protection member, which is capable of suppressing or preventing the fiber convex structure section having a characteristic of conducting or absorbing electromagnetic waves from being fallen down, is provided at least partially on the surface of the thin layer-like substrate, on which the fiber convex structure section having a characteristic of conducting or absorbing electromagnetic waves is not formed.

**15.** The article according to claim 14, wherein the fiber protection member is a member having a plurality of penetrating hole sections formed into a net shape or a sheet-like member having a plurality of penetrating hole sections formed by perforation.

**16.** The article according to claim 1, wherein the surfaces of the sheet-like electromagnetic shielding structure on each of which the fiber convex structure sections having a characteristic of conducting or absorbing electromagnetic waves is formed are superposed with each other in an opposed state.

FIG. 1A

11
1b
1a1
1a

FIG. 1B

12
1b
1a1
1a

FIG. 2A

2a
2a3
2a1
2a2

FIG. 2B

2b
2b3
2b1
2b2

FIG. 2C

2c
2c2
2c1

FIG. 3A

3a
3a3
3a1
3a2

FIG. 3B

3b
3b3
3b1
3b2

FIG. 3C

3c
3c2
3c1

FIG. 4A

4a
4a3
4a2
4a1

FIG. 4B

4b
4b4
4b2
4b3
4b1

FIG. 5

5
5b
5c
5a1
5a

FIG. 6A

61
61a

FIG. 6B

62a
62

FIG. 7

7
71
72

FIG. 8A

8
81
81a
81b
81c
82c
82b
82a
82

FIG. 8B

9
91
91a
91b
91c
92c
92b
92a
92

FIG. 9

10
102
102c
103
103b
102a
103a
102b
103c
101c
101b
101a
101

FIG. 10A

11
111
111b
111c
111a

FIG. 10B

12
121
121b
121a
121c

FIG. 11

13
132
132a
131b
132b
131a
131
133b
131c
133a
133

FIG. 12A

CENTRAL CONDUCTOR
EXTERNAL CONDUCTOR
INPUT/OUTPUT
80mm
100mm
230mm
50mm

FIG. 12B

LOOP ANTENNA
BNC CONNECTOR
2mm
50Ω
RADIUS: 22mm

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002501821 T
- JP 10120904 A
- JP 61002394 A
- JP 2006126182 A


### Non-patent literature cited in the description


- Principle and Truth of Electrostatic Flocking. *SENI (Fiber,* June 1982, vol. 34 (6
- Denjiha Shahei Gijutsu (Electromagnetic Shielding Technologies. Tokkyo Mappu Shirizu: Denki 23 (Patent Map Series: Electricity 23. Japan Institute of Invention and Innovation, 253-269